# EUROPEAN PATENT APPLICATION

(11) **EP 4 819 809 A1**
(43) Date of publication of application: **07.10.2026**
(21) Application number: 26163383.8
(22) Date of filing: 09.03.2026
(51) Int. Cl.: H10K 59/121, G09G 3/3233, H10D 86/60, H10K 59/123, H10K 59/124

(54) **DISPLAY DEVICE AND ELECTRONIC DEVICE INCLUDING THE SAME**

(30) Priority: 31.03.2025 KR 20250041159
(71) Applicant: Samsung Display Co., Ltd., Yongin-si, Gyeonggi-do 17113 (KR)
(72) Inventor: SON, Sunkwun, Yongin-si 17113 (KR); LEE, Cheol-Gon, Yongin-si 17113 (KR); SEO, Youngwan, Yongin-si 17113 (KR); LEE, Yongwoo, Yongin-si 17113 (KR); CHO, Sanghwan, Yongin-si 17113 (KR); HWANG, Junghwan, Yongin-si 17113 (KR)
(74) Representative: Walaski, Jan Filip

(57) **Abstract**

A display device according to an embodiment includes a substrate including a plurality of pixel circuit regions, a circuit element layer disposed on the substrate, and a light emitting element layer disposed on the circuit element layer. The circuit element layer includes a plurality of semiconductor layers, a plurality of conductive layers, and a plurality of insulating layers which are stacked in a thickness direction. The circuit element layer includes a plurality of pixel circuits disposed in the plurality of pixel circuit regions, respectively. The light emitting element layer includes a plurality of light emitting elements connected to the plurality of pixel circuits, respectively. A ratio (%) of a sum of areas of contact holes in one pixel circuit region of the pixel circuit regions to an area of the one pixel circuit region is in a range of 8 or more and 98 or less.

## Description

### BACKGROUND

### 1. FIELD

The disclosure relates to a display device and an electronic device including the same. More particularly, the disclosure relates to a high-resolution display device and an electronic device including the same.

### 2. DESCRIPTION OF THE RELATED ART

A display device is a device that displays an image to provide visual information to a user. Types of display device include a liquid crystal display, an organic light emitting diode display, or the like. The display device may be operated by thin film transistors, capacitors, and multiple lines which have complex interconnections.

Recently, as a demand for compact and high-resolution display device increases, a demand for efficient space arrangement, connection structure, driving method, and improvement of quality of images implemented among thin film transistors, capacitors, and lines included in the display device is increasing.

### SUMMARY

Embodiments provide a display device with improved resolution.

Embodiments also provide an electronic device including the display device.

Additional features of the inventive concepts will be set forth in the description which follows, and in part will be apparent from the description, or may be learned by practice of the inventive concepts.

A display device according to an embodiment includes a substrate including a plurality of pixel circuit regions, a circuit element layer disposed on the substrate, and a light emitting element layer disposed on the circuit element layer. The circuit element layer includes a plurality of semiconductor layers, a plurality of conductive layers, and a plurality of insulating layers which are stacked in a thickness direction. The circuit element layer includes a plurality of pixel circuits disposed in the plurality of pixel circuit regions, respectively. The light emitting element layer includes a plurality of light emitting elements connected to the plurality of pixel circuits, respectively. Each of the pixel circuits includes a plurality of transistors and at least one capacitor. The insulating layers included in the circuit element layer include a plurality of inorganic insulating layers and at least one organic insulating layer disposed on the inorganic insulating layers. A plurality of contact holes, which penetrate at least one of the inorganic insulating layers, are defined. A ratio (%) of a sum of areas of the contact holes in one pixel circuit region of the pixel circuit regions to an area of the one pixel circuit region is in a range of 8 or more and 98 or less.

In an embodiment, the area of each of the contact holes may be measured based on a bottom surface of each of the contact holes in a plan view.

In an embodiment, a ratio (%) of a sum of areas of channel regions of the transistors in the one pixel circuit region to the area of the one pixel circuit region may be in a range of 10 or more and 30 or less.

In an embodiment, each of the pixel circuits may include a first transistor including a gate electrode connected to a first node, a first electrode to which a driving power voltage is applied, and a second electrode connected to a second node, and configured to apply a driving current to a corresponding one of the light emitting elements, a second transistor including a gate electrode to which a write gate signal is applied, a first electrode to which a data voltage is applied, and a second electrode connected to a third node, a third transistor including a gate electrode to which a compensation gate signal is applied, a first electrode connected to the second node, and a second electrode connected to the first node, a fourth transistor including a gate electrode to which an initialization gate signal is applied, a first electrode to which an initialization voltage is applied, and a second electrode connected to the second node, a first capacitor including a first electrode connected to the first node and a second electrode connected to the third node, and a second capacitor including a first electrode connected to the third node and a second electrode to which the initialization voltage is applied.

In an embodiment, each of the first transistor and the third transistor may be a P-type transistor. Each of the second transistor and the fourth transistor may be an N-type transistor.

In an embodiment, the semiconductor layers may include a first semiconductor layer including a silicon semiconductor, and a second semiconductor layer disposed on the first semiconductor layer and including an oxide semiconductor. A channel region of the first transistor and a channel region of the third transistor may be defined in the first semiconductor layer. A channel region of the second transistor and a channel region of the fourth transistor may be defined in the second semiconductor layer.

In an embodiment, the first capacitor may at least partially overlap each of the channel region of the second transistor and the channel region of the third transistor in a plan view.

In an embodiment, the second capacitor may at least partially overlap the first capacitor in a plan view.

In an embodiment, the second capacitor may at least partially overlap each of the channel region of the second transistor and the channel region of the third transistor in a plan view.

In an embodiment, each of the pixel circuits may include a first transistor including a gate electrode connected to a first node, a first electrode connected to a second node, and a second electrode connected to a third node, and configured to apply a driving current to a corresponding one of the light emitting elements, a second transistor including a gate electrode to which a write gate signal is applied, a first electrode to which a data voltage is applied, and a second electrode connected to the first node, a third transistor including a gate electrode to which a compensation gate signal is applied, a first electrode to which a driving power voltage is applied, and a second electrode connected to the second node, a fourth transistor including a gate electrode to which an emission signal is applied, a first electrode connected to the third node, and a second electrode connected to an anode electrode of the corresponding one of the light emitting elements, a first capacitor including a first electrode connected to the first node and a second electrode connected to the third node, and a second capacitor including a first electrode connected to the third node and a second electrode to which a reference voltage is applied.

In an embodiment, each of the first transistor, the third transistor, and the fourth transistor may be an N-type transistor. The second transistor may be a P-type transistor.

In an embodiment, the semiconductor layers may include a first semiconductor layer including a silicon semiconductor, a second semiconductor layer disposed on the first semiconductor layer and including an oxide semiconductor, and a third semiconductor layer disposed on the second semiconductor layer and including an oxide semiconductor. A channel region of the first transistor may be defined in the second semiconductor layer. A channel region of the second transistor may be defined in the first semiconductor layer. A channel region of the third transistor and a channel region of the fourth transistor may be defined in the third semiconductor layer.

In an embodiment, the first capacitor may include a first sub-capacitor, a second sub-capacitor, and a third sub-capacitor which are stacked in the thickness direction.

In an embodiment, the first sub-capacitor, the second sub-capacitor, and the third sub-capacitor may at least partially overlap each other in a plan view.

In an embodiment, the second capacitor may at least partially overlap each of the first sub-capacitor, the second sub-capacitor, and the third sub-capacitor in a plan view.

In an embodiment, each of the pixel circuits may include a first transistor including a gate electrode connected to a first node, a first electrode to which a driving power voltage is applied, and a second electrode connected to a second node, and configured to apply a driving current to a corresponding one of the light emitting elements, a second transistor including a gate electrode to which a compensation gate signal is applied, a first electrode connected to a third node, and a second electrode connected to the second node, a third transistor including a gate electrode to which a write gate signal is applied, a first electrode connected to the first node, and a second electrode connected to the third node, a first capacitor including a first electrode to which an initialization voltage is applied and a second electrode connected to the first node, and a second capacitor including a first electrode to which a data voltage is applied and a second electrode connected to the third node.

In an embodiment, the first transistor may be a P-type transistor. Each of the second transistor and the third transistor may be an N-type transistor.

In an embodiment, a resolution of the display device may be in a range of 1250 ppi (pixel per inch) or more.

A display device according to an embodiment includes a substrate including a plurality of pixel circuit regions, a circuit element layer disposed on the substrate, and a light emitting element layer disposed on the circuit element layer. The circuit element layer includes a plurality of semiconductor layers, a plurality of conductive layers, and a plurality of insulating layers which are stacked in a thickness direction. The circuit element layer includes a plurality of pixel circuits disposed in the plurality of pixel circuit regions, respectively. The light emitting element layer includes a plurality of light emitting elements connected to the plurality of pixel circuits, respectively. Each of the pixel circuits includes a plurality of transistors and at least one capacitor. The insulating layers included in the circuit element layer include a plurality of inorganic insulating layers and at least one organic insulating layer disposed on the inorganic insulating layers. A plurality of contact holes, which penetrate at least one of the inorganic insulating layers, are defined. A ratio (%) of a sum of areas of channel regions of the transistors in one pixel circuit region of the pixel circuit regions to an area of the one pixel circuit region is in a range of 10 or more and 30 or less.

An electronic device according to an embodiment includes a display device displaying an image and one or more processors configured to provide input image data and an input control signal to the display device. The display device includes a substrate including a plurality of pixel circuit regions, a circuit element layer disposed on the substrate, and a light emitting element layer disposed on the circuit element layer. The circuit element layer includes a plurality of semiconductor layers, a plurality of conductive layers, and a plurality of insulating layers which are stacked in a thickness direction. The circuit element layer includes a plurality of pixel circuits disposed in the plurality of pixel circuit regions, respectively. The light emitting element layer includes a plurality of light emitting elements connected to the plurality of pixel circuits, respectively. Each of the pixel circuits includes a plurality of transistors and at least one capacitor. The insulating layers included in the circuit element layer include a plurality of inorganic insulating layers and at least one organic insulating layer disposed on the inorganic insulating layers. A plurality of contact holes, which penetrate at least one of the inorganic insulating layers, are defined. A ratio (%) of a sum of areas of the contact holes in one pixel circuit region of the pixel circuit regions to an area of the one pixel circuit region is in a range of 8 or more and 98 or less.

According to embodiments, the degree of integration of the pixel circuit included in the display device may be improved, and the resolution of the display device may be improved.

It is to be understood that both the foregoing general description and the following detailed description are exemplary and explanatory and are intended to provide further explanation of the inventive concept as claimed.

### BRIEF DESCRIPTION OF THE DRAWINGS

The accompanying drawings, which are included to provide a further understanding of the inventive concept and are incorporated in and constitute a part of this specification, illustrate embodiments of the inventive concept, and together with the description serve to explain the inventive concept.
FIG. 1 is a block diagram schematically illustrating a display device according to an embodiment.
FIG. 2 is a plan view schematically illustrating a display panel included in the display device of FIG. 1.
FIG. 3 is a cross-sectional view schematically illustrating the display panel of FIG. 2.
FIG. 4 is a cross-sectional view schematically illustrating a contact hole defined in the display panel of FIG. 3.
FIG. 5 is an equivalent circuit diagram schematically illustrating a pixel according to an embodiment.
FIG. 6 is a timing diagram illustrating an example of signals applied to a pixel circuit of FIG. 5.
FIG. 7 is an equivalent circuit diagram schematically illustrating a pixel according to an embodiment.
FIG. 8 is a timing diagram illustrating an example of signals applied to a pixel circuit of FIG. 7.
FIG. 9 is an equivalent circuit diagram schematically illustrating a pixel according to an embodiment.
FIG. 10 is a timing diagram illustrating an example of signals applied to a pixel circuit of FIG. 9.
FIG. 11 is a table showing transistor area ratios and contact hole area ratios according to embodiments and a comparative example.
FIG. 12 is a cross-sectional view illustrating a display panel according to an embodiment.
FIGS. 13, 14, 15, 16, 17, 18, 19, 20, 21, 22, 23, 24, 25, 26, 27, 28, 29, 30, 31, 32, 33, 34, 35, 36, 37, 38, and 39 are layout views illustrating the display panel of FIG. 12.
FIG. 40 is a cross-sectional view illustrating a display panel according to an embodiment.
FIGS. 41, 42, 43, 44, 45, 46, 47, 48, 49, 50, 51, 52, 53, 54, 55, 56, 57, 58, 59, 60, 61, 62, 63, 64, and 65 are layout views illustrating the display panel of FIG. 40.
FIG. 66 is a block diagram illustrating an electronic device according to an embodiment.
FIG. 67 is a schematic diagram illustrating an electronic device according to various embodiments.

### DETAILED DESCRIPTION

Various example embodiments will be described more fully hereinafter with reference to the accompanying drawings, in which some example embodiments are shown. The present inventive concept may, however, be embodied in many different forms and should not be construed as limited to the example embodiments set forth herein. Rather, these example embodiments are provided so that this disclosure will be thorough and complete, and will fully convey the scope of the present inventive concept to those skilled in the art. In the drawings, the sizes and relative sizes of layers and regions may be exaggerated for clarity.

In the disclosure, various modifications can be made, various forms can be used, and specific embodiments will be illustrated in the drawings and described in detail in the text. However, this is not intended to limit the disclosure to a specific form disclosed, and it will be understood that all changes, equivalents, or substitutes which fall in the technical scope of the disclosure should be included.

It will be understood that, although the terms first, second, third etc. may be used herein to describe various elements, these elements should not be limited by these terms. These terms are used to distinguish one element from another. Thus, a first element discussed below could be termed a second element without departing from the teachings of the present inventive concept. As used herein, the term "and/or" includes any and all combinations of one or more of the associated listed items.

It will be understood that when an element is referred to as being "connected" or "coupled" to another element, it can be directly connected or coupled to the other element or intervening element(s) may be present. In contrast, when an element is referred to as being "directly connected" or "directly coupled" to another element, there are no intervening elements present. Other words used to describe the relationship between elements should be interpreted in a like fashion (e.g., "between" versus "directly between," "adjacent" versus "directly adjacent," etc.).

The terminology used herein is for the purpose of describing particular example embodiments only and is not intended to be limiting of the present inventive concept. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Furthermore, relative terms, such as "lower" or "bottom" and "upper" or "top," may be used herein to describe one element's relationship to another element as illustrated in the figures. It will be understood that relative terms are intended to encompass different orientations of the device in addition to the orientation depicted in the figures. For example, if the device in one of the figures is turned over, elements described as being on the "lower" side of other elements would then be oriented on "upper" sides of the other elements. The term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

Unless otherwise defined, all terms (including technical and scientific terms) used herein have the same meaning as commonly understood by one of ordinary skill in the art to which this inventive concept belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, embodiments will be described in detail with reference to the accompanying drawings. The same reference numerals are used for the same components in the drawings, and redundant descriptions of the same components will be omitted.

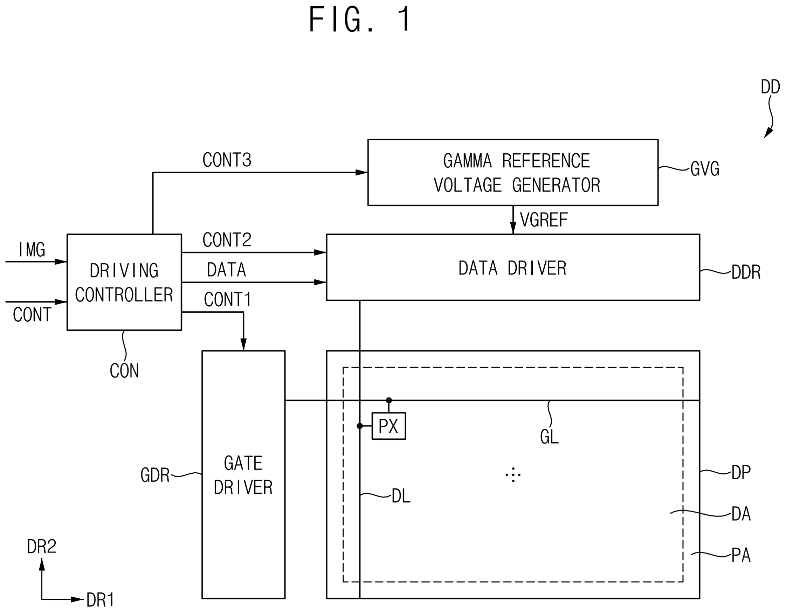

FIG. 1 is a block diagram schematically illustrating a display device DD according to an embodiment.

Referring to FIG. 1, the display device DD according to an embodiment may include a display panel DP and a panel driver for driving the display panel DP. The panel driver may include a driving controller CON, a gate driver GDR, a gamma reference voltage generator GVG, and a data driver DDR.

In an embodiment, the driving controller CON and the data driver DDR may be integrated. In an embodiment, the driving controller CON, the gamma reference voltage generator GVG, and the data driver DDR may be integrated. In an embodiment, the driving controller CON, the gate driver GDR, the gamma reference voltage generator GVG, and the data driver DDR may be integrated. For example, a driving module which is provided by (e.g., formed by) an integration of at least the driving controller CON and the data driver DDR may be referred to as a timing controller embedded data driver (TED).

The display panel DP may include a display region DA for displaying an image and a peripheral region PA positioned outside the display region DA. For example, the peripheral region PA may surround at least a portion of the display region DA in a plan view.

In an embodiment, the display panel DP may be an organic light emitting diode display panel including an organic light emitting diode. In an embodiment, the display panel DP may be a quantum dot organic light emitting diode display panel including an organic light emitting diode and a quantum dot color filter. In an embodiment, the display panel DP may be a quantum dot nano light emitting diode display panel including a nano light emitting diode and a quantum dot color filter.

The display panel DP may include a plurality of gate lines GL, a plurality of data lines DL, and a plurality of pixels PX. The plurality of pixels PX may be disposed in the display region DA, and may be electrically connected to the plurality of gate lines GL and the plurality of data lines DL. In an embodiment, each of the gate lines GL may extend generally in a first direction DR1. Each of the data lines DL may extend generally in a second direction DR2 crossing the first direction DR1. For example, the second direction DR2 may be perpendicular to the first direction DR1.

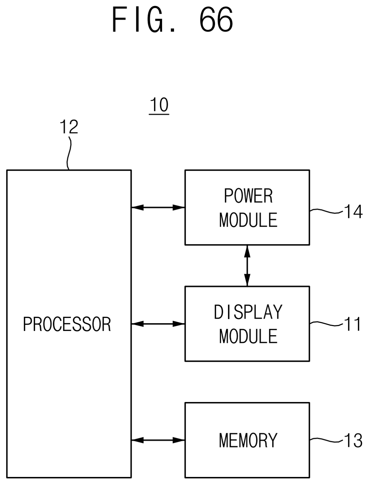

The driving controller CON may receive input image data IMG and an input control signal CONT from an external host processor (e.g., a processor 12 of FIG. 66). For example, the input image data IMG may include red image data, green image data, and blue image data. For example, the input image data IMG may further include white image data. For example, the input image data IMG may include magenta image data, yellow image data, cyan image data, or the like. The input control signal CONT may include a master clock signal and a data enable signal. The input control signal CONT may further include a vertical synchronization signal and a horizontal synchronization signal.

The driving controller CON may generate a first control signal CONT1, a second control signal CONT2, a third control signal CONT3, and a data signal DATA.

The driving controller CON may generate the first control signal CONT1 for controlling the operation of the gate driver GDR based on the input control signal CONT. The driving controller CON may output the first control signal CONT1 to the gate driver GDR. The first control signal CONT1 may include a vertical start signal and a scan clock signal.

The driving controller CON may generate the second control signal CONT2 for controlling the operation of the data driver DDR based on the input control signal CONT. The driving controller CON may output the second control signal CONT2 to the data driver DDR. The second control signal CONT2 may include a horizontal start signal and a load signal.

The driving controller CON may generate the data signal DATA based on the input image data IMG. The driving controller CON may output the data signal DATA to the data driver DDR.

The driving controller CON may generate the third control signal CONT3 for controlling the operation of the gamma reference voltage generator GVG based on the input control signal CONT. The driving controller CON may output the third control signal CONT3 to the gamma reference voltage generator GVG.

The gate driver GDR may generate gate signals in response to the first control signal CONT1 received from the driving controller CON. The gate driver GDR may output the gate signals to the gate lines GL. In an embodiment, the gate driver GDR may be integrated in the peripheral region PA of the display panel DP.

The gamma reference voltage generator GVG may generate a gamma reference voltage VGREF in response to the third control signal CONT3 received from the driving controller CON. The gamma reference voltage generator GVG may provide the gamma reference voltage VGREF to the data driver DDR. The gamma reference voltage VGREF may have a value corresponding to each data signal DATA.

In an embodiment, the gamma reference voltage generator GVG may be formed in the driving controller CON or in the data driver DDR.

The data driver DDR may receive the second control signal CONT2 and the data signal DATA from the driving controller CON, and may receive the gamma reference voltage VGREF from the gamma reference voltage generator GVG. The data driver DDR may convert the data signal DATA into a data voltage in analog form using the gamma reference voltage VGREF. The data driver DDR may output the data voltage to the data line DL.

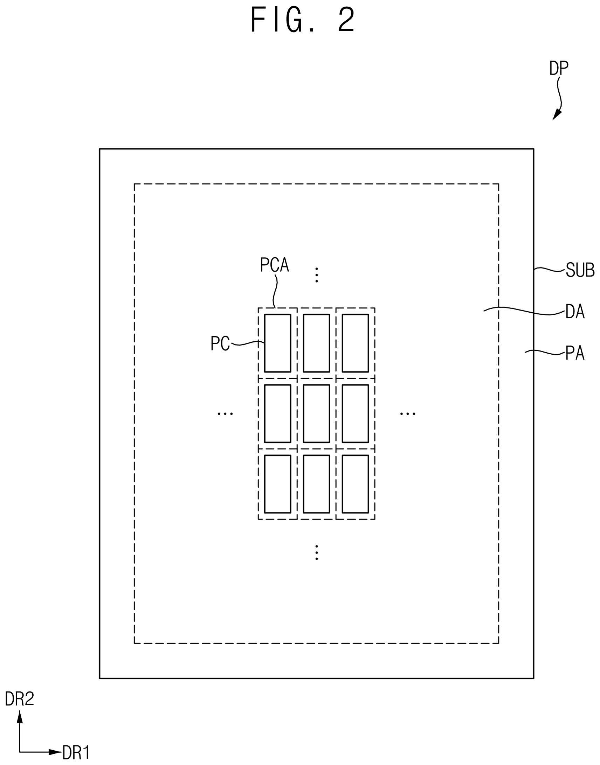

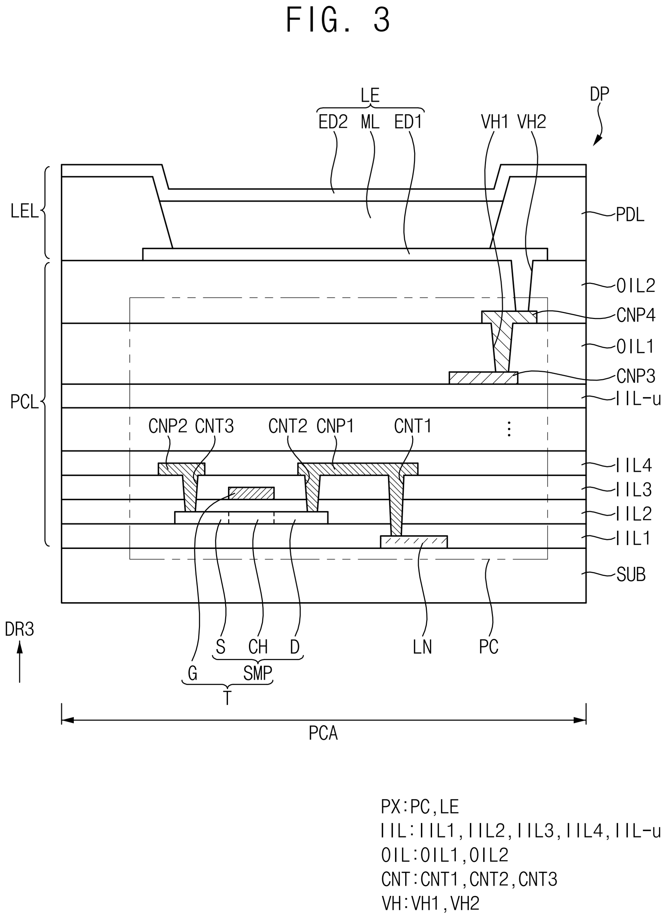

FIG. 2 is a plan view schematically illustrating a display panel DP included in the display device DD of FIG. 1. FIG. 3 is a cross-sectional view schematically illustrating the display panel DP of FIG. 2.

Referring to FIGS. 2 and 3, the display panel DP may include a substrate SUB, a circuit element layer PCL, and a light emitting element layer LEL. The display panel DP (or the substrate SUB included in the display panel DP) may include the display region DA and the peripheral region PA.

The substrate SUB may form a base of the display panel DP. In an embodiment, the substrate SUB may be an insulating substrate formed of a transparent or opaque material. In an embodiment, the substrate SUB may include glass, and the display panel DP may be a rigid display panel. In an embodiment, the substrate SUB may include plastic, and the display panel DP may be a flexible display panel. In an embodiment, the substrate SUB may be a semiconductor substrate. For example, the substrate SUB may include silicon, germanium, or silicon/germanium, or may be a silicon on isolation (SOI) substrate.

The plurality of pixels PX may be disposed in the display region DA on the substrate SUB. For example, each of the pixels PX may emit one of red light, green light, and blue light, but the inventive concept is not limited thereto. The light emitted from the pixels PX may be combined to generate the image. For example, pixels PX that emit light of different colors and are adjacent to each other may constitute (or form) one unit pixel. Each of the pixels PX may include a pixel circuit PC and a light emitting element LE. The pixel circuit PC may include a plurality of transistors T and at least one capacitor (not illustrated).

The display region DA may include a plurality of pixel circuit regions PCA. The pixel circuits PC may be disposed in the pixel circuit regions PCA, respectively. Each of the pixel circuit regions PCA may be defined as a region in which one pixel circuit PC is disposed. In an embodiment, the pixel circuit regions PCA may have the same shape and size. For example, the pixel circuit regions PCA may be repeatedly disposed in the first direction DR1 and the second direction DR2.

The circuit element layer PCL may be disposed on the substrate SUB. The circuit element layer PCL may include the pixel circuits PC respectively disposed in the pixel circuit regions PCA. The circuit element layer PCL may include a plurality of semiconductor layers, a plurality of conductive layers, and a plurality of insulating layers which are stacked in a third direction DR3. For example, the third direction DR3 may be perpendicular to each of the first direction DR1 and the second direction DR2, and may be referred to as a thickness direction.

In an embodiment, the insulating layers included in the circuit element layer PCL may include a plurality of inorganic insulating layers IIL including an inorganic insulating material and at least one organic insulating layer OIL including an organic insulating material. The organic insulating layer OIL may be disposed on the inorganic insulating layers IIL. For example, the organic insulating layer OIL may be disposed on an uppermost layer IIL-u among the inorganic insulating layers IIL. Although FIG. 3 illustrates that the circuit element layer PCL includes two organic insulating layers OIL1 and OIL2, this is an example and the inventive concept is not limited thereto, and the circuit element layer PCL may include one or three or more organic insulating layers OIL.

The circuit element layer PCL may include a plurality of semiconductor patterns, electrodes, conductive patterns, and lines (wirings) for forming the pixel circuits PC. For convenience of description, FIG. 3 illustrates a line LN disposed on the substrate SUB, a semiconductor pattern SMP disposed on a first inorganic insulating layer IIL1, a gate electrode G disposed on a second inorganic insulating layer IIL2, a first connection pattern CNP1 and a second connection pattern CNP2 disposed on a third inorganic insulating layer IIL3, a third connection pattern CNP3 disposed on the uppermost layer IIL-u among the inorganic insulating layers IIL, and a fourth connection pattern CNP4 disposed on a first organic insulating layer OIL1, but the circuit element layer PCL may further include additional components, such as a plurality of patterns, electrodes, lines, and layers.

Electrical properties of the semiconductor pattern SMP may vary depending on whether a region thereof is doped or not. As illustrated in FIG. 3, the semiconductor pattern SMP may include a source region S, a drain region D, and a channel region CH between the source region S and the drain region D. For example, the conductivity of each of the source region S and the drain region D may be higher than the conductivity of the channel region CH.

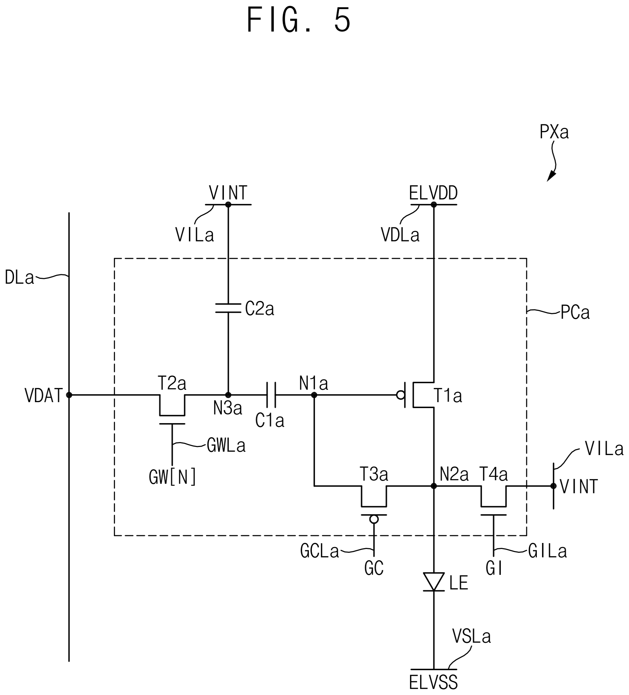

The gate electrode G may overlap the channel region CH of the semiconductor pattern SMP in a plan view. The second inorganic insulating layer IIL2 may be disposed between the semiconductor pattern SMP and the gate electrode G. The semiconductor pattern SMP and the gate electrode G may form the transistor T. Although only one transistor T is illustrated in FIG. 3, each of the pixel circuits PC may include two or more transistors, for example, three or four transistors (see FIGS. 5, 7, and 9).

In some embodiments, a transistor area ratio (the ratio may be expressed as a percentage (%)) of the display panel DP may be in a range of about 10 or more and about 30 or less. The transistor area ratio (%) may be defined as the ratio (%) of the sum of areas of the channel regions of the transistors T in one pixel circuit region PCA of the pixel circuit regions PCA in a plan view to the area of the one pixel circuit region PCA of the pixel circuit regions PCA in a plan view.

The insulating layers included in the circuit element layer PCL may define a plurality of contact holes CNT and a plurality of via holes VH for connection between patterns, electrodes, and/or lines disposed in different layers. In the present specification, each of the contact holes CNT may be defined as a through-hole penetrating at least one of the inorganic insulating layers IIL included in the circuit element layer PCL in the third direction DR3, and each of the via holes VH may be defined as a through-hole penetrating at least one of the organic insulating layers OIL included in the circuit element layer PCL in the third direction DR3. That is, each of the contact holes CNT may be a through-hole formed in the inorganic insulating layers IIL including an inorganic material among the insulating layers included in the circuit element layer PCL, and each of the via hole VH may be a through-hole formed in the organic insulating layers OIL including an organic insulating material among the insulating layers included in the circuit element layer PCL.

Patterns, electrodes, and/or lines arranged in different layers may be electrically connected to each other through the contact holes CNT and/or the via holes VH. For example, the first connection pattern CNP1 may be electrically connected to the line LN through a first contact hole CNT1 that penetrates the first to third inorganic insulating layers IIL1, IIL2, and IIL3, and may be electrically connected to the drain region D of the semiconductor pattern SMP through a second contact hole CNT2 that penetrates the second and third inorganic insulating layers IIL2 and IIL3. The second connection pattern CNP2 may be electrically connected to the source region S of the semiconductor pattern SMP through a third contact hole CNT3 that penetrates the second and third inorganic insulating layers IIL2 and IIL3. The fourth connection pattern CNP4 may be electrically connected to the third connection pattern CNP3 through a first via hole VH1 that penetrates the first organic insulating layer OIL1. A first electrode ED1 of the light emitting element LE disposed on the circuit element layer PCL may be electrically connected to the fourth connection pattern CNP4 through a second via hole VH2 that penetrates the second organic insulating layer OIL2.

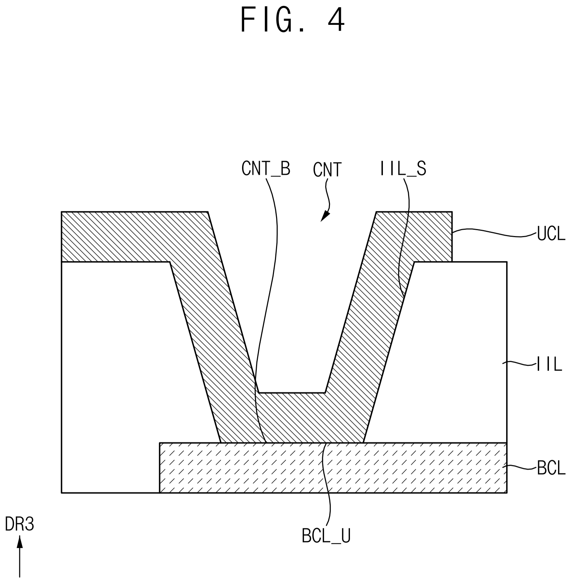

FIG. 4 is a cross-sectional view schematically illustrating a contact hole CNT defined in the display panel DP of FIG. 3.

Referring further to FIG. 4, an upper conductive layer UCL may be connected to a lower conductive layer BCL through the contact hole CNT that penetrates at least one inorganic insulating layer IIL. In an embodiment, the contact hole CNT may have a trapezoidal shape in a cross-sectional view. That is, a side surface IIL_S of the inorganic insulating layer IIL defining a side wall of the contact hole CNT may be inclined. A bottom surface CNT_B of the contact hole CNT may be defined as a portion of an upper surface BCL_U of the lower conductive layer BCL exposed by the contact hole CNT.

In some embodiments, a contact hole area ratio (%) of the display panel DP may be in a range of about 8 or more and about 98 or less. The contact hole area ratio, expressed as a percentage (%), may be defined as the ratio (%) of the sum of areas of the contact holes CNT in one pixel circuit region PCA of the pixel circuit regions PCA in a plan view to the area of the one pixel circuit region PCA of the pixel circuit regions PCA in a plan view, also referred to as the surface area. Here, the area of each of the contact holes CNT in a plan view may be measured based on the bottom surface CNT_B of the contact hole CNT in a plan view. That is, the area of each of the contact holes CNT in a plan view may be the area of a portion of the upper surface BCL_U of the lower conductive layer BLC exposed by the contact hole CNT in a plan view.

Referring again to FIG. 3, the light emitting element layer LEL may be disposed on the circuit element layer PCL. The light emitting element layer LEL may include the light emitting elements LE respectively connected to the pixel circuits PC and a pixel defining layer PDL. Each of the light emitting elements LE may include the first electrode ED1, a middle layer ML, and a second electrode ED2.

The first electrode ED1 may be disposed on the second organic insulating layer OIL2. The first electrode ED1 may include a conductive material. For example, the first electrode ED1 may be an anode electrode of the light emitting element LE.

The pixel defining layer PDL may be disposed on the second organic insulating layer OIL2 and the first electrode ED1. The pixel defining layer PDL may cover a peripheral portion of the first electrode ED1, and may define a pixel opening that extends to and exposes a central portion of the first electrode ED1. The pixel defining layer PDL may include an inorganic insulating material and/or an organic insulating material.

The middle layer ML may be disposed on the first electrode ED1. In an embodiment, the middle layer ML may be formed in the pixel opening of the pixel defining layer PDL to correspond to the corresponding first electrode ED1. In an embodiment, the middle layer ML may be entirely formed on the display region DA.

The middle layer ML may include an emission layer. In an embodiment, the middle layer ML may further include various functional layers (e.g., a hole injection layer, a hole transport layer, an electron transport layer, an electron injection layer, or the like) disposed on and/or under the emission layer.

The second electrode ED2 may be disposed on the middle layer ML. The second electrode ED2 may also be disposed on the pixel defining layer PDL. The second electrode ED2 may include a conductive material. For example, the second electrode ED2 may be a cathode electrode of the light emitting element LE.

FIG. 5 is an equivalent circuit diagram schematically illustrating a pixel PXa according to an embodiment.

Referring to FIG. 5, in an embodiment, the pixel PXa may include a pixel circuit PCa and a light emitting element LE electrically connected to the pixel circuit PCa. The pixel circuit PCa may include a first transistor T1a, a second transistor T2a, a third transistor T3a, a fourth transistor T4a, a first capacitor C1a, and a second capacitor C2a.

The first transistor T1a may include a gate electrode connected to a first node N1a, a first electrode connected to a driving power line VDLa, and a second electrode connected to a second node N2a. A driving power voltage ELVDD may be applied to the first electrode of the first transistor T1a. The first transistor T1a may be configured to generate a driving current based on a voltage of the first node N1a. The first transistor T1a may be configured to output the driving current to the second node N2a based on the voltage of the first node N1a.

The second transistor T2a may include a gate electrode connected to a write gate line GWLa, a first electrode connected to a data line DLa, and a second electrode connected to a third node N3a. A write gate signal GW[N] may be applied to the gate electrode of the second transistor T2a, and a data voltage VDAT may be applied to the first electrode of the second transistor T2a. The second transistor T2a may be configured to apply the data voltage VDAT to the third node N3a in response to the write gate signal GW[N].

The third transistor T3a may include a gate electrode connected to a compensation gate line GCLa, a first electrode connected to the second node N2a, and a second electrode connected to the first node N1a. A compensation gate signal GC may be applied to the gate electrode of the third transistor T3a. The third transistor T3a may be configured to connect the first node N1a and the second node N2a in response to the compensation gate signal GC. For example, the third transistor T3a may be configured to diode-connect the first transistor T1a.

The fourth transistor T4a may include a gate electrode connected to an initialization gate line GILa, a first electrode connected to an initialization line VILa, and a second electrode connected to the second node N2a. An initialization gate signal GI may be applied to the gate electrode of the fourth transistor T4a, and an initialization voltage VINT may be applied to the first electrode of the fourth transistor T4a. The fourth transistor T4a may be configured to apply the initialization voltage VINT to the second node N2a in response to the initialization gate signal GI.

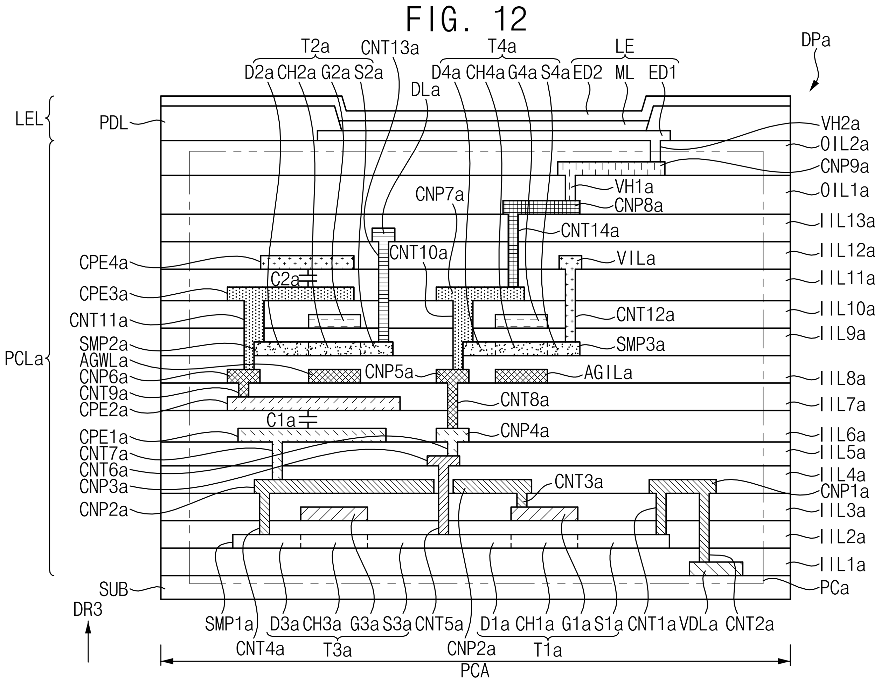

In an embodiment, each of the first transistor T1a and the third transistor T3a may be a P-type transistor, and each of the second transistor T2a and the fourth transistor T4a may be an N-type transistor. For example, each of the first transistor T1a and the third transistor T3a may be a polysilicon thin film transistor, and each of the second transistor T2a and the fourth transistor T4a may be an oxide thin film transistor (see FIG. 12). However, the inventive concept is not limited thereto.

The first capacitor C1a may include a first electrode connected to the first node N1a and a second electrode connected to the third node N3a.

The second capacitor C2a may include a first electrode connected to the third node N3a and a second electrode connected to the initialization line VILa. The initialization voltage VINT may be applied to the second electrode of the second capacitor C2a.

The light emitting element LE may include a first electrode (e.g., an anode electrode) connected to the second node N2a and a second electrode (e.g., a cathode electrode) connected to a common power line VSLa. A common power voltage ELVSS may be applied to the second electrode of the light emitting element LE. The light emitting element LE may emit light based on the driving current. In an embodiment, the light emitting element LE may be an organic light emitting diode (OLED), but the inventive concept is not limited thereto, and the light emitting element LE may be a nano light emitting diode (NED), a quantum dot (QD) light emitting diode, a micro light emitting diode, an inorganic light emitting diode, or any other suitable light emitting element.

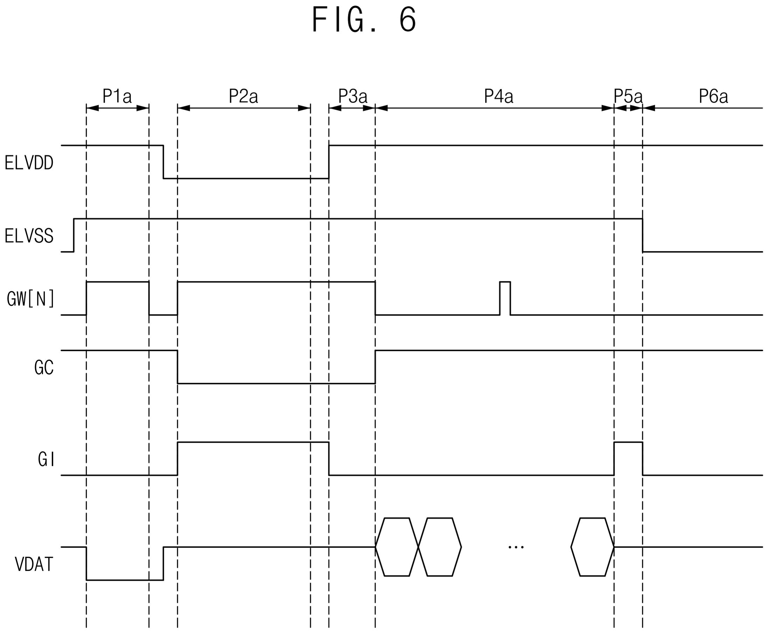

FIG. 6 is a timing diagram illustrating an example of signals applied to a pixel circuit PCa of FIG. 5.

Referring to FIGS. 5 and 6, a frame period in which the pixel circuit PCa is driven may include an on-bias period P1a, a first initialization period P2a, a compensation period P3a, an addressing period P4a, a second initialization period P5a, and an emission period P6a.

In the on-bias period P1a, the driving power voltage ELVDD may have a high level, the common power voltage ELVSS may have a high level, the write gate signal GW[N] may have an active level, the compensation gate signal GC may have a non-active level, the initialization gate signal GI may have a non-active level, and the data voltage VDAT may have a low level.

In the on bias period P1a, the second transistor T2a may be turned on, and the third transistor T3a and the fourth transistor T4a may be turned off. Since the data voltage VDAT has the low level and the driving power voltage ELVDD has the high level, a voltage of the gate electrode of the first transistor T1a may be initialized to a certain voltage to relieve accumulated stress of the first transistor T1a. In addition, in order to prevent the first transistor T1a from being turned on and the light emitting element LE from emitting light, the common power voltage ELVSS may have the high level.

In the first initialization period P2a after the on-bias period P1a, the driving power voltage ELVDD may have a low level, the common power voltage ELVSS may have the high level, the write gate signal GW[N] may have the active level, the compensation gate signal GC may have an active level, the initialization gate signal GI may have an active level, and the data voltage VDAT may have a common level. The common level of the data voltage VDAT may be a reference voltage.

In the first initialization period P2a, the second transistor T2a, the third transistor T3a, and the fourth transistor T4a may be turned on. Since the third transistor T3a and the fourth transistor T4a are turned on, the initialization voltage VINT may be applied to the first node N1a. Accordingly, the first node N1a may be initialized to the initialization voltage VINT. In addition, since the second transistor T2a is turned on, the reference voltage may be applied to the third node N3a.

In the compensation period P3a after the first initialization period P2a, the driving power voltage ELVDD may have the high level, the common power voltage ELVSS may have the high level, the write gate signal GW[N] may have the active level, the compensation gate signal GC may have the active level, the initialization gate signal GI may have the non-active level, and the data voltage VDAT may have the common level.

In the compensation period P3a, the first transistor T1a, the second transistor T2a, and the third transistor T3a may be turned on, and the fourth transistor T4a may be turned off. The third transistor T3a may diode-connect the first transistor T1a. Accordingly, a voltage in which a threshold voltage of the first transistor T1a is compensated for may be applied to the first node N1a. For example, in the compensation period P3a, the voltage of the first node N1a may correspond to a sum of the high level of the driving power voltage ELVDD and the threshold voltage of the first transistor T1a. Here, the threshold voltage of the first transistor T1a may be a negative voltage. In addition, in order to prevent the first transistor T1a from being turned on and the light emitting element LE from emitting light, the common power voltage ELVSS may have the high level.

In the addressing period P4a after the compensation period P3a, the driving power voltage ELVDD may have the high level, the common power voltage ELVSS may have the high level, the write gate signal GW[N] may have an active pulse corresponding to pixel rows, the compensation gate signal GC may have the non-active level, the initialization gate signal GI may have the non-active level, and the data voltage VDAT may have a pixel data voltage corresponding to each pixel.

In the addressing period P4a, the second transistor T2a may be turned on so that the pixel data voltage may be applied to the third node N3a. The first capacitor C1a may couple a voltage change of the third node N3a and may apply the coupling voltage to the first node N1a. For example, in the addressing period P4a, the voltage of the first node N1a may correspond to a sum of a difference between the pixel data voltage and the reference voltage and the voltage of the first node N1a in the compensation period P3a. In the addressing period P4a, pixel data voltages may be applied to corresponding ones of the pixel rows, respectively. In FIGS. 5 and 6, the write gate signal GW[N] is illustrated as a scan signal of a Nth pixel row. In addition, in order to prevent the first transistor T1a from being turned on and the light emitting element LE from emitting light, the common power voltage ELVSS may have the high level.

In the second initialization period P5a after the addressing period P4a, the driving power voltage ELVDD may have the high level, the common power voltage ELVSS may have the high level, the write gate signal GW[N] may have a non-active level, the compensation gate signal GC may have the non-active level, the initialization gate signal GI may have the active level, and the data voltage VDAT may have the common level.

In the second initialization period P5a, the fourth transistor T4a may be turned on, and the second transistor T2a and the third transistor T3a may be turned off. Since the fourth transistor T4a is turned on, the initialization voltage VINT may be applied to the second node N2a. Accordingly, the second node N2a may be initialized to the initialization voltage VINT.

In the emission period P6a after the second initialization period P5a, the driving power voltage ELVDD may have the high level, the common power voltage ELVSS may have a low level, the write gate signal GW[N] may have the non-active level, the compensation gate signal GC may have the non-active level, the initialization gate signal GI may have the non-active level, and the data voltage VDAT may have the common level.

In the emission period P6a, the first transistor T1a may be turned on and the driving power voltage ELVDD may have the high level, so that the first transistor T1a may output the driving current based on the voltage of the first node N1a. In addition, since the common power voltage ELVSS has the low level, the light emitting element LE may emit light based on the driving current.

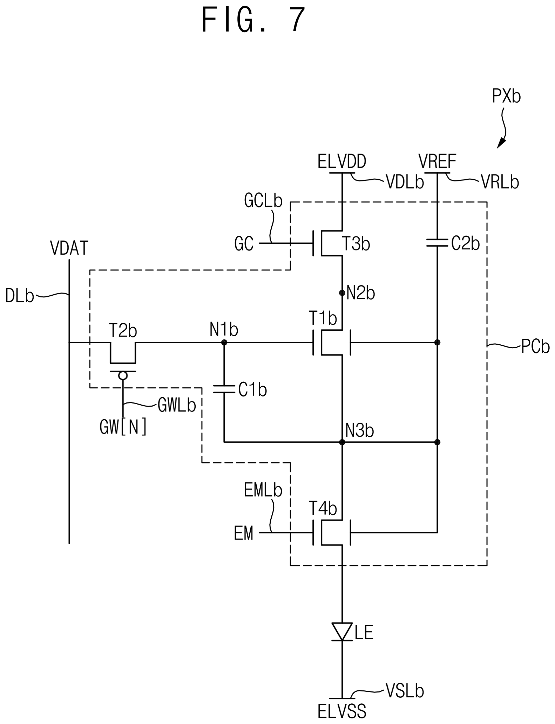

FIG. 7 is an equivalent circuit diagram schematically illustrating a pixel PXb according to an embodiment.

Referring to FIG. 7, in an embodiment, the pixel PXb may include a pixel circuit PCb and a light emitting element LE electrically connected to the pixel circuit PCb. The pixel circuit PCb may include a first transistor T1b, a second transistor T2b, a third transistor T3b, a fourth transistor T4b, a first capacitor C1b, and a second capacitor C2b.

The first transistor T1b may include a gate electrode connected to a first node N1b, a first electrode connected to a second node N2b, and a second electrode connected to a third node N3b. In an embodiment, the first transistor T1b may further include a back gate electrode connected to the third node N3b. The first transistor T1b may be configured to generate a driving current based on a voltage of the first node N1b. The first transistor T1b may be configured to output the driving current to the third node N3b based on the voltage of the first node N1b.

The second transistor T2b may include a gate electrode connected to a write gate line GWLb, a first electrode connected to a data line DLb, and a second electrode connected to the first node N1b. A write gate signal GW[N] may be applied to the gate electrode of the second transistor T2b, and a data voltage VDAT may be applied to the first electrode of the second transistor T2b. The second transistor T2b may be configured to apply the data voltage VDAT to the first node N1b in response to the write gate signal GW[N].

The third transistor T3b may include a gate electrode connected to a compensation gate line GCLb, a first electrode connected to a driving power line VDLb, and a second electrode connected to the second node N2b. A compensation gate signal GC may be applied to the gate electrode of the third transistor T3b.

The fourth transistor T4b may include a gate electrode connected to an emission line EMLb, a first electrode connected to the third node N3b, and a second electrode connected to a first electrode (e.g., an anode electrode) of the light emitting element LE. An emission signal EM may be applied to the gate electrode of the fourth transistor T4b. In an embodiment, the fourth transistor T4b may further include a back gate electrode connected to the third node N3b.

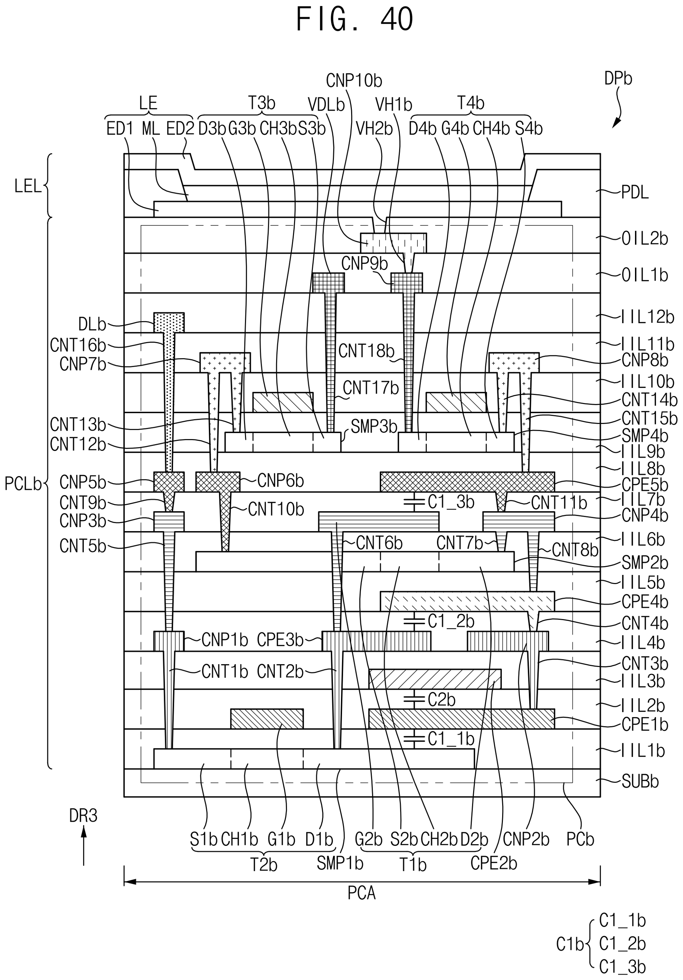

In an embodiment, each of the first transistor T1b, the third transistor T3b, and the fourth transistor T4b may be the N-type transistor, and the second transistor T2b may be the P-type transistor. For example, each of the first transistor T1b, the third transistor T3b, and the fourth transistor T4b may be the oxide thin film transistor, and the second transistor T2b may be the polysilicon thin film transistor (see FIG. 40). However, the inventive concept is not limited thereto.

The first capacitor C1b may include a first electrode connected to the first node N1b and a second electrode connected to the third node N3b.

The second capacitor C2b may include a first electrode connected to a reference voltage line VRLb and a second electrode connected to the third node N3b. A reference voltage VREF may be applied to the first electrode of the second capacitor C2b.

The light emitting element LE may include the first electrode connected to the second electrode of the fourth transistor T4b and a second electrode (e.g., a cathode electrode) connected to a common power line VSLb. A common power voltage ELVSS may be applied to the second electrode of the light emitting element LE. The light emitting element LE may emit light based on the driving current.

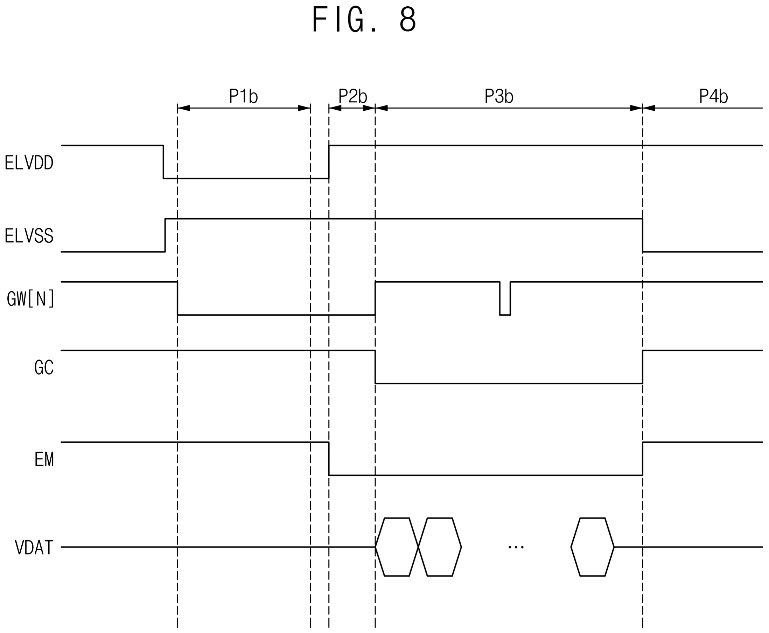

FIG. 8 is a timing diagram illustrating an example of signals applied to the pixel circuit PCb of FIG. 7.

Referring to FIGS. 7 and 8, a frame period in which the pixel circuit PCb is driven may include an initialization period P1b, a compensation period P2b, an addressing period P3b, and an emission period P4b.

In the initialization period P1b, the driving power voltage ELVDD may have a low level, the common power voltage ELVSS may have a high level, the write gate signal GW[N] may have an active level, the compensation gate signal GC may have an active level, the emission signal EM may have an active level, and the data voltage VDAT may have a common level. The common level of the data voltage VDAT may be the reference voltage VREF.

In the initialization period P1b, the second transistor T2b, the third transistor T3b, and the fourth transistor T4b may be turned on. Since the second transistor T2b is turned on, the reference voltage VREF may be applied to the first node N1b. The first transistor T1b may be turned on by the reference voltage VREF applied to the first node N1b. Since the first transistor T1b, the third transistor T3b, and the fourth transistor T4b are turned on, the low level of the driving power voltage ELVDD may be applied to the first electrode of the light emitting element LE.

In the compensation period P2b after the initialization period P1b, the driving power voltage ELVDD may have a high level, the common power voltage ELVSS may have the high level, the write gate signal GW[N] may have the active level, the compensation gate signal GC may have the active level, the emission signal EM may have a non-active level, and the data voltage VDAT may have the common level.

In the compensation period P2b, the driving power voltage ELVDD may be switched to the high level, and a voltage corresponding to the reference voltage VREF minus a threshold voltage of the first transistor T1b may be applied to the third node N3b. Here, the threshold voltage of the first transistor T1b may be a positive voltage. A voltage corresponding to the threshold voltage of the first transistor T1b may be stored in the first capacitor C1b. That is, the threshold voltage of the first transistor T1b may be compensated in the compensation period P2b.

In the compensation period P2b, the fourth transistor T4b may be turned off. Accordingly, a capacitance of the light emitting element LE may not affect the compensation operation of the threshold voltage of the first transistor T1b in the compensation period P2b. Therefore, a deterioration of the light emitting element LE may not affect the compensation operation of the threshold voltage of the first transistor T1b, so that a display quality of the display device may be improved.

In the addressing period P3b after the compensation period P2b, the driving power voltage ELVDD may have the high level, the common power voltage ELVSS may have the high level, the write gate signal GW[N] may have an active pulse corresponding to pixel rows, the compensation gate signal GC may have a non-active level, the emission signal EM may have the non-active level, and the data voltage VDAT may have a pixel data voltage corresponding to each pixel.

In the addressing period P3b, the second transistor T2b may be turned on so that the pixel data voltage may be applied to the first node N1b. In the addressing period P3b, pixel data voltages may be applied to corresponding ones of the pixel rows, respectively. The pixel data voltage may be transferred to the third node N3b by voltage distribution of the first capacitor C1b and the second capacitor C2b.

In the emission period P4b after the addressing period P3b, the driving power voltage ELVDD may have the high level, the common power voltage ELVSS may have a low level, the write gate signal GW[N] may have a non-active level, the compensation gate signal GC may have the active level, the emission signal EM may have the active level, and the data voltage VDAT may have the common level.

In the emission period P4b, since the third transistor T3b is turned on and the driving power voltage ELVDD has the high level, the first transistor T1b may output the driving current based on the voltage of the first node N1b. In addition, since the fourth transistor T4b is turned on and the common power voltage ELVSS has the low level, the light emitting element LE may emit light based on the driving current.

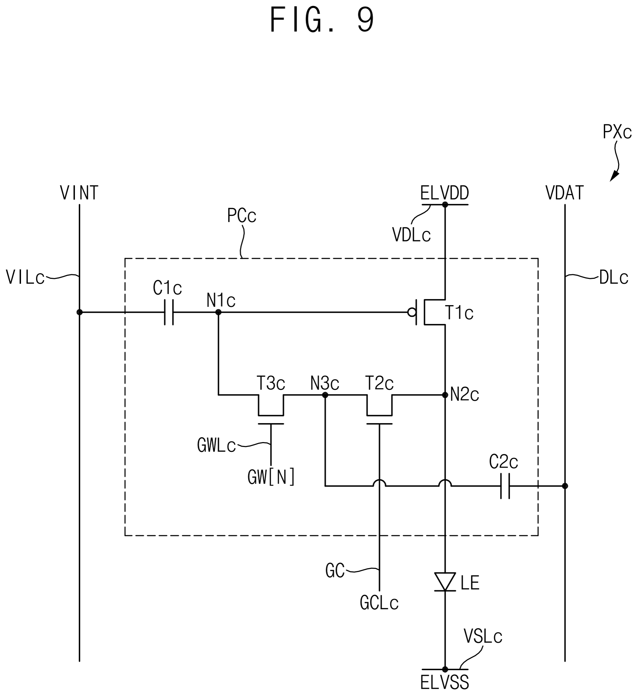

FIG. 9 is an equivalent circuit diagram schematically illustrating a pixel PXc according to an embodiment.

Referring to FIG. 9, in an embodiment, the pixel PXc may include a pixel circuit PCc and a light emitting element LE electrically connected to the pixel circuit PCc. The pixel circuit PCc may include a first transistor T1c, a second transistor T2c, a third transistor T3c, a first capacitor C1c, and a second capacitor C2c.

The first transistor T1c may include a gate electrode connected to a first node N1c, a first electrode connected to a driving power line VDLc, and a second electrode connected to a second node N2c. A driving power voltage ELVDD may be applied to the first electrode of the first transistor T1c. The first transistor T1c may be configured to generate a driving current based on the voltage of the first node N1c. The first transistor T1c may be configured to output the driving current to the second node N2c based on the voltage of the first node N1c.

The second transistor T2c may include a gate electrode connected to a compensation gate line GCLc, a first electrode connected to the second node N2c, and a second electrode connected to a third node N3c. A compensation gate signal GC may be applied to the gate electrode of the second transistor T2c.

The third transistor T3c may include a gate electrode connected to a write gate line GWLc, a first electrode connected to the third node N3c, and a second electrode connected to the first node N1c. A write gate signal GW[N] may be applied to the gate electrode of the third transistor T3c.

In an embodiment, the first transistor T1c may be the P-type transistor, and each of the second transistor T2c and the third transistor T3c may be the N-type transistor. For example, the first transistor T1c may be the polysilicon thin film transistor, and each of the second transistor T2c and the third transistor T3c may be the oxide thin film transistor. However, the inventive concept is not limited thereto.

The first capacitor C1c may include a first electrode connected to an initialization line VILc and a second electrode connected to the first node N1c. An initialization voltage VINT may be applied to the first electrode of the first capacitor C1c.

The second capacitor C2c may include a first electrode connected to a data line DLc and a second electrode connected to the third node N3c. A data voltage VDAT may be applied to the first electrode of the second capacitor C2c.

The light emitting element LE may include a first electrode (e.g., an anode electrode) connected to the second node N2c and a second electrode (e.g., a cathode electrode) connected to a common power line VSLc. A common power voltage ELVSS may be applied to the second electrode of the light emitting element LE. The light emitting element LE may emit light based on the driving current.

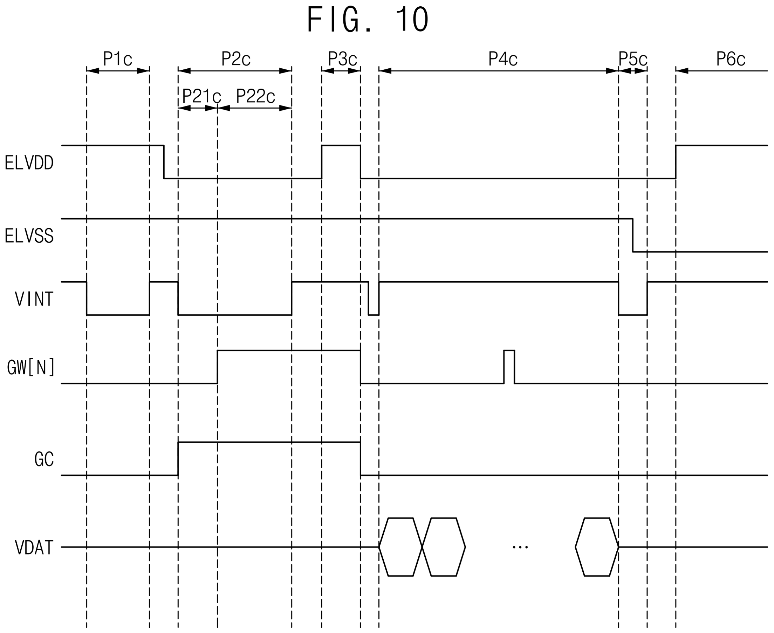

FIG. 10 is a timing diagram illustrating an example of signals applied to the pixel circuit PCc of FIG. 9.

Referring to FIGS. 9 and 10, a frame period in which the pixel circuit PCc is driven may include an on-bias period P1c, a first initialization period P2c, a compensation period P3c, an addressing period P4c, a second initialization period P5c, and an emission period P6c.

In the on-bias period P1c, the driving power voltage ELVDD may have a high level, the common power voltage ELVSS may have a high level, the initialization voltage VINT may have a low level, the write gate signal GW[N] may have a non-active level, the compensation gate signal GC may have a non-active level, and the data voltage VDAT may have a common level. The common level of the data voltage VDAT may be a reference voltage.

In the on bias period P1c, the second transistor T2c and the third transistor T3c may be turned off. Since the initialization voltage VINT has the low level and the driving power voltage ELVDD has the high level, the voltage of the gate electrode of the first transistor T1c may be initialized to a certain voltage to relieve accumulated stress of the first transistor T1c. In addition, in order to prevent the first transistor T1c from being turned on and the light emitting element LE from emitting light, the common power voltage ELVSS may have the high level.

The first initialization period P2c after the on bias period P1c may include a first-first initialization period P21c and a first-second initialization period P22c.

In the first-first initialization period P21c after the on-bias period P1c, the driving power voltage ELVDD may have a low level, the common power voltage ELVSS may have the high level, the initialization voltage VINT may have the low level, the write gate signal GW[N] may have the non-active level, the compensation gate signal GC may have an active level, and the data voltage VDAT may have the common level.

In the first-first initialization period P21c, the first transistor T1c and the second transistor T2c may be turned on, and the third transistor T3c may be turned off. In the first-first initialization period P21c, the second node N2c connected to the first electrode of the light emitting element LE may be initialized to the low level of the driving power voltage ELVDD.

In the first-second initialization period P22c after the first-first initialization period P21c, the write gate signal GW[N] may be switched to an active level to turn on the third transistor T3c. Therefore, in the first-second initialization period P22c, the first node N1c connected to the gate electrode of the first transistor T1c may be initialized to a voltage corresponding to a sum of the low level of the driving power voltage ELVDD and a threshold voltage of the first transistor T1c. Here, the threshold voltage of the first transistor T1c may be a negative voltage.

In an embodiment, the initialization voltage VINT may temporarily have a high level at a boundary between the on-bias period P1c and the first initialization period P2c. In this case, the voltage of the first node N1c may momentarily decrease more significantly in the first initialization period P2c. Accordingly, the initialization operation of the first node N1c may be performed more stably.

In the compensation period P3c after the first initialization period P2c, the driving power voltage ELVDD may have the high level, the common power voltage ELVSS may have the high level, the initialization voltage VINT may have a high level, the write gate signal GW[N] may have the active level, the compensation gate signal GC may have the active level, and the data voltage VDAT may have the common level.

In the compensation period P3c, the first transistor T1c, the second transistor T2c, and the third transistor T3c may be turned on. Accordingly, a voltage in which the threshold voltage of the first transistor T1c is compensated for may be applied to the first node N1c. For example, in the compensation period P3c, the voltage of the first node N1c may correspond to a sum of the high level of the driving power voltage ELVDD and the threshold voltage of the first transistor T1c. In addition, in order to prevent the first transistor T1c from being turned on and the light emitting element LE from emitting light, the common power voltage ELVSS may have the high level.

In the addressing period P4c after the compensation period P3c, the driving power voltage ELVDD may have the low level, the common power voltage ELVSS may have the high level, the initialization voltage VINT may have the high level, the write gate signal GW[N] may have an active pulse corresponding to pixel rows, the compensation gate signal GC may have the non-active level, and the data voltage VDAT may have a pixel data voltage corresponding to each pixel.

In the addressing period P4c, the second transistor T2c may be turned off and the third transistor T3c may be turned on. When the data voltage VDAT is changed from the reference voltage to the pixel data voltage, the voltage of the third node N3c may be changed by the coupling operation of the second capacitor C2c. The turned-on third transistor T3c may transfer the voltage of the third node N3c to the first node N1c.

In the second initialization period P5c after the addressing period P4c, the driving power voltage ELVDD may have the low level, the common power voltage ELVSS may have the high level, the initialization voltage VINT may have the low level, the write gate signal GW[N] may have the non-active level, the compensation gate signal GC may have the non-active level, and the data voltage VDAT may have the common level.

In the second initialization period P5c, the first transistor T1c may be turned on, and the second transistor T2c and the third transistor T3c may be turned off. In the second initialization period P5c, the first electrode of the light emitting element LE may be initialized prior to emission, so that an afterimage of the display image having a low grayscale value may be enhanced. In addition, since the driving power voltage ELVDD has the low level in the second initialization period P5c, the first electrode of the light emitting element LE may be stably initialized.

In the emission period P6c after the second initialization period P5c, the driving power voltage ELVDD may have the high level, the common power voltage ELVSS may have a low level, the initialization voltage VINT may have the high level, the write gate signal GW[N] may have the non-active level, the compensation gate signal GC may have the non-active level, and the data voltage VDAT may have the common level.

In the emission period P6c, since the first transistor T1c is turned on and the driving power voltage ELVDD has the high level, the first transistor T1c may output the driving current based on the voltage of the first node N1c. In addition, since the common power voltage ELVSS has the low level, the light emitting element LE may emit light based on the driving current.

According to embodiments of the inventive concept, the pixel circuit PC may have 4T2C or 3T2C structure, and a degree of integration of the pixel circuit PC may be improved. In addition, as described below with reference to FIGS. 12 to 65, the circuit element layer PCL including the pixel circuit PC may be multi-layered, so that the degree of integration of the pixel circuit PC may be further improved. Accordingly, the transistor area ratio of the display panel DP may increase, and the contact hole area ratio of the display panel DP may increase. In addition, the resolution of the display panel DP and the resolution of the display device DD including the same may be improved.

For example, the resolution of the display device DD may be in a range of about 1250 ppi (pixel per inch) or more. For example, the resolution of the display device DD may be in a range of about 1500 ppi or more. For example, the resolution of the display device DD may be in a range of about 1750 ppi or more. For example, the resolution of the display device DD may be in a range of about 2000 ppi or more.

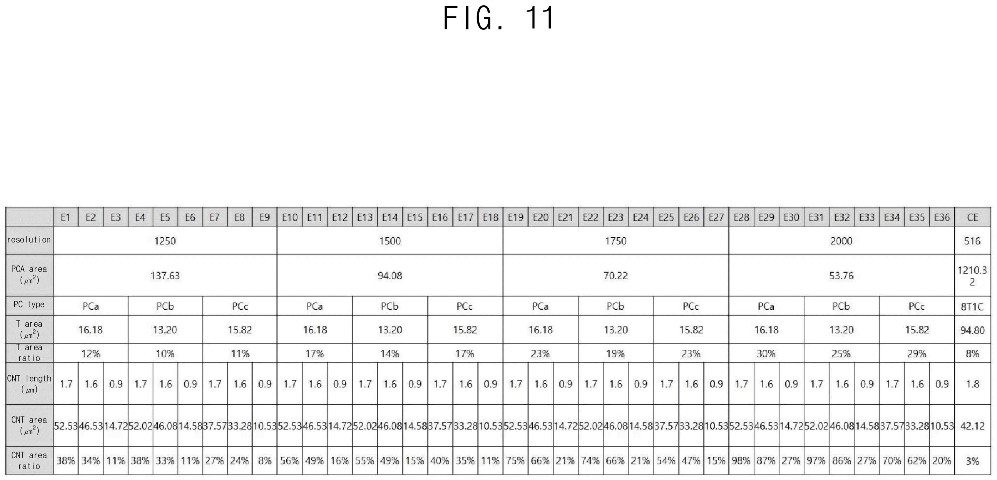

FIG. 11 is a table showing transistor area ratios and contact hole area ratios according to embodiments and a comparative example.

FIG. 11 shows a resolution of each display device (resolution), an area of one pixel circuit (PCA area), a type of the pixel circuit (PC type), an area of transistors (T area), the transistor area ratio (T area ratio), a length of each contact hole (CNT length), areas of the contact holes (CNT area), and the contact hole area ratio (CNT area ratio), in display devices according to Embodiments 1 to 36 (E1 to E36) and a display device according to Comparative Example CE.

Here, in the PC type, PCa means the pixel circuit PCa of FIG. 5, PCb means the pixel circuit PCb of FIG. 7, PCc means the pixel circuit PCc of FIG. 9, and 8T1C means a pixel circuit of the 8T1C structure according to the comparative example. The T area is a value calculated by summing areas of channel regions of transistors T in one pixel circuit region PCA in a plan view. The T area ratio is a value calculated as a ratio of an area of the transistor T to an area of one pixel circuit region PCA. The CNT length is the mode value of length of short sides of contact holes CNT (through holes penetrating an inorganic insulating layer). The CNT area is a value calculated by summing areas of the contact holes CNT in one pixel circuit region PCA in a plan view, and an area of each contact hole CNT is measured based on the bottom surface of each contact hole CNT. The CNT area ratio is a value calculated as a ratio of the CNT area to the PCA area.

Referring to FIG. 11, in Embodiments 1 to 36 (E1 to E36), it can be noted that the T area ratio (%) is 10 or more, which is greater than the T area ratio of the Comparative Example CE, and the CNT area ratio (%) is 8 or more, which is greater than the CNT area ratio of the Comparative Example CE.

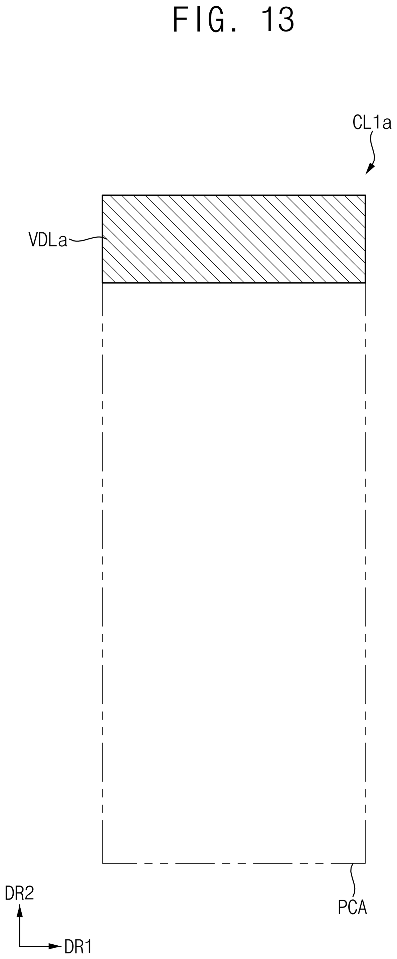

FIG. 12 is a cross-sectional view illustrating a display panel DPa according to an embodiment. FIGS. 13 to 39 are layout views illustrating the display panel DPa of FIG. 12.

FIG. 12 is a cross-sectional view schematically illustrating one pixel PXa described with reference to FIG. 5. FIGS. 13 to 39 are layout views illustrating one pixel circuit PCa of FIG. 12. FIGS. 13 to 39 selectively illustrate some of the layers among the plurality of layers included in the display panel DPa. Each of FIGS. 13 to 39 may correspond to one pixel circuit region PCA.

Hereinafter, an example of an arrangement structure of the transistors, the capacitors, and the lines included in the pixel circuit PCa of FIG. 5 will be described in greater detail with reference to FIGS. 12 to 39. The arrangement structure of one pixel circuit PCa described with reference to FIGS. 12 to 39 may be repeatedly provided in the display panel DPa.

Referring to FIGS. 12 to 39, the display panel DPa may include the substrate SUB, the circuit element layer PCLa, and the light emitting element layer LEL. The pixel circuit PCa of FIG. 5 may be disposed in the circuit element layer PCLa, and the light emitting element LE of FIG. 5 and the pixel defining layer PDL may be disposed in the light emitting element layer LEL. The circuit element layer PCLa and the light emitting element layer LEL may be sequentially disposed on the substrate SUB along the third direction DR3. The third direction DR3 may cross the first direction DR1 and the second direction DR2. Hereinafter, the third direction DR3 may be referred to as an upper direction.

In an embodiment, the circuit element layer PCLa may include a first conductive layer CL1a, a first inorganic insulating layer IIL1a, a first semiconductor layer SML1a, a second inorganic insulating layer IIL2a, a second conductive layer CL2a, a third inorganic insulating layer IIL3a, a third conductive layer CL3a, a fourth inorganic insulating layer IIL4a, a fourth conductive layer CL4a, a fifth inorganic insulating layer IIL5a, a fifth conductive layer CL5a, a sixth inorganic insulating layer IIL6a, a sixth conductive layer CL6a, a seventh inorganic insulating layer IIL7a, a seventh conductive layer CL7a, an eighth inorganic insulating layer IIL8a, a second semiconductor layer SML2a, a ninth inorganic insulating layer IIL9a, an eighth conductive layer CL8a, a tenth inorganic insulating layer IIL10a, a ninth conductive layer CL9a, an eleventh inorganic insulating layer IIL11a, a tenth conductive layer CL10a, a twelfth inorganic insulating layer IIL12a, an eleventh conductive layer CL11a, a thirteenth inorganic insulating layer IIL13a, a twelfth conductive layer CL12a, a first organic insulating layer OIL1a, a thirteenth conductive layer, and a second organic insulating layer OIL2a sequentially disposed or stacked along the third direction DR3.

FIG. 13 illustrates the first conductive layer CL1a.

In an embodiment, as illustrated in FIGS. 12 and 13, the first conductive layer CL1a may be disposed on the substrate SUB. The first conductive layer CL1a may include a conductive material, such as a metal, an alloy, a conductive metal nitride, a conductive metal oxide, a transparent conductive material, or the like. For example, the first conductive layer CL1a may include a low-resistance metal material, such as copper (Cu), aluminum (Al), molybdenum (Mo), titanium (Ti), or the like, but the inventive concept is not limited thereto. The first conductive layer CL1a may have a single-layer structure or a multi-layer structure including a plurality of conductive layers. In an embodiment, the first conductive layer CL1a may be referred to as a lower conductive layer.

The first conductive layer CL1a may include or define the driving power line VDLa. In an embodiment, the driving power line VDLa may extend in the first direction DR1. The driving power voltage ELVDD of FIG. 5 may be applied to the driving power line VDLa.

In an embodiment, a buffer layer may be disposed between the substrate SUB and the first conductive layer CL1a. The buffer layer may prevent or reduce impurities, such as oxygen or moisture, from diffusing into the first conductive layer CL1a through the substrate SUB. The buffer layer may include an inorganic insulating material, such as a silicon compound, a metal oxide, or the like. The buffer layer may have a single-layer structure or a multi-layer structure including a plurality of insulating layers. In an embodiment, the buffer layer may be omitted.

The first inorganic insulating layer IIL1a may be disposed on the first conductive layer CL1a. The first inorganic insulating layer IIL1a may include an inorganic insulating material. The first inorganic insulating layer IIL1a may have a single-layer structure or a multi-layer structure including a plurality of insulating layers. The first inorganic insulating layer IIL1a may cover the driving power line VDLa.

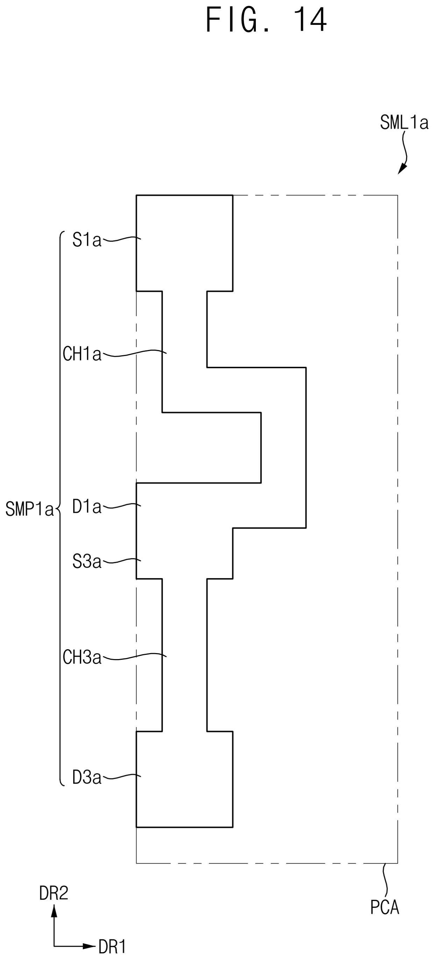

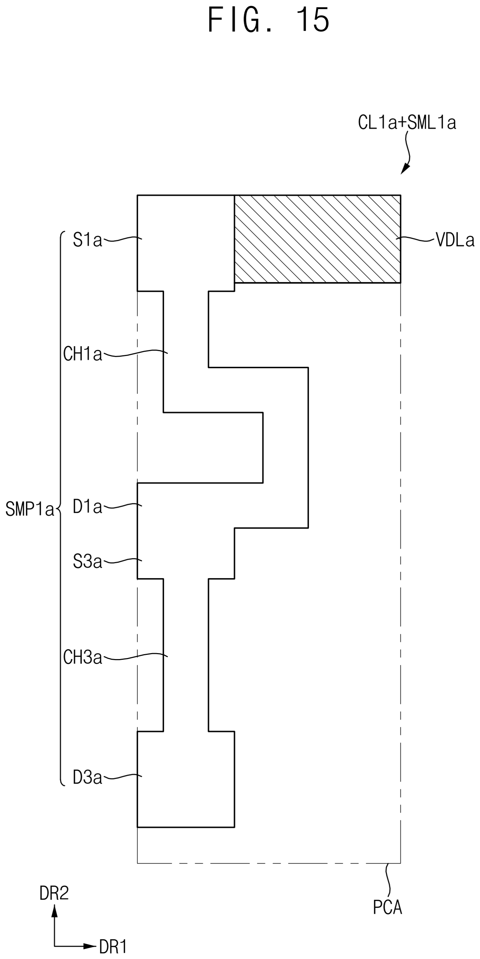

FIG. 14 illustrates the first semiconductor layer SML1a, and FIG. 15 illustrates the view of FIG. 13 with the first semiconductor layer SML1a further disposed.

In an embodiment, as illustrated in FIGS. 12, 14, and 15, the first semiconductor layer SML1a may be disposed on the first inorganic insulating layer IIL1a. That is, the first conductive layer CL1a may be disposed under the first semiconductor layer SML1a.

In an embodiment, the first semiconductor layer SML1a may include a silicon semiconductor. For example, the first semiconductor layer SML1a may include polycrystalline silicon, amorphous silicon, or the like. For example, the first semiconductor layer SML1a may include low-temperature polysilicon.

The first semiconductor layer SML1a may include or define a first semiconductor pattern SMP1a. The first semiconductor pattern SMP1a may be integrally provided. The first semiconductor pattern SMP1a may include a first source region S1a, a first channel region CH1a, a first drain region D1a, a third source region S3a, a third channel region CH3a, and a third drain region D3a. The first channel region CH1a may be defined between the first source region S1a and the first drain region D1a, and the third channel region CH3a may be defined between the third source region S3a and the third drain region D3a. The first drain region D1a and the third source region S3a may be connected to each other. In an embodiment, the third channel region CH3a may be located in a direction opposite to the second direction DR2 from the first channel region CH1a. In an embodiment, the first source region S1a, the first drain region D1a, the third source region S3a, and the third drain region D3a may be sequentially disposed along the direction opposite to the second direction DR2.

In an embodiment, as illustrated in FIG. 14, a length of the first channel region CH1a may be greater than a length of the third channel region CH3a. For example, in a plan view (or when viewed in the third direction DR3), the first channel region CH1a may have a shape that is bent along the first direction DR1 and the second direction DR2, and the third channel region CH3a may have a shape that extends in a straight line along the second direction DR2, but the inventive concept is not limited thereto.

Electrical properties of the first semiconductor pattern SMP1a may vary depending on whether a region thereof is doped or not. In an embodiment, the first source region S1a, the first drain region D1a, the third source region S3a, and the third drain region D3a may be doped with a P-type dopant, but the inventive concept is not limited thereto.

The first source region S1a may be the first electrode of the first transistor T1a, the first drain region D1a may be the second electrode of the first transistor T1a, and the first channel region CH1a may be a channel of the first transistor T1a. In an embodiment, as illustrated in FIGS. 13 and 15, the first source region S1a may overlap the driving power line VDLa in a plan view.

The third source region S3a may be the first electrode of the third transistor T3a, the third drain region D3a may be the second electrode of the third transistor T3a, and the third channel region CH3a may be a channel of the third transistor T3a.

The second inorganic insulating layer IIL2a may be disposed on the first semiconductor layer SML1a. The second inorganic insulating layer IIL2a may include an inorganic insulating material. The second inorganic insulating layer IIL2a may have a single-layer structure or a multi-layer structure including a plurality of insulating layers. The second inorganic insulating layer IIL2a may cover the first semiconductor pattern SMP1a.

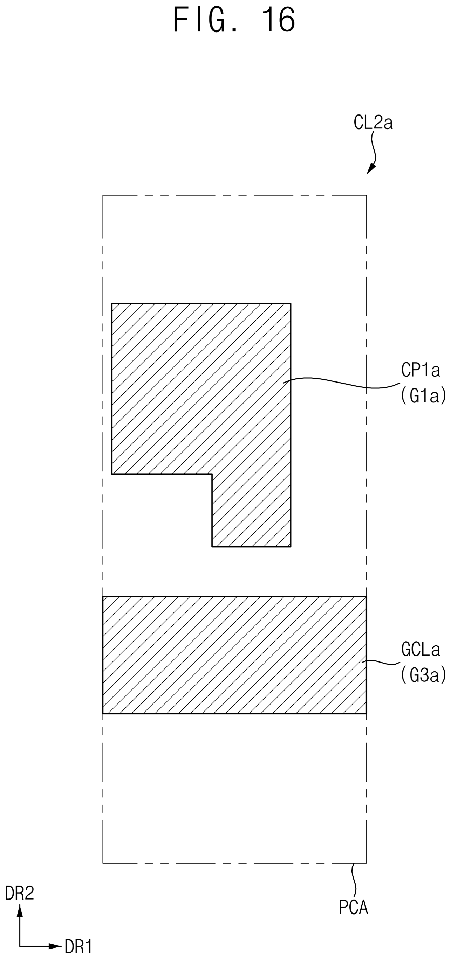

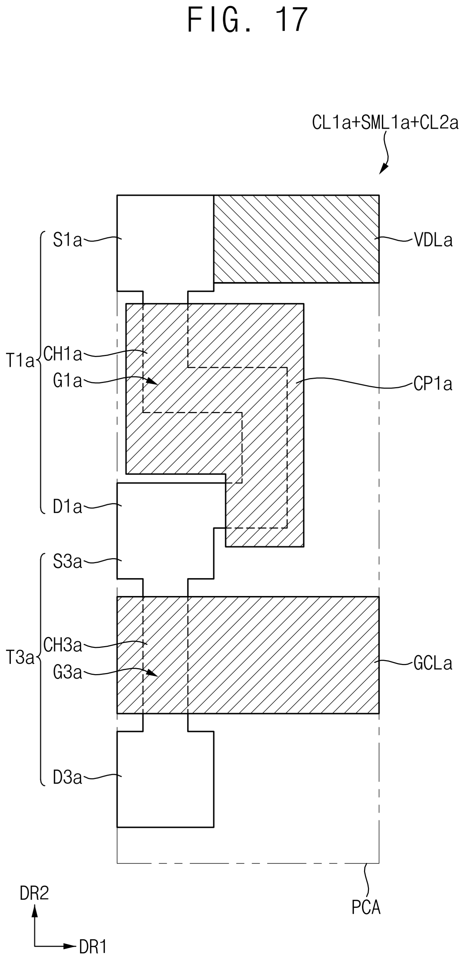

FIG. 16 illustrates the second conductive layer CL2a, and FIG. 17 illustrates the view of FIG. 15 with the second conductive layer CL2a further disposed.

In an embodiment, as illustrated in FIGS. 12, 16, and 17, the second conductive layer CL2a may be disposed on the second inorganic insulating layer IIL2a. The second conductive layer CL2a may be disposed on the first semiconductor layer SML1a and under the second semiconductor layer SML2a. That is, the second conductive layer CL2a may be disposed between the first semiconductor layer SML1a and the second semiconductor layer SML2a. The second conductive layer CL2a may include a conductive material. The second conductive layer CL2a may have a single-layer structure or a multi-layer structure including a plurality of conductive layers. In an embodiment, the second conductive layer CL2a may be referred to as a first gate conductive layer.

The second conductive layer CL2a may include or define a first conductive pattern CP1a and the compensation gate line GCLa. The first conductive pattern CP1a and the compensation gate line GCLa may be spaced apart from each other in a plan view.

In an embodiment, as illustrated in FIGS. 15 and 17, a portion of the first conductive pattern CP1a may overlap the first channel region CH1a of the first semiconductor pattern SMP1a in a plan view. The portion of the first conductive pattern CP1a overlapping the first channel region CH1a may be the gate electrode G1a of the first transistor T1a.

In an embodiment, the first conductive pattern CP1a may be spaced apart from the driving power line VDLa in the direction opposite to the second direction DR2 in a plan view. That is, the first conductive pattern CP1a may not overlap the driving power line VDLa in a plan view.

In an embodiment, the compensation gate line GCLa may extend in the first direction DR1. The compensation gate line GCLa may be spaced apart from the first conductive pattern CP1a in the direction opposite to the second direction DR2 in a plan view. The compensation gate signal GC of FIG. 5 may be applied to the compensation gate line GCLa.

A portion of the compensation gate line GCLa may overlap the third channel region CH3a of the first semiconductor pattern SMP1a in a plan view. The portion of the compensation gate line GCLa overlapping the third channel region CH3a may be the gate electrode G3a of the third transistor T3a.

The third inorganic insulating layer IIL3a may be disposed on the second conductive layer CL2a. The third inorganic insulating layer IIL3a may include an inorganic insulating material. The third inorganic insulating layer IIL3a may have a single-layer structure or a multi-layer structure including a plurality of insulating layers. The third inorganic insulating layer IIL3a may cover the first conductive pattern CP1a and the compensation gate line GCLa.

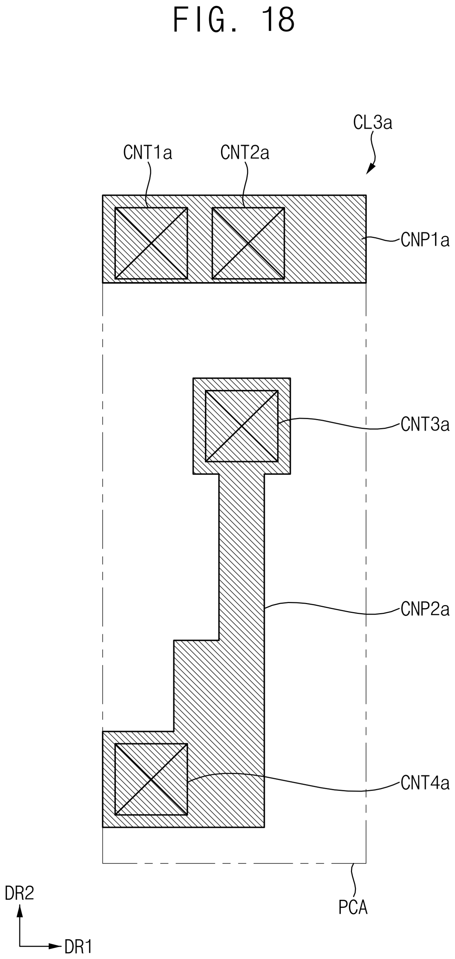

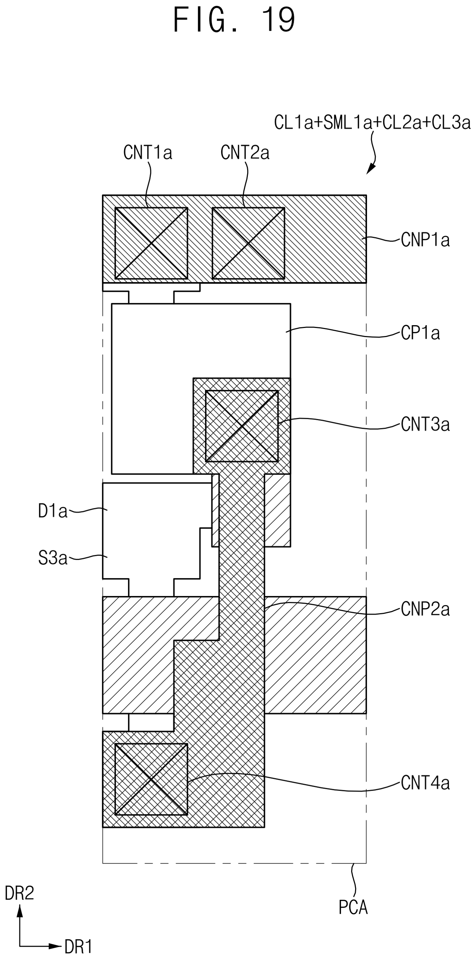

FIG. 18 illustrates the third conductive layer CL3a, and FIG. 19 illustrates the view of FIG. 17 with the third conductive layer CL3a further disposed.

In an embodiment, as illustrated in FIGS. 12, 18, and 19, the third conductive layer CL3a may be disposed on the third inorganic insulating layer IIL3a. The third conductive layer CL3a may be disposed on the second conductive layer CL2a and under the second semiconductor layer SML2a. That is, the third conductive layer CL3a may be disposed between the second conductive layer CL2a and the second semiconductor layer SML2a. The third conductive layer CL3a may include a conductive material. The third conductive layer CL3a may have a single-layer structure or a multi-layer structure including a plurality of conductive layers. In an embodiment, the third conductive layer CL3a may be referred to as a second gate conductive layer.

The third conductive layer CL3a may include or define a first connection pattern CNP1a and a second connection pattern CNP2a. The first connection pattern CNP1a and the second connection pattern CNP2a may be spaced apart from each other in a plan view.

In an embodiment, as illustrated in FIGS. 17 and 19, the first connection pattern CNP1a may overlap each of the first source region S1a of the first semiconductor pattern SMP1a and the driving power line VDLa in a plan view. In an embodiment, the first connection pattern CNP1a may extend in the first direction DR1.

A first portion of the first connection pattern CNP1a may be connected to the first source region S1a of the first semiconductor pattern SMP1a through a first contact hole CNT1a defined or formed by penetrating (or defined or formed through) an inorganic insulating layer (e.g., the second and third inorganic insulating layers IIL2a and IIL3a) disposed therebelow. For example, the first contact hole CNT1a may expose a portion of the first source region S1a of the first semiconductor pattern SMP1a. The first portion of the first connection pattern CNP1a may contact the portion of the first source region S1a of the first semiconductor pattern SMP1a exposed by the first contact hole CNT1a.

A second portion of the first connection pattern CNP1a may be connected to the driving power line VDLa through a second contact hole CNT2a defined or formed by penetrating an inorganic insulating layer (e.g., the first to third inorganic insulating layers IIL1a, IIL2a, and IIL3a) disposed therebelow. For example, the second contact hole CNT2a may expose a portion of the driving power line VDLa. The second portion of the first connection pattern CNP1a may contact the portion of the driving power line VDLa exposed by the second contact hole CNT2a. Accordingly, the first connection pattern CNP1a may electrically connect the first source region S1a of the first semiconductor pattern SMP1a (i.e., the first electrode of the first transistor T1a) and the driving power line VDLa.

In an embodiment, the second connection pattern CNP2a may be spaced apart from the first connection pattern CNP1a in the direction opposite to the second direction DR2 in a plan view. In an embodiment, the second connection pattern CNP2a may overlap the compensation gate line GCLa in a plan view. The second connection pattern CNP2a may be electrically insulated from the compensation gate line GCLa.

The second connection pattern CNP2a may overlap each of the first conductive pattern CP1a and the third drain region D3a of the first semiconductor pattern SMP1a in a plan view.

A first portion of the second connection pattern CNP2a may be connected to the first conductive pattern CP1a through a third contact hole CNT3a defined or formed by penetrating an inorganic insulating layer (e.g., the third inorganic insulating layer IIL3a) disposed therebelow. For example, the third contact hole CNT3a may expose a portion of the first conductive pattern CP1a. The first portion of the second connection pattern CNP2a may contact the portion of the first conductive pattern CP1a exposed by the third contact hole CNT3a.

A second portion of the second connection pattern CNP2a may be connected to the third drain region D3a of the first semiconductor pattern SMP1a through a fourth contact hole CNT4a defined or formed by penetrating an inorganic insulating layer (e.g., the second and third inorganic insulating layers IIL2a and IIL3a) disposed therebelow. For example, the fourth contact hole CNT4a may expose a portion of the third drain region D3a of the first semiconductor pattern SMP1a. The second portion of the second connection pattern CNP2a may contact the portion of the third drain region D3a of the first semiconductor pattern SMP1a exposed by the fourth contact hole CNT4a. Accordingly, the second connection pattern CNP2a may electrically connect the third drain region D3a of the first semiconductor pattern SMP1a (i.e., the second electrode of the third transistor T3a) and the first conductive pattern CP1a (i.e., the gate electrode G1a of the first transistor T1a).

The fourth inorganic insulating layer IIL4a may be disposed on the third conductive layer CL3a. The fourth inorganic insulating layer IIL4a may include an inorganic insulating material. The fourth inorganic insulating layer IIL4a may have a single-layer structure or a multi-layer structure including a plurality of insulating layers. The fourth inorganic insulating layer IIL4a may cover the first connection pattern CNP1a and the second connection pattern CNP2a.

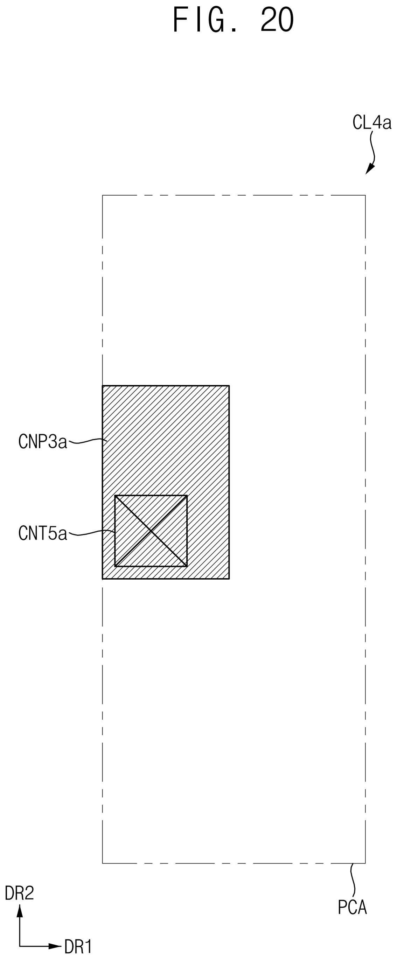

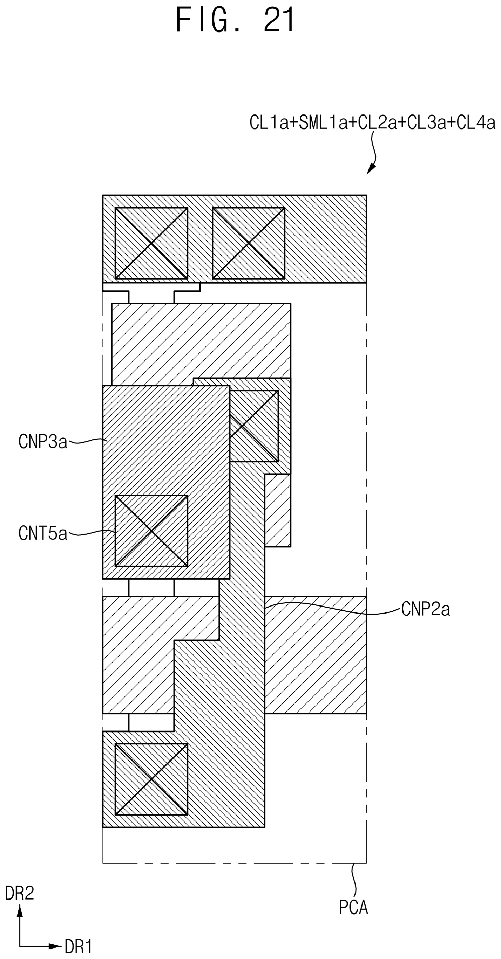

FIG. 20 illustrates the fourth conductive layer CL4a, and FIG. 21 illustrates the view of FIG. 19 with the fourth conductive layer CL4a further disposed.

In an embodiment, as illustrated in FIGS. 12, 20, and 21, the fourth conductive layer CL4a may be disposed on the fourth inorganic insulating layer IIL4a. The fourth conductive layer CL4a may be disposed on the third conductive layer CL3a and under the second semiconductor layer SML2a. That is, the fourth conductive layer CL4a may be disposed between the third conductive layer CL3a and the second semiconductor layer SML2a. The fourth conductive layer CL4a may include a conductive material. The fourth conductive layer CL4a may have a single-layer structure or a multi-layer structure including a plurality of conductive layers. In an embodiment, the fourth conductive layer CL4a may be referred to as a third gate conductive layer.

The fourth conductive layer CL4a may include or define a third connection pattern CNP3a. In an embodiment, as illustrated in FIGS. 19 and 21, the third connection pattern CNP3a may overlap the first drain region D1a and the third source region S3a of the first semiconductor pattern SMP1a in a plan view.

The third connection pattern CNP3a may be connected to the first drain region D1a of the first semiconductor pattern SMP1a (i.e., the second electrode of the first transistor T1a) and the third source region S3a (i.e., the first electrode of the third transistor T3a) through a fifth contact hole CNT5a defined or formed by penetrating an inorganic insulating layer (e.g., the second to fourth inorganic insulating layers IIL2a, IIL3a, and IIL4a) disposed therebelow. For example, the fifth contact hole CNT5a may expose a portion of the first drain region D1a and the third source region S3a of the first semiconductor pattern SMP1a. A portion of the third connection pattern CNP3a may contact the portion of the first drain region D1a and the third source region S3a of the first semiconductor pattern SMP1a exposed by the fifth contact hole CNT5a.

The fifth inorganic insulating layer IIL5a may be disposed on the fourth conductive layer CL4a. The fifth inorganic insulating layer IIL5a may include an inorganic insulating material. The fifth inorganic insulating layer IIL5a may have a single-layer structure or a multi-layer structure including a plurality of insulating layers. The fifth inorganic insulating layer IIL5a may cover the third connection pattern CNP3a.

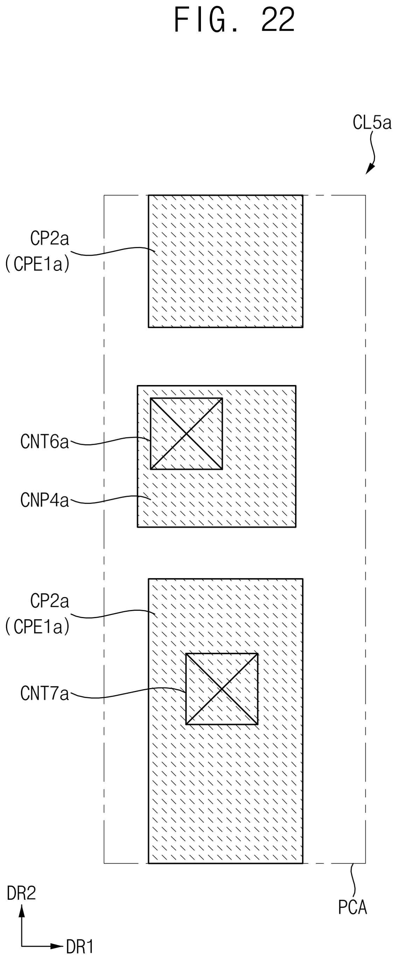

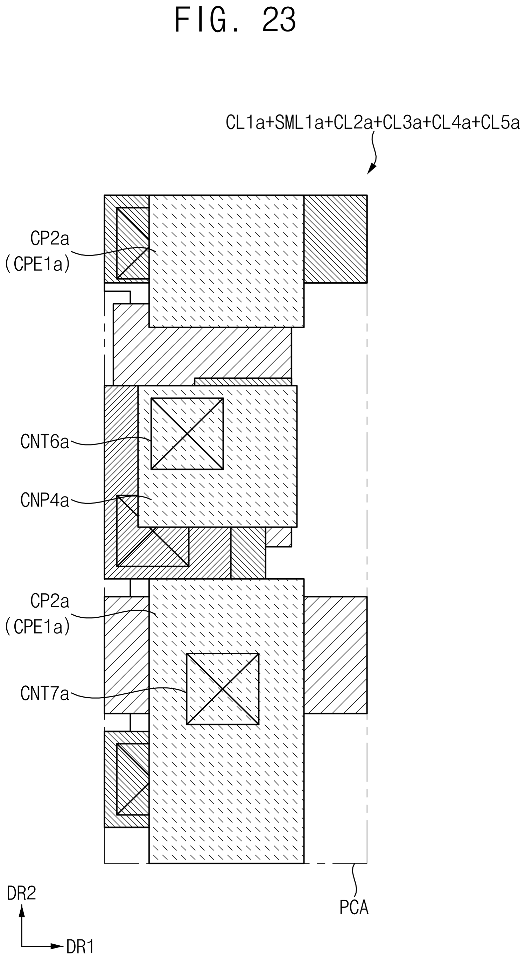

FIG. 22 illustrates the fifth conductive layer CL5a, and FIG. 23 illustrates the view of FIG. 21 with the fifth conductive layer CL5a further disposed.

In an embodiment, as illustrated in FIGS. 12, 22, and 23, the fifth conductive layer CL5a may be disposed on the fifth inorganic insulating layer IIL5a. The fifth conductive layer CL5a may be disposed on the fourth conductive layer CL4a and under the second semiconductor layer SML2a. That is, the fifth conductive layer CL5a may be disposed between the fourth conductive layer CL4a and the second semiconductor layer SML2a. The fifth conductive layer CL5a may include a conductive material. The fifth conductive layer CL5a may have a single-layer structure or a multi-layer structure including a plurality of conductive layers. In an embodiment, the fifth conductive layer CL5a may be referred to as a fourth gate conductive layer.

The fifth conductive layer CL5a may include or define a fourth connection pattern CNP4a and a second conductive pattern CP2a. The fourth connection pattern CNP4a and the second conductive pattern CP2a may be spaced apart from each other in a plan view.

In an embodiment, as illustrated in FIGS. 21 and 23, the fourth connection pattern CNP4a may overlap the third connection pattern CNP3a in a plan view. The fourth connection pattern CNP4a may be connected to the third connection pattern CNP3a through a sixth contact hole CNT6a defined or formed by penetrating an inorganic insulating layer (e.g., the fifth inorganic insulating layer IIL5a) disposed therebelow. For example, the sixth contact hole CNT6a may expose a portion of the third connection pattern CNP3a. A portion of the fourth connection pattern CNP4a may contact the portion of the third connection pattern CNP3a exposed by the sixth contact hole CNT6a.

In an embodiment, the second conductive pattern CP2a may be spaced apart from the third connection pattern CNP3a in the direction opposite to the second direction DR2 in a plan view.

In an embodiment, a portion of the second conductive pattern CP2a may overlap the second connection pattern CNP2a in a plan view. The portion of the second conductive pattern CP2a may be connected to the second connection pattern CNP2a through a seventh contact hole CNT7a defined or formed by penetrating an inorganic insulating layer (e.g., the fourth and fifth inorganic insulating layers IIL4a and IIL5a) disposed therebelow. For example, the seventh contact hole CNT7a may expose a portion of the second connection pattern CNP2a. The portion of the second conductive pattern CP2a may contact the portion of the second connection pattern CNP2a exposed by the seventh contact hole CNT7a. That is, the second conductive pattern CP2a may be electrically connected to each of the third drain region D3a of the first semiconductor pattern SMP1a (i.e., the second electrode of the third transistor T3a) and the first conductive pattern CP1a (i.e., the gate electrode G1a of the first transistor T1a) through the second connection pattern CNP2a. As described below, the second conductive pattern CP2a may be the first electrode CPE1a of the first capacitor C1a.

The sixth inorganic insulating layer IIL6a may be disposed on the fifth conductive layer CL5a. The sixth inorganic insulating layer IIL6a may include an inorganic insulating material. The sixth inorganic insulating layer IIL6a may have a single-layer structure or a multi-layer structure including a plurality of insulating layers. The sixth inorganic insulating layer IIL6a may cover the fourth connection pattern CNP4a and the second conductive pattern CP2a.

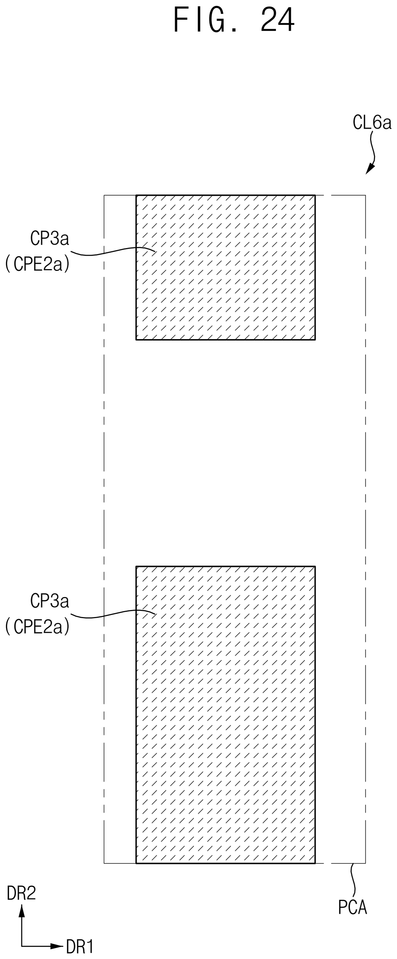

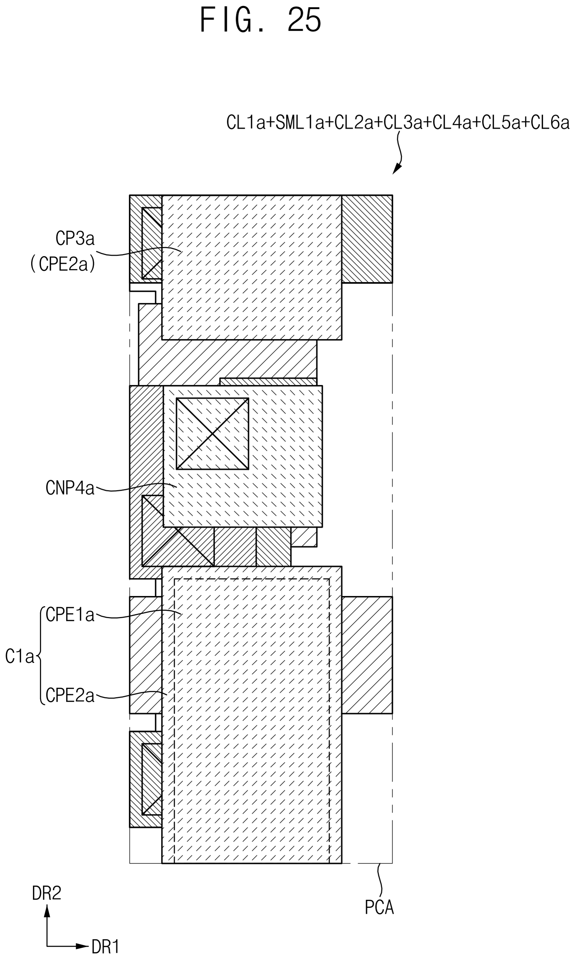

FIG. 24 illustrates the sixth conductive layer CL6a, and FIG. 25 illustrates the view of FIG. 23 with the sixth conductive layer CL6a further disposed.

In an embodiment, as illustrated in FIGS. 12, 24, and 25, the sixth conductive layer CL6a may be disposed on the sixth inorganic insulating layer IIL6a. The sixth conductive layer CL6a may be disposed on the fifth conductive layer CL5a and under the second semiconductor layer SML2a. That is, the sixth conductive layer CL6a may be disposed between the fifth conductive layer CL5a and the second semiconductor layer SML2a. The sixth conductive layer CL6a may include a conductive material. The sixth conductive layer CL6a may have a single-layer structure or a multi-layer structure including a plurality of conductive layers. In an embodiment, the sixth conductive layer CL6a may be referred to as a first contact conductive layer.

The sixth conductive layer CL6a may include or define a third conductive pattern CP3a. The third conductive pattern CP3a may overlap the second conductive pattern CP2a in a plan view. In an embodiment, the third conductive pattern CP3a may be spaced apart from the fourth connection pattern CNP4a in the direction opposite to the second direction DR2 in a plan view. That is, the third conductive pattern CP3a may not overlap the fourth connection pattern CNP4a in a plan view.

The second conductive pattern CP2a and the third conductive pattern CP3a, which are spaced apart from each other with the sixth inorganic insulating layer IIL6a therebetween, may form the first capacitor C1a. The second conductive pattern CP2a may be the first electrode CPE1a of the first capacitor C1a, and the third conductive pattern CP3a may be the second electrode CPE2a of the first capacitor C1a. Although FIG. 25 illustrates an embodiment where a size of the third conductive pattern CP3a is larger than a size of the second conductive pattern CP2a, the inventive concept is not limited thereto.

The seventh inorganic insulating layer IIL7a may be disposed on the sixth conductive layer CL6a. The seventh inorganic insulating layer IIL7a may include an inorganic insulating material. The seventh inorganic insulating layer IIL7a may have a single-layer structure or a multi-layer structure including a plurality of insulating layers. The seventh inorganic insulating layer IIL7a may cover the third conductive pattern CP3a.

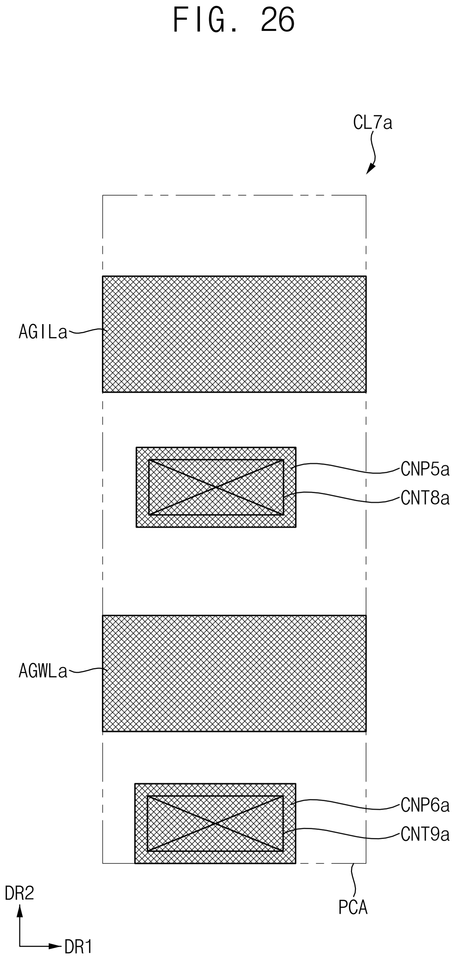

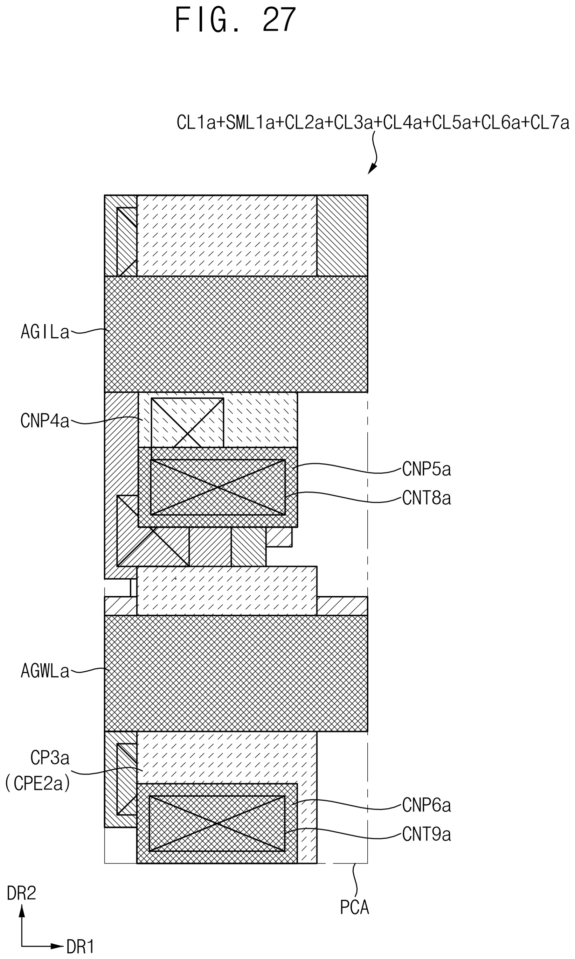

FIG. 26 illustrates the seventh conductive layer CL7a, and FIG. 27 illustrates the view of FIG. 25 with the seventh conductive layer CL7a further disposed.

In an embodiment, as illustrated in FIGS. 12, 26, and 27, the seventh conductive layer CL7a may be disposed on the seventh inorganic insulating layer IIL7a. The seventh conductive layer CL7a may be disposed on the sixth conductive layer CL6a and under the second semiconductor layer SML2a. That is, the seventh conductive layer CL7a may be disposed between the sixth conductive layer CL6a and the second semiconductor layer SML2a. The seventh conductive layer CL7a may include a conductive material. The seventh conductive layer CL7a may have a single-layer structure or a multi-layer structure including a plurality of conductive layers. In an embodiment, the seventh conductive layer CL7a may be referred to as a fifth gate conductive layer.

The seventh conductive layer CL7a may include or define a fifth connection pattern CNP5a, a sixth connection pattern CNP6a, an auxiliary initialization gate line AGILa, and an auxiliary write gate line AGWLa. The fifth connection pattern CNP5a, the sixth connection pattern CNP6a, the auxiliary initialization gate line AGILa, and the auxiliary write gate line AGWLa may be spaced apart from each other in a plan view.

In an embodiment, as illustrated in FIGS. 25 and 27, the fifth connection pattern CNP5a may overlap the fourth connection pattern CNP4a in a plan view. The fifth connection pattern CNP5a may be connected to the fourth connection pattern CNP4a through an eighth contact hole CNT8a defined or formed by penetrating an inorganic insulating layer (e.g., the sixth and seventh inorganic insulating layers IIL6a and IIL7a) disposed therebelow. For example, the eighth contact hole CNT8a may expose a portion of the fourth connection pattern CNP4a. A portion of the fifth connection pattern CNP5a may contact the portion of the fourth connection pattern CNP4a exposed by the eighth contact hole CNT8a.

In an embodiment, the sixth connection pattern CNP6a may be spaced apart from the fifth connection pattern CNP5a in the direction opposite to the second direction DR2 in a plan view. In an embodiment, as illustrated in FIGS. 25 and 27, the sixth connection pattern CNP6a may overlap the third conductive pattern CP3a (i.e., the second electrode CPE2a of the first capacitor C1a) in a plan view. The sixth connection pattern CNP6a may be connected to the third conductive pattern CP3a (i.e., the second electrode CPE2a of the first capacitor C1a) through a ninth contact hole CNT9a defined or formed by penetrating an inorganic insulating layer (e.g., the seventh inorganic insulating layer IIL7a) disposed therebelow. For example, the ninth contact hole CNT9a may expose a portion of the third conductive pattern CP3a. A portion of the sixth connecting pattern CNP6 may contact the portion of the third conductive pattern CP3a exposed by the ninth contact hole CNT9a.

In an embodiment, the auxiliary initialization gate line AGILa may extend in the first direction DR1. The auxiliary initialization gate line AGILa may be spaced apart from the fifth connection pattern CNP5a in the second direction DR2 in a plan view. For example, the auxiliary initialization gate line AGILa may be connected to the initialization gate line GILa disposed in the eighth conductive layer CL8a described below through a contact hole in the peripheral region PA (see FIG. 2). The initialization gate signal GI of FIG. 5 may be applied to the auxiliary initialization gate line AGILa.

In an embodiment, the auxiliary write gate line AGWLa may extend in the first direction DR1. The auxiliary write gate line AGWLa may be disposed between the fifth connection pattern CNP5a and the sixth connection pattern CNP6a in a plan view. For example, the auxiliary write gate line AGWLa may be connected to the write gate line GWLa disposed in the eighth conductive layer CL8a described below through a contact hole in the peripheral region PA (see FIG. 2). The write gate signal GW[N] of FIG. 5 may be applied to the auxiliary write gate line AGWLa.

The eighth inorganic insulating layer IIL8a may be disposed on the seventh conductive layer CL7a. The eighth inorganic insulating layer IIL8a may include an inorganic insulating material. The eighth inorganic insulating layer IIL8a may have a single-layer structure or a multi-layer structure including a plurality of insulating layers. The eighth inorganic insulating layer IIL8a may cover the fifth connection pattern CNP5a, the sixth connection pattern CNP6a, the auxiliary initialization gate line AGILa, and the auxiliary write gate line AGWLa.

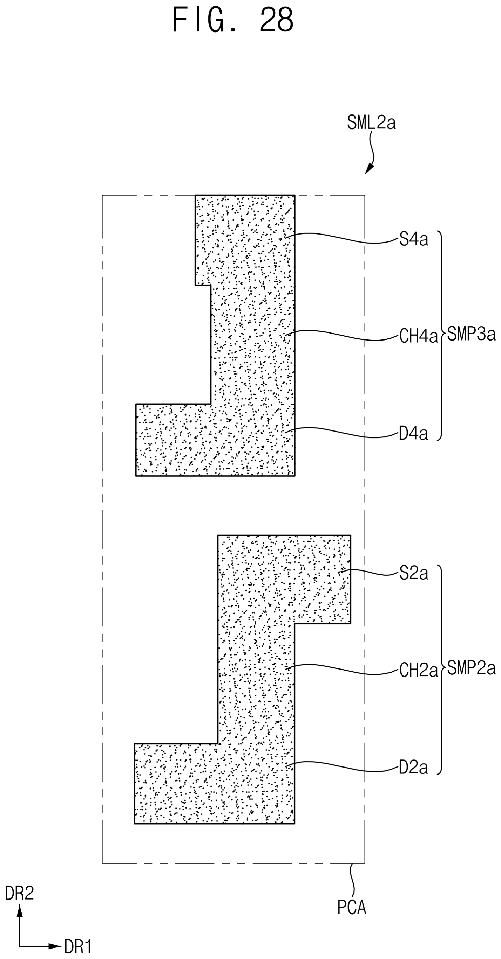

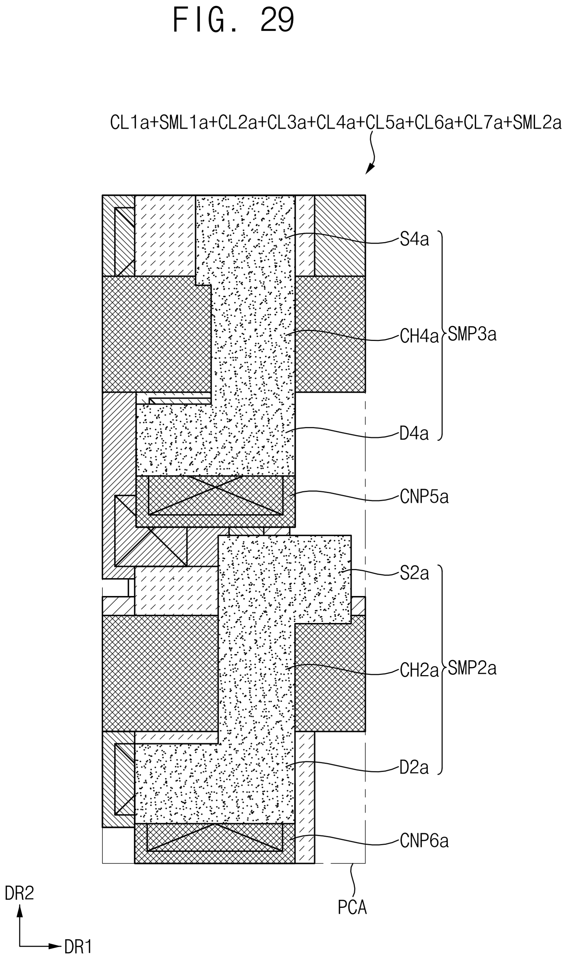

FIG. 28 illustrates the second semiconductor layer SML2a, and FIG. 29 illustrates the view of FIG. 27 with the second semiconductor layer SML2a further disposed.

In an embodiment, as illustrated in FIGS. 12, 28, and 29, the second semiconductor layer SML2a may be disposed on the eighth inorganic insulating layer IIL8a. That is, the second semiconductor layer SML2a may be disposed on the first semiconductor layer SML1a.

In an embodiment, the second semiconductor layer SML2a may include an oxide semiconductor. For example, the second semiconductor layer SML2a may include a metal oxide semiconductor. For example, the second semiconductor layer SML2a may include an oxide of at least one selected from indium (In), gallium (Ga), tin (Sn), zirconium (Zr), vanadium (V), hafnium (Hf), cadmium (Cd), germanium (Ge), chromium (Cr), titanium (Ti), and zinc (Zn).

The second semiconductor layer SML2a may include or define a second semiconductor pattern SMP2a and a third semiconductor pattern SMP3a. The second semiconductor pattern SMP2a and the third semiconductor pattern SMP3a may be spaced apart from each other in a plan view.

The second semiconductor pattern SMP2a may include a second source region S2a, a second channel region CH2a, and a second drain region D2a. The second channel region CH2a may be between the second source region S2a and the second drain region D2a. The third semiconductor pattern SMP3a may include a fourth source region S4a, a fourth channel region CH4a, and a fourth drain region D4a. The fourth channel region CH4a may be between the fourth source region S4a and the fourth drain region D4a. In an embodiment, the fourth channel region CH4a may be located in the second direction DR2 from the second channel region CH2a. In an embodiment, the fourth source region S4a, the fourth drain region D4a, the second source region S2a, and the second drain region D2a may be sequentially disposed along the direction opposite to the second direction DR2.

The second source region S2a may be the first electrode of the second transistor T2a, the second drain region D2a may be the second electrode of the second transistor T2a, and the second channel region CH2a may be a channel of the second transistor T2a. In an embodiment, as illustrated in FIGS. 27 and 29, in a plan view, the second channel region CH2a may overlap the auxiliary write gate line AGWLa, and the second drain region D2a may overlap the sixth connection pattern CNP6a.

The fourth source region S4a may be the first electrode of the fourth transistor T4a, the fourth drain region D4a may be the second electrode of the fourth transistor T4a, and the fourth channel region CH4a may be a channel of the fourth transistor T4a. In an embodiment, as illustrated in FIGS. 27 and 29, in a plan view, the fourth channel region CH4a may overlap the auxiliary initialization gate line AGILa, and the fourth drain region D4a may overlap the fifth connection pattern CNP5a.

The ninth inorganic insulating layer IIL9a may be disposed on the second semiconductor layer SML2a. The ninth inorganic insulating layer IIL9a may include an inorganic insulating material. The ninth inorganic insulating layer IIL9a may have a single-layer structure or a multi-layer structure including a plurality of insulating layers. The ninth inorganic insulating layer IIL9a may cover the second semiconductor pattern SMP2a and the third semiconductor pattern SMP3a.

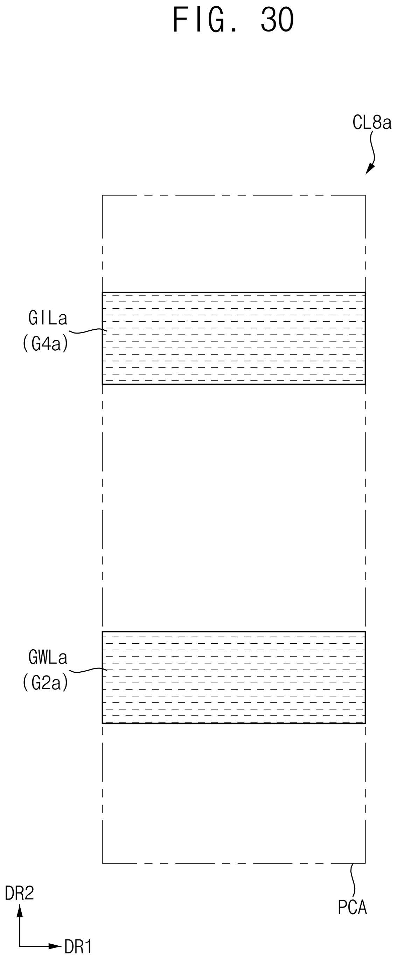

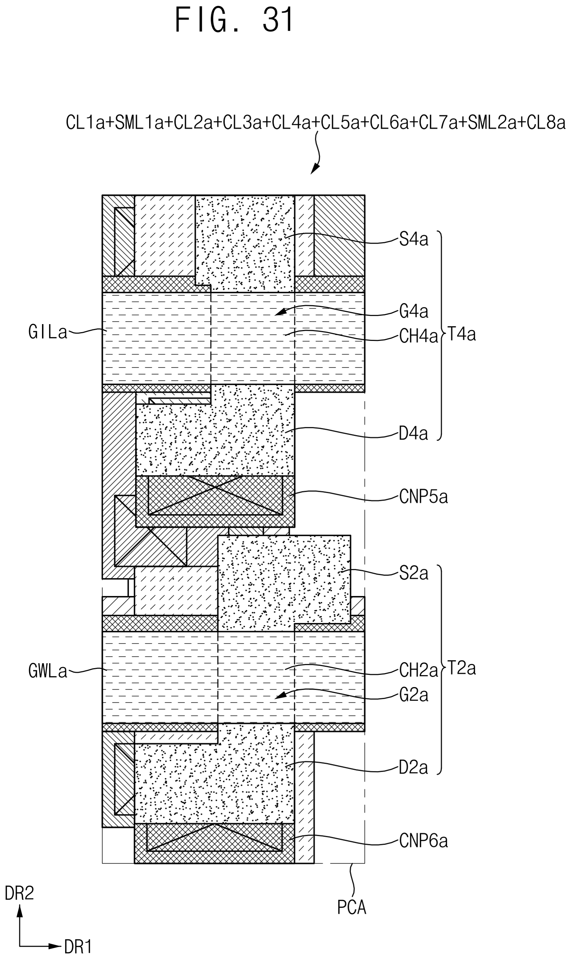

FIG. 30 illustrates the eighth conductive layer CL8a, and FIG. 31 illustrates the view of FIG. 29 with the eighth conductive layer CL8a further disposed.

In an embodiment, as illustrated in FIGS. 12, 30, and 31, the eighth conductive layer CL8a may be disposed on the ninth inorganic insulating layer IIL9a. The eighth conductive layer CL8a may be disposed on the second semiconductor layer SML2a. The eighth conductive layer CL8a may include a conductive material. The eighth conductive layer CL8a may have a single-layer structure or a multi-layer structure including a plurality of conductive layers. In an embodiment, the eighth conductive layer CL8a may be referred to as a sixth gate conductive layer.

The eighth conductive layer CL8a may include or define the write gate line GWLa and the initialization gate line GILa. The write gate line GWLa and the initialization gate line GILa may be spaced apart from each other in a plan view.

In an embodiment, the write gate line GWLa may extend in the first direction DR1. The write gate signal GW[N] of FIG. 5 may be applied to the write gate line GWLa.

A portion of the write gate line GWLa may overlap the second channel region CH2a of the second semiconductor pattern SMP2a in a plan view. The portion of the write gate line GWLa overlapping the second channel region CH2a may be the gate electrode G2a of the second transistor T2a.

In an embodiment, the initialization gate line GILa may extend in the first direction DR1. The initialization gate line GILa may be spaced apart from the write gate line GWLa in the second direction DR2 in a plan view. The initialization gate signal GI of FIG. 5 may be applied to the initialization gate line GILa.

A portion of the initialization gate line GILa may overlap the fourth channel region CH4a of the third semiconductor pattern SMP3a in a plan view. The portion of the initialization gate line GILa overlapping the fourth channel region CH4a may be the gate electrode G4a of the fourth transistor T4a.

The tenth inorganic insulating layer IIL10a may be disposed on the eighth conductive layer CL8a. The tenth inorganic insulating layer IIL10a may include an inorganic insulating material. The tenth inorganic insulating layer IIL10a may have a single-layer structure or a multi-layer structure including a plurality of insulating layers. The tenth inorganic insulating layer IIL10a may cover the write gate line GWLa and the initialization gate line GILa.

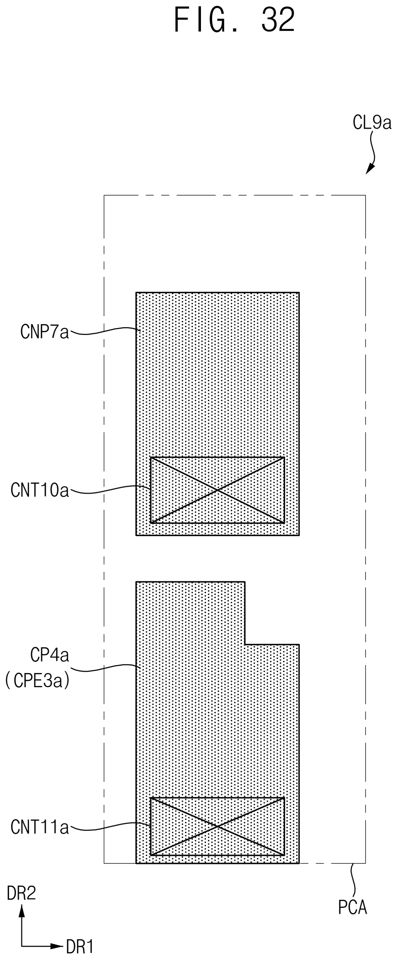

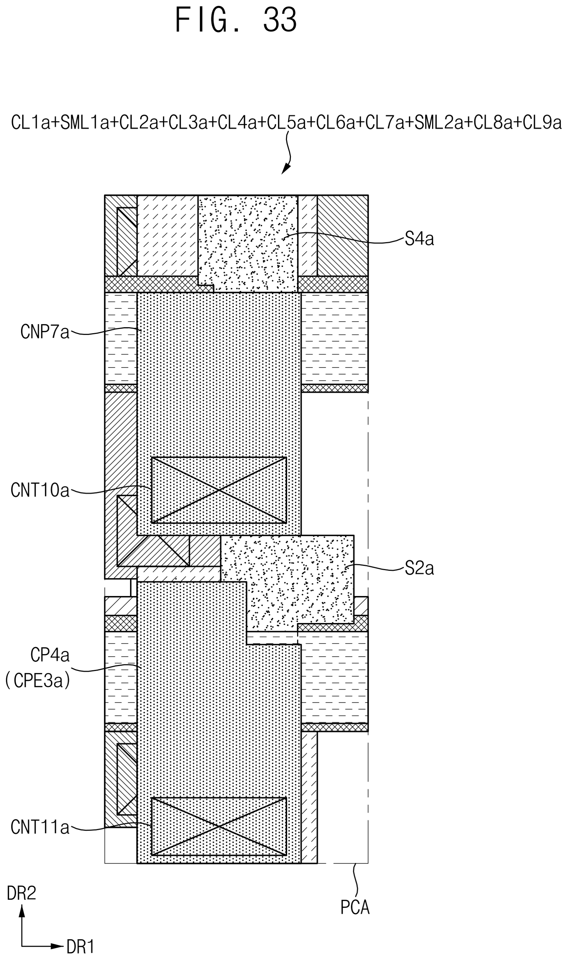

FIG. 32 illustrates the ninth conductive layer CL9a, and FIG. 33 illustrates the view of FIG. 31 with the ninth conductive layer CL9a further disposed.

In an embodiment, as illustrated in FIGS. 12, 32, and 33, the ninth conductive layer CL9a may be disposed on the tenth inorganic insulating layer IIL10a. The ninth conductive layer CL9a may be disposed on the eighth conductive layer CL8a. The ninth conductive layer CL9a may include a conductive material. The ninth conductive layer CL9a may have a single-layer structure or a multi-layer structure including a plurality of conductive layers. In an embodiment, the ninth conductive layer CL9a may be referred to as a first source conductive layer.

The ninth conductive layer CL9a may include or define a seventh connection pattern CNP7a and a fourth conductive pattern CP4a. The seventh connection pattern CNP7a and the fourth conductive pattern CP4a may be spaced apart from each other in a plan view.

As illustrated in FIG. 31 and FIG. 33, a portion of the seventh connection pattern CNP7a may overlap the fifth connection pattern CNP5a and the fourth drain region D4a of the third semiconductor pattern SMP3a in a plan view. The portion of the seventh connection pattern CNP7a may be connected to the fifth connection pattern CNP5a and the fourth drain region D4a of the third semiconductor pattern SMP3a through a tenth contact hole CNT10a defined or formed by penetrating an inorganic insulating layer (e.g., the eighth to tenth inorganic insulating layers IIL8a, IIL9a, and IIL10a) disposed therebelow. For example, the tenth contact hole CNT10a may expose a portion of the fifth connection pattern CNP5a and a portion of the fourth drain region D4a of the third semiconductor pattern SMP3a. That is, the tenth contact hole CNT10a may overlap each of the fifth connection pattern CNP5a and the fourth drain region D4a of the third semiconductor pattern SMP3a. The portion of the seventh connection pattern CNP7a may contact the portion of the fifth connection pattern CNP5a and the portion of the fourth drain region D4a of the third semiconductor pattern SMP3a exposed by the tenth contact hole CNT10a.

Accordingly, the fourth drain region D4a of the third semiconductor pattern SMP3a (i.e., the second electrode of the fourth transistor T4a) may be electrically connected to the first drain region D1a of the first semiconductor pattern SMP1a (i.e., the second electrode of the first transistor T1a) and the third source region S3a (i.e., the first electrode of the third transistor T3a) through the seventh connection pattern CNP7a, the fifth connection pattern CNP5a, the fourth connection pattern CNP4a, and the third connection pattern CNP3a.

In an embodiment, the fourth conductive pattern CP4a may be spaced apart from the seventh connection pattern CNP7a in the direction opposite to the second direction DR2 in a plan view.

In an embodiment, a portion of the fourth conductive pattern CP4a may overlap the sixth connection pattern CNP6a and the second drain region D2a of the second semiconductor pattern SMP2a in a plan view. The portion of the fourth conductive pattern CP4a may be connected to the sixth connection pattern CNP6a and the second drain region D2a of the second semiconductor pattern SMP2a through an eleventh contact hole CNT11a defined or formed by penetrating an inorganic insulating layer (e.g., the eighth to tenth inorganic insulating layers IIL8a, IIL9a, and IIL10a) disposed therebelow. For example, the eleventh contact hole CNT11a may expose a portion of the sixth connection pattern CNP6a and a portion of the second drain region D2a of the second semiconductor pattern SMP2a. That is, the eleventh contact hole CNT11a may overlap each of the sixth connection pattern CNP6a and the second drain region D2a of the second semiconductor pattern SMP2a. The portion of the fourth conductive pattern CP4a may contact the portion of the sixth connection pattern CNP6a and the portion of the second drain region D2a of the second semiconductor pattern SMP2a exposed by the eleventh contact hole CNT11a. That is, the fourth conductive pattern CP4a may be connected to the second drain region D2a of the second semiconductor pattern SMP2a (i.e., the second electrode of the second transistor T2a) and also connected to the third conductive pattern CP3a (i.e., the second electrode of the first capacitor C1a) through the sixth connection pattern CNP6a. As described below, the fourth conductive pattern CP4a may be the first electrode CPE3a of the second capacitor C2a.

The eleventh inorganic insulating layer IIL11a may be disposed on the ninth conductive layer CL9a. The eleventh inorganic insulating layer IIL11a may include an inorganic insulating material. The eleventh inorganic insulating layer IIL11a may have a single-layer structure or a multi-layer structure including a plurality of insulating layers. The eleventh inorganic insulating layer IIL11a may cover the seventh connection pattern CNP7a and the fourth conductive pattern CP4a.

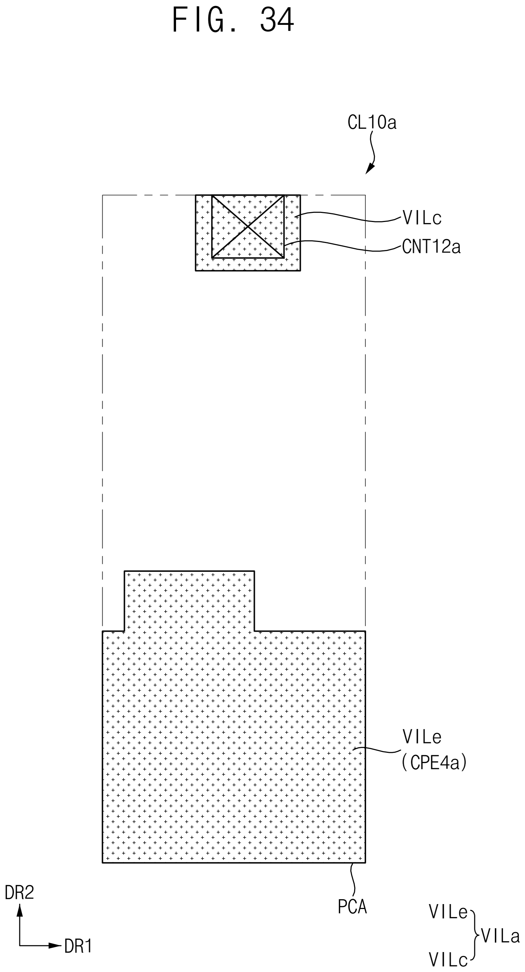

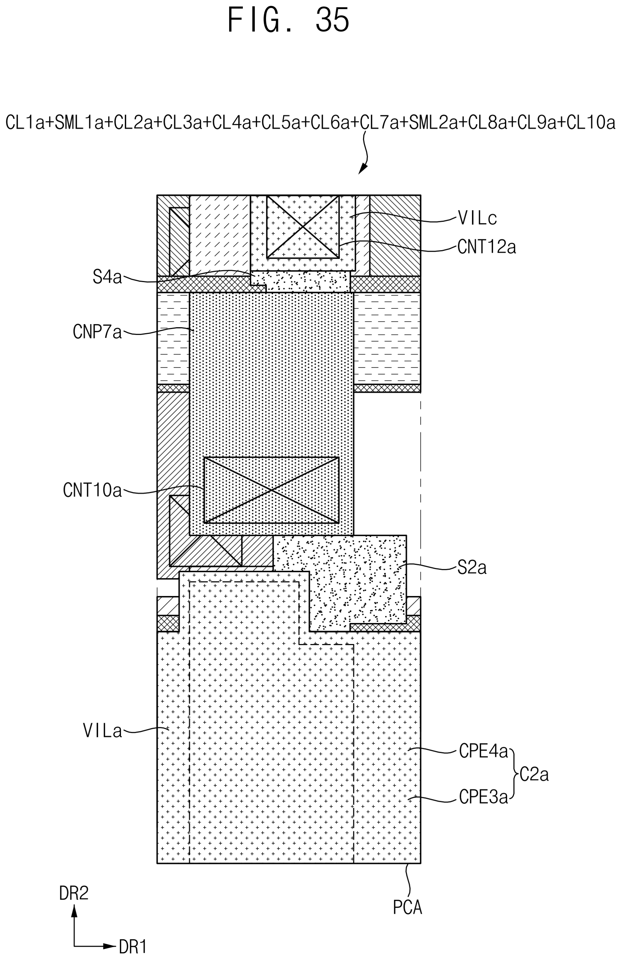

FIG. 34 illustrates the tenth conductive layer CL10a, and FIG. 35 illustrates the view of FIG. 33 with the tenth conductive layer CL10a further disposed.

In an embodiment, as illustrated in FIGS. 12, 34, and 35, the tenth conductive layer CL10a may be disposed on the eleventh inorganic insulating layer IIL11a. The tenth conductive layer CL10a may be disposed on the ninth conductive layer CL9a. The tenth conductive layer CL10a may include a conductive material. The tenth conductive layer CL10a may have a single-layer structure or a multi-layer structure including a plurality of conductive layers. In an embodiment, the tenth conductive layer CL10a may be referred to as a second contact conductive layer.

The tenth conductive layer CL10a may include or define the initialization line VILa. The initialization voltage VINT of FIG. 5 may be applied to the initialization line VILa.

In an embodiment, the initialization line VILa may include an extension portion VILe extending in the first direction DR1 and a contact portion VILc. The extension portion VILe and the contact portion VILc may be integrally connected (or integrally formed with each other as a single unitary indivisible part). The contact portion VILc may protrude from the extension portion VILe in the direction opposite to the second direction DR2. For example, the contact portion VILc illustrated in an upper side of FIG. 34 may be a portion included in an adjacent initialization line spaced apart in the second direction DR2 from the initialization line VILa including the extension portion VILe illustrated in an lower side of FIG. 34. In addition, although not illustrated in FIG. 34, a contact portion protruding from the extension portion VILe illustrated in the lower side of FIG. 34 in the direction opposite to the second direction DR2 may be provided.

In an embodiment, as illustrated in FIGS. 33 and 35, a portion of the initialization line VILa (e.g., a portion of the extension portion VILe) may overlap the fourth conductive pattern CP4a in a plan view. The fourth conductive pattern CP4a and the portion of the initialization line VILa, which are spaced apart from each other with the eleventh inorganic insulating layer IIL11a therebetween, may form the second capacitor C2a. The fourth conductive pattern CP4a may be the first electrode CPE3a of the second capacitor C2a, and the portion of the initialization line VILa overlapping the fourth conductive pattern CP4a may be the second electrode CPE4a of the second capacitor C2a.

In an embodiment, as illustrated in FIGS. 25 and 35, the second capacitor C2a may at least partially overlap the first capacitor C1a in a plan view. That is, the second conductive pattern CP2a, the third conductive pattern CP3a, the fourth conductive pattern CP4a, and the initialization line VILa may at least partially overlap each other in a plan view.

In an embodiment, the first capacitor C1a may at least partially overlap each of the channel of the second transistor T2a and the channel of the third transistor T3a in a plan view. In an embodiment, the second capacitor C2a may at least partially overlap each of the channel of the second transistor T2a and the channel of the third transistor T3a in a plan view.

As illustrated in FIG. 17 and FIG. 25, the first capacitor C1a may at least partially overlap the channel of the third transistor T3a in a plan view. That is, each of the second conductive pattern CP2a (i.e., the first electrode CPE1a of the first capacitor C1a) and the third conductive pattern CP3a (i.e., the second electrode CPE2a of the first capacitor C1a) may at least partially overlap the third channel region CH3a of the first semiconductor pattern SMP1a in a plan view.

As illustrated in FIG. 25 and FIG. 29, the first capacitor C1a may at least partially overlap the channel of the second transistor T2a in a plan view. That is, each of the second conductive pattern CP2a (i.e., the first electrode CPE1a of the first capacitor C1a) and the third conductive pattern CP3a (i.e., the second electrode CPE2a of the first capacitor C1a) may at least partially overlap the second channel region CH2a of the second semiconductor pattern SMP2a in a plan view.

Similarly, as illustrated in FIG. 17 and FIG. 35, the second capacitor C2a may at least partially overlap the channel of the third transistor T3a in a plan view. That is, each of the fourth conductive pattern CP4a (i.e., the first electrode CPE3a of the second capacitor C2a) and the initialization line VILa (i.e., the second electrode CPE4a of the second capacitor C2a) may at least partially overlap the third channel region CH3a of the first semiconductor pattern SMP1a in a plan view.

As illustrated in FIG. 29 and FIG. 35, the second capacitor C2a may at least partially overlap the channel of the second transistor T2a in a plan view. That is, each of the fourth conductive pattern CP4a (i.e., the first electrode CPE3a of the second capacitor C2a) and the initialization line VILa (i.e., the second electrode CPE4a of the second capacitor C2a) may at least partially overlap the second channel region CH2a of the second semiconductor pattern SMP2a in a plan view.

In an embodiment, a portion (e.g., the contact portion VILc) of the adjacent initialization line may overlap the fourth source region S4a of the third semiconductor pattern SMP3a in a plan view. The portion (e.g., the contact portion VILc) of the adjacent initialization line may be connected to the fourth source region S4a of the third semiconductor pattern SMP3a through a twelfth contact hole CNT12a defined or formed by penetrating an inorganic insulating layer (e.g., the ninth to eleventh inorganic insulating layers IIL9a, IIL10a, and IIL11a) disposed therebelow. For example, the twelfth contact hole CNT12a may expose a portion of the fourth source region S4a of the third semiconductor pattern SMP3a. The portion (e.g., the contact portion VILc) of the adjacent initialization line may contact the portion of the fourth source region S4a of the third semiconductor pattern SMP3a exposed by the twelfth contact hole CNT12a. Accordingly, the initialization voltage VINT of FIG. 5 may be applied to the fourth source region S4a of the third semiconductor pattern SMP3a (i.e., the first electrode of the fourth transistor T4a) through the adjacent initialization line.

The twelfth inorganic insulating layer IIL12a may be disposed on the tenth conductive layer CL10a. The twelfth inorganic insulating layer IIL12a may include an inorganic insulating material. The twelfth inorganic insulating layer IIL12a may have a single-layer structure or a multi-layer structure including a plurality of insulating layers. The twelfth inorganic insulating layer IIL12a may cover the initialization line VILa.

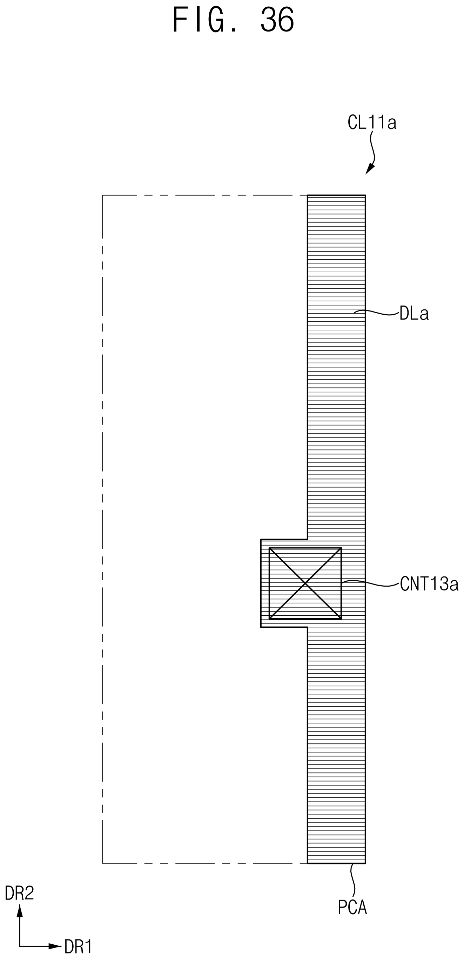

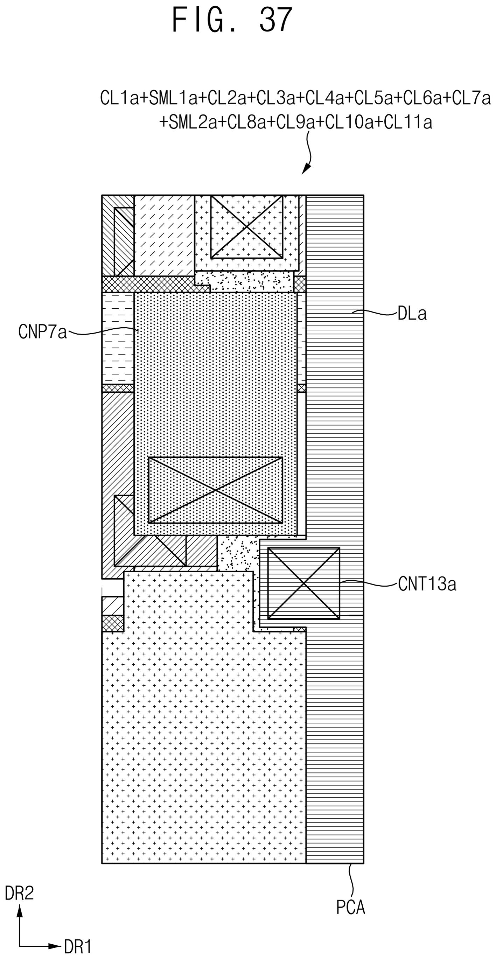

FIG. 36 illustrates the eleventh conductive layer CL11a, and FIG. 37 illustrates the view of FIG. 35 with the eleventh conductive layer CL11a further disposed.

In an embodiment, as illustrated in FIGS. 12, 36, and 37, the eleventh conductive layer CL11a may be disposed on the twelfth inorganic insulating layer IIL12a. The eleventh conductive layer CL11a may be disposed on the tenth conductive layer CL10a. The eleventh conductive layer CL11a may include a conductive material. The eleventh conductive layer CL11a may have a single-layer structure or a multi-layer structure including a plurality of conductive layers. In an embodiment, the eleventh conductive layer CL11a may be referred to as a second source conductive layer.

The eleventh conductive layer CL11a may include or define the data line DLa. The data voltage VDAT of FIG. 5 may be applied to the data line DLa.

In an embodiment, the data line DLa may extend in the second direction DR2. In an embodiment, as illustrated in FIGS. 35 and 37, a portion of the data line DLa may overlap the second source region S2a of the second semiconductor pattern SMP2a in a plan view. The portion of the data line DLa may be connected to the second source region S2a of the second semiconductor pattern SMP2a through a thirteenth contact hole CNT13a defined or formed by penetrating an inorganic insulating layer (e.g., the ninth to twelfth inorganic insulating layers IIL9a, IIL10a, IIL11a, and IIL12a) disposed therebelow. For example, the thirteenth contact hole CNT13a may expose a portion of the second source region S2a of the second semiconductor pattern SMP2a. The portion of the data line DLa may contact the portion of the second source region S2a of the second semiconductor pattern SMP2a exposed by the thirteenth contact hole CNT13a. Accordingly, the data voltage VDAT of FIG. 5 may be applied to the second source region S2a of the second semiconductor pattern SMP2a (i.e., the first electrode of the second transistor T2a) through the data line DLa.

The thirteenth inorganic insulating layer IIL13a may be disposed on the eleventh conductive layer CL11a. The thirteenth inorganic insulating layer IIL13a may include an inorganic insulating material. The thirteenth inorganic insulating layer IIL13a may have a single-layer structure or a multi-layer structure including a plurality of insulating layers. The thirteenth inorganic insulating layer IIL13a may cover the data line DLa.

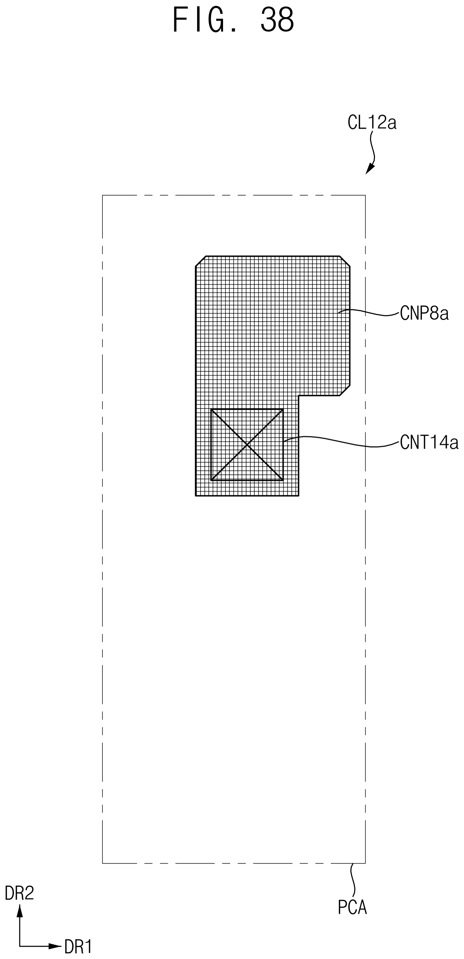

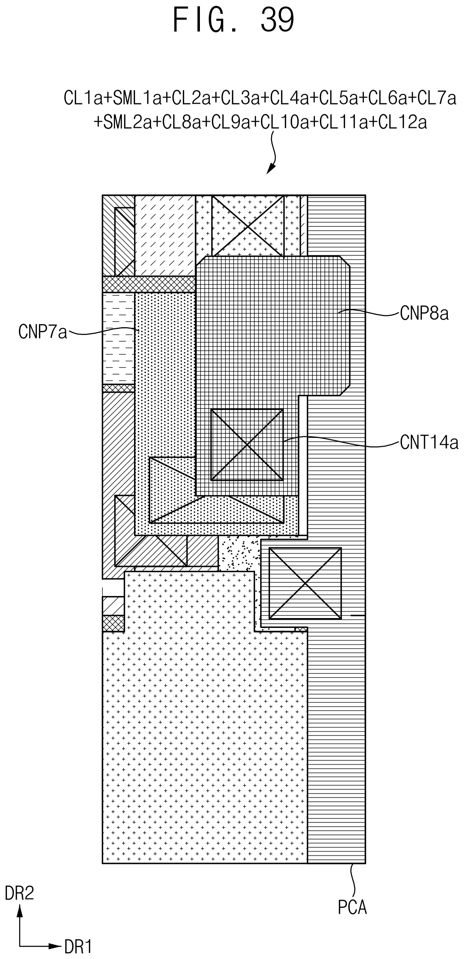

FIG. 38 illustrates the twelfth conductive layer CL12a, and FIG. 39 illustrates the view of FIG. 37 with the twelfth conductive layer CL12a further disposed.

In an embodiment, as illustrated in FIGS. 12, 38, and 39, the twelfth conductive layer CL12a may be disposed on the thirteenth inorganic insulating layer IIL13a. The twelfth conductive layer CL12a may be disposed on the eleventh conductive layer CL11a. The twelfth conductive layer CL12a may include a conductive material. The twelfth conductive layer CL12a may have a single-layer structure or a multi-layer structure including a plurality of conductive layers. In an embodiment, the twelfth conductive layer CL12a may be referred to as a third source conductive layer.

The twelfth conductive layer CL12a may include or define an eighth connection pattern CNP8a. In an embodiment, as illustrated in FIGS. 37 and 39, the eighth connection pattern CNP8a may overlap the seventh connection pattern CNP7a in a plan view. The eighth connection pattern CNP8a may be connected to the seventh connection pattern CNP7a through a fourteenth contact hole CNT14a defined or formed by penetrating an inorganic insulating layer (e.g., the eleventh to thirteenth inorganic insulating layers IIL11a, IIL12a, and IIL13a) disposed therebelow. For example, the fourteenth contact hole CNT14a may expose a portion of the seventh connection pattern CNP7a. A portion of the eighth connection pattern CNP8a may contact the portion of the seventh connection pattern CNP7a exposed by the fourteenth contact hole CNT14a.

The first organic insulating layer OIL1a may be disposed on the twelfth conductive layer CL12a. The first organic insulating layer OIL1a may include an organic insulating material. The first organic insulating layer OIL1a may have a single-layer structure or a multi-layer structure including a plurality of insulating layers. The first organic insulating layer OIL1a may cover the eighth connection pattern CNP8a.

The thirteenth conductive layer may be disposed on the first organic insulating layer OIL1a. The thirteenth conductive layer may be disposed on the twelfth conductive layer CL12a. The thirteenth conductive layer may include a conductive material. The thirteenth conductive layer may have a single-layer structure or a multi-layer structure including a plurality of conductive layers. In an embodiment, the thirteenth conductive layer may be referred to as a fourth source conductive layer.

The thirteenth conductive layer may include or define a ninth connection pattern CNP9a. The ninth connection pattern CNP9a may overlap the eighth connection pattern CNP8a in a plan view. The ninth connection pattern CNP9a may be connected to the eighth connection pattern CNP8a through a first via hole VH1a defined or formed by penetrating an organic insulating layer (e.g., the first organic insulating layer OIL1a) disposed therebelow. For example, the first via hole VH1a may expose a portion of the eighth connection pattern CNP8a. A portion of the ninth connection pattern CNP9a may contact the portion of the eighth connection pattern CNP8a exposed by the first via hole VH1a.

The second organic insulating layer OIL2a may be disposed on the thirteenth conductive layer. The second organic insulating layer OIL2a may include an organic insulating material. The second organic insulating layer OIL2a may have a single-layer structure or a multi-layer structure including a plurality of insulating layers. The second organic insulating layer OIL2a may cover the ninth connection pattern CNP9a.

The light emitting element layer LEL may be disposed on the second organic insulating layer OIL2a.

The first electrode ED1 of the light emitting element LE may be disposed on the second organic insulating layer OIL2a. The first electrode ED1 may include a conductive material. For example, the first electrode ED1 may be the anode electrode of the light emitting element LE.

The first electrode ED1 may be connected to the ninth connection pattern CNP9a through a second via hole VH2a defined or formed by penetrating an organic insulating layer (e.g., the second organic insulating layer OIL2a) disposed therebelow. Accordingly, the first electrode ED1 may be electrically connected to the fourth drain region D4a of the third semiconductor pattern SMP3a (i.e., the second electrode of the fourth transistor T4a) through the ninth connection pattern CNP9a, the eighth connection pattern CNP8a, and the seventh connection pattern CNP7a. In addition, the first electrode ED1 may be electrically connected to the first drain region D1a (i.e., the second electrode of the first transistor T1a) and the third source region S3a (i.e., the first electrode of the third transistor T3a) of the first semiconductor pattern SMP1a through the ninth connection pattern CNP9a, the eighth connection pattern CNP8a, the seventh connection pattern CNP7a, the fifth connection pattern CNP5a, the fourth connection pattern CNP4a, and the third connection pattern CNP3a.

The pixel defining layer PDL may be disposed on the second organic insulating layer OIL2a and the first electrode ED1. The pixel defining layer PDL may cover a peripheral portion of the first electrode ED1 and may define a pixel opening that exposes a central portion of the first electrode ED1. The pixel defining layer PDL may include an inorganic insulating material and/or an organic insulating material.

The middle layer ML may be disposed on the first electrode ED1. The middle layer ML may include the emission layer. In an embodiment, the middle layer ML may further include various functional layers (e.g., a hole injection layer, a hole transport layer, an electron transport layer, an electron injection layer, or the like) disposed on and/or under the emission layer.

The second electrode ED2 of the light emitting element LE may be disposed on the middle layer ML. The second electrode ED2 may also be disposed on the pixel defining layer PDL. The second electrode ED2 may include a conductive material. For example, the second electrode ED2 may be the cathode electrode of the light emitting element LE. The first electrode ED1, the middle layer ML, and the second electrode ED2 may form or collectively define the light emitting element LE.

Embodiments 1 to 3 (E1 to E3), Embodiments 10 to 12 (E10 to E12), Embodiments 19 to 21 (E19 to E21), and Embodiments 28 to 30 (E28 to E30) of FIG. 11 may be embodiments of the display panel DPa having the structure described with reference to FIGS. 12 to 39. Here, in each of Embodiments 1 to 3 (E1 to E3), Embodiments 10 to 12 (E10 to E12), Embodiments 19 to 21 (E19 to E21), and Embodiments 28 to 30 (E28 to E30), the CNT area of FIG. 11 is a value calculated by summing areas of the first to fourteenth contact holes CNT1a to CNT14a of FIGS. 12 to 39 in a plan view. Specifically, in Embodiment 10 (E10), an area of a bottom surface of each of the first to seventh contact holes CNT1a to CNT7a and the twelfth to fourteenth contact holes CNT12a to CNT14a is 2.89 µm², an area of a bottom surface of each of the eighth contact hole CNT8a and the tenth contact hole CNT10a is 5.44 µm², and an area of a bottom surface of each of the ninth contact hole CNT9a and the eleventh contact hole CNT11a is 6.38 µm².

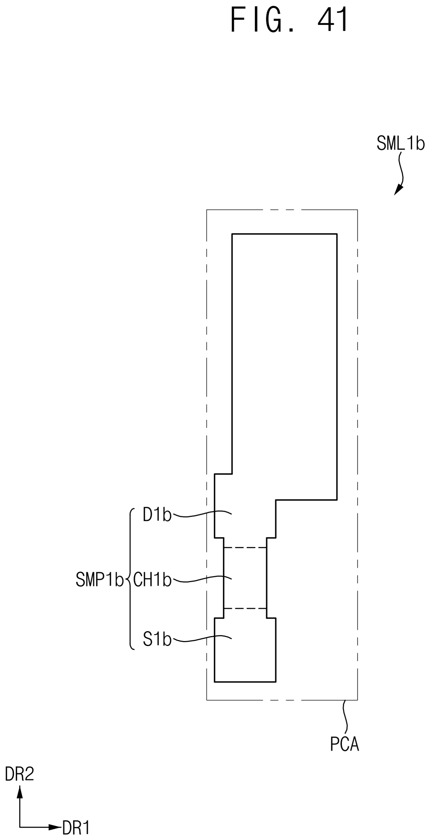

FIG. 40 is a cross-sectional view illustrating a display panel DPb according to an embodiment. FIGS. 41 to 65 are layout views illustrating the display panel DPb of FIG. 40.

FIG. 40 is a cross-sectional view schematically illustrating one pixel PXb described with reference to FIG. 7. FIGS. 41 to 65 are layout views illustrating one pixel circuit PCb of FIG. 40. FIGS. 41 to 65 selectively illustrate some of the layers among the plurality of layers included in the display panel DPb. Each of FIGS. 41 to 65 may correspond to one pixel circuit region PCA.

Hereinafter, an example of an arrangement structure of the transistors, the capacitors, and the lines included in the pixel circuit PCb of FIG. 7 will be described in greater detail with reference to FIGS. 41 to 65. The arrangement structure of one pixel circuit PCb described with reference to FIGS. 41 to 65 may be repeatedly provided in the display panel DPb.

Referring to FIGS. 40 to 65, the display panel DPb may include the substrate SUBb, the circuit element layer PCLb, and the light emitting element layer LEL. The pixel circuit PCb of FIG. 7 may be disposed in the circuit element layer PCLb, and the light emitting element LE of FIG. 7 and the pixel defining layer PDL may be disposed in the light emitting element layer LEL. The circuit element layer PCLb and the light emitting element layer LEL may be sequentially disposed on the substrate SUBb along the third direction DR3. The third direction DR3 may cross the first direction DR1 and the second direction DR2. Hereinafter, the third direction DR3 may be referred to as an upper direction.

In an embodiment, the circuit element layer PCLb may include a first semiconductor layer SML1b, a first inorganic insulating layer IIL1b, a first conductive layer CL1b, a second inorganic insulating layer IIL2b, a second conductive layer CL2b, a third inorganic insulating layer IIL3b, a third conductive layer CL3b, a fourth inorganic insulating layer IIL4b, a fourth conductive layer CL4b, a fifth inorganic insulating layer IIL5b, a second semiconductor layer SML2b, a sixth inorganic insulating layer IIL6b, a fifth conductive layer CL5b, a seventh inorganic insulating layer IIL7b, a sixth conductive layer CL6b, an eighth inorganic insulating layer IIL8b, a third semiconductor layer SML3b, a ninth inorganic insulating layer IIL9b, a seventh conductive layer CL7b, a tenth inorganic insulating layer IIL10b, an eighth conductive layer CL8b, an eleventh inorganic insulating layer IIL11b, a ninth conductive layer CL9b, a twelfth inorganic insulating layer IIL12b, a tenth conductive layer CL10b, a first organic insulating layer OIL1b, an eleventh conductive layer, and a second organic insulating layer OIL2b sequentially disposed or stacked along the third direction DR3.

FIG. 41 illustrates the first semiconductor layer SML1b.

In an embodiment, as illustrated in FIGS. 40 and 41, the first semiconductor layer SML1b may be disposed on the substrate SUBb.

In an embodiment, the first semiconductor layer SML1b may include a silicon semiconductor. For example, the first semiconductor layer SML1b may include polycrystalline silicon, amorphous silicon, or the like. For example, the first semiconductor layer SML1b may include low-temperature polysilicon.

The first semiconductor layer SML1b may include or define a first semiconductor pattern SMP1b. The first semiconductor pattern SMP1b may include a first source region S1b, a first drain region D1b, and a first channel region CH1b defined between the first source region S1b and the first drain region D1b. In an embodiment, the first source region S1b, the first channel region CH1b, and the first drain region D1b may be sequentially disposed along the second direction DR2.

Electrical properties of the first semiconductor pattern SMP1b may vary depending on whether a region thereof is doped or not. In an embodiment, the first source region S1b and the first drain region D1b may be doped with a P-type dopant, but the inventive concept is not limited thereto.

The first source region S1b may be the first electrode of the second transistor T2b, the first drain region D1b may be the second electrode of the second transistor T2b, and the first channel region CH1b may be a channel of the second transistor T2b.

The first inorganic insulating layer IIL1b may be disposed on the first semiconductor layer SML1b. The first inorganic insulating layer IIL1b may include an inorganic insulating material. The first inorganic insulating layer IIL1b may have a single-layer structure or a multi-layer structure including a plurality of insulating layers. The first inorganic insulating layer IIL1b may cover the first semiconductor pattern SMP1b.

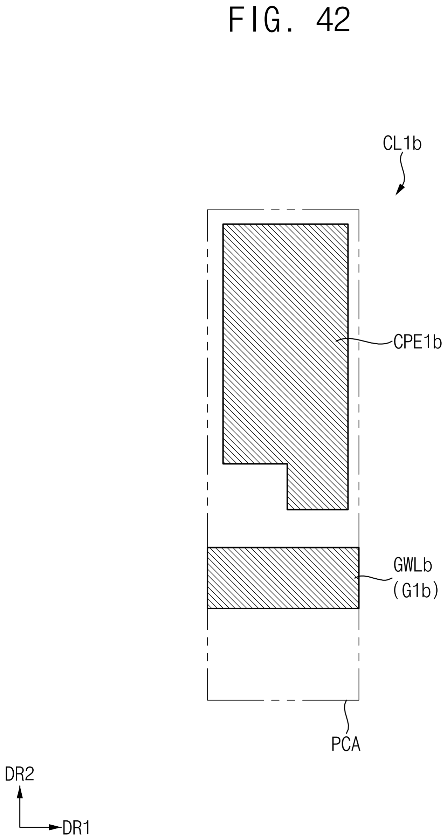

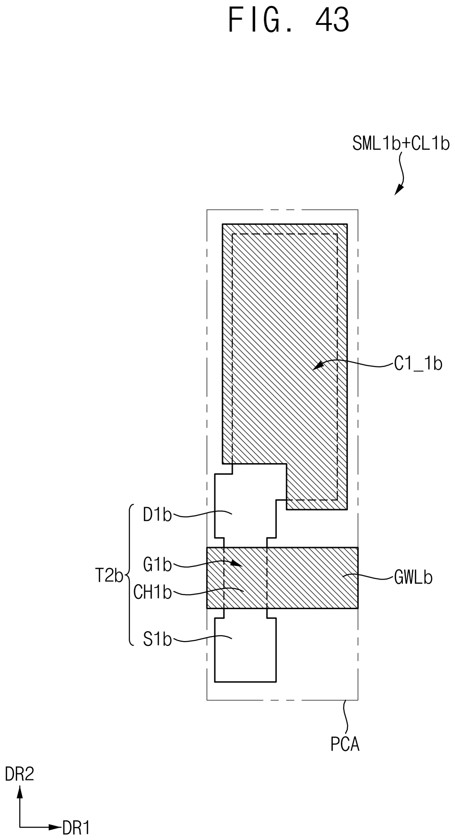

FIG. 42 illustrates the first conductive layer CL1b, and FIG. 43 illustrates the view of FIG. 41 with the first conductive layer CL1b further disposed.

In an embodiment, as illustrated in FIGS. 40, 42, and 43, the first conductive layer CL1b may be disposed on the first inorganic insulating layer IIL1b. The first conductive layer CL1b may include a conductive material. The first conductive layer CL1b may have a single-layer structure or a multi-layer structure including a plurality of conductive layers.

The first conductive layer CL1b may include or define the write gate line GWLb and a first capacitor pattern CPE1b. The write gate line GWLb and the first capacitor pattern CPE1b may be spaced apart from each other in a plan view.

In an embodiment, the write gate line GWLb can extend in the first direction DR1. The write gate line GWLb may be spaced apart from the first capacitor pattern CPE1b in the direction opposite to the second direction DR2 in a plan view. The write gate signal GW[N] of FIG. 7 may be applied to the write gate line GWLb.

A portion of the write gate line GWLb may overlap the first channel region CH1b of the first semiconductor pattern SMP1b in a plan view. The portion of the write gate line GWLb overlapping the first channel region CH1b may be the gate electrode G1b of the second transistor T2b.

The first capacitor pattern CPE1b may at least partially overlap the first semiconductor pattern SMP1b in a plan view. A portion of the first capacitor pattern CPE1b may overlap a portion of the first drain region D1b of the first semiconductor pattern SMP1b. In an embodiment, the portion of the first drain region D1b of the first semiconductor pattern SMP1b and the portion of the first capacitor pattern CPE1b, which are spaced apart from each other with the first inorganic insulating layer IIL1b therebetween, may form a first sub-capacitor C1_1b. The portion of the first drain region D1b of the first semiconductor pattern SMP1b may be a first electrode of the first sub-capacitor C1_1b, and the portion of the first capacitor pattern CPE1b may be a second electrode of the first sub-capacitor C1_1b. In an embodiment, the first sub-capacitor C1_1b may be a portion of the first capacitor C1b.

The second inorganic insulating layer IIL2b may be disposed on the first conductive layer CL1b. The second inorganic insulating layer IIL2b may include an inorganic insulating material. The second inorganic insulating layer IIL2b may have a single-layer structure or a multi-layer structure including a plurality of insulating layers. The second inorganic insulating layer IIL2b may cover the write gate line GWLb and the first capacitor pattern CPE1b.

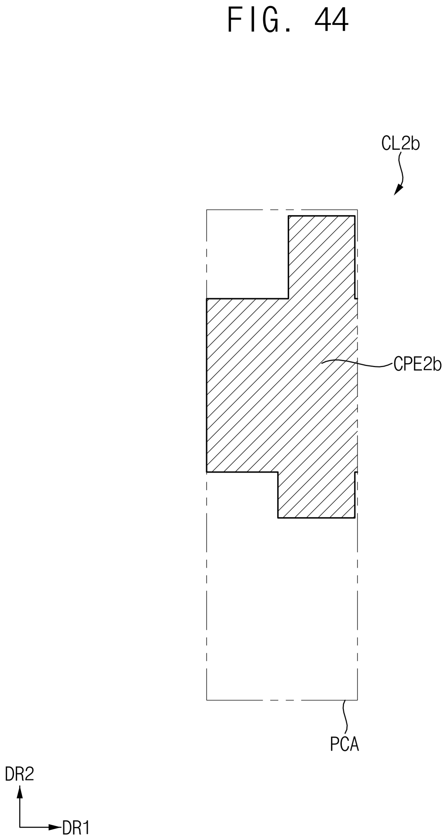

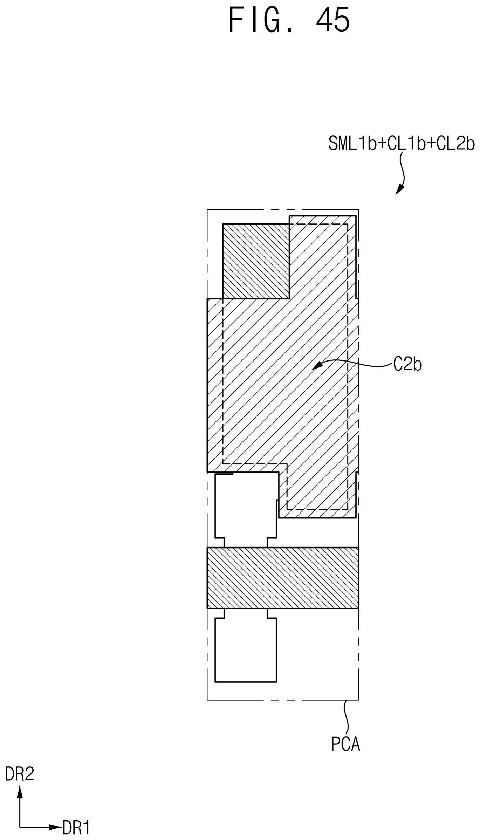

FIG. 44 illustrates the second conductive layer CL2b, and FIG. 45 illustrates the view of FIG. 43 with the second conductive layer CL2b further disposed.

In an embodiment, as illustrated in FIGS. 40, 44, and 45, the second conductive layer CL2b may be disposed on the second inorganic insulating layer IIL2b. The second conductive layer CL2b may include a conductive material. The second conductive layer CL2b may have a single-layer structure or a multi-layer structure including a plurality of conductive layers.

The second conductive layer CL2b may include or define a second capacitor pattern CPE2b. In an embodiment, the second capacitor pattern CPE2b may extend in the first direction DR1. The second capacitor pattern CPE2b may at least partially overlap the first capacitor pattern CPE1b in a plan view. A portion of the second capacitor pattern CPE2b may overlap a portion of the first capacitor pattern CPE1b. In an embodiment, the portion of the first capacitor pattern CPE1b and the portion of the second capacitor pattern CPE2b, which are spaced apart from each other with the second inorganic insulating layer IIL2b therebetween, may form the second capacitor C2b. The portion of the second capacitor pattern CPE2b may be the first electrode of the second capacitor C2b, and the portion of the first capacitor pattern CPE1b may be the second electrode of the second capacitor C2b. The reference voltage VREF of FIG. 7 may be applied to the second capacitor pattern CPE2b. For example, the second capacitor pattern CPE2b may correspond to the reference voltage line VRLb of FIG. 7.

In an embodiment, the second capacitor pattern CPE2b may at least partially overlap the first drain region D1b of the first semiconductor pattern SMP1b in a plan view. The first drain region D1b of the first semiconductor pattern SMP1b, the first capacitor pattern CPE1b, and the second capacitor pattern CPE2b may be disposed along the third direction DR3.

In an embodiment, the second capacitor C2b may at least partially overlap the first sub-capacitor C1_1b in a plan view. The first sub-capacitor C1_1b and the second capacitor C2b may be disposed along the third direction DR3.

The third inorganic insulating layer IIL3b may be disposed on the second conductive layer CL2b. The third inorganic insulating layer IIL3b may include an inorganic insulating material. The third inorganic insulating layer IIL3b may have a single-layer structure or a multi-layer structure including a plurality of insulating layers. The third inorganic insulating layer IIL3b may cover the second capacitor pattern CPE2b.

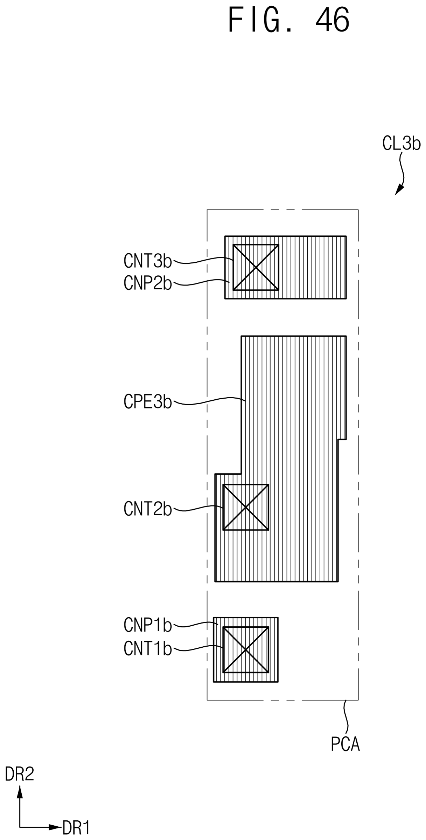

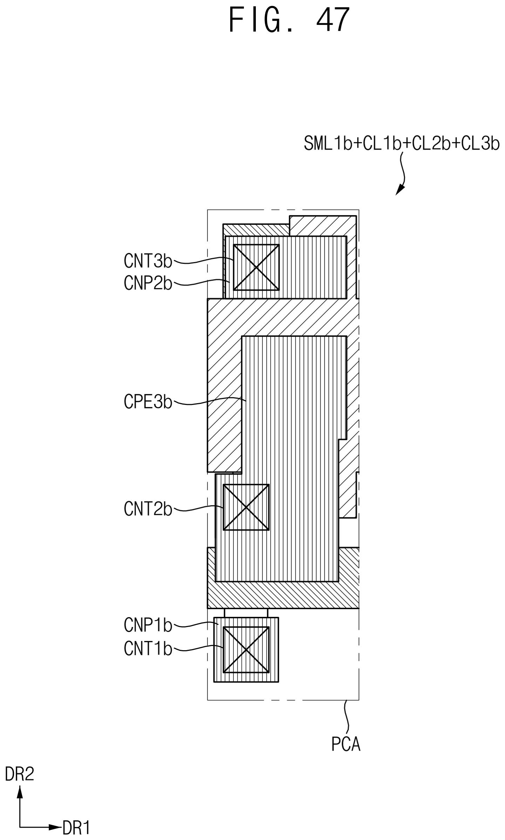

FIG. 46 illustrates the third conductive layer CL3b, and FIG. 47 illustrates the view of FIG. 45 with the third conductive layer CL3b further disposed.

In an embodiment, as illustrated in FIGS. 40, 46, and 47, the third conductive layer CL3b may be disposed on the third inorganic insulating layer IIL3b. The third conductive layer CL3b may include a conductive material. The third conductive layer CL3b may have a single-layer structure or a multi-layer structure including a plurality of conductive layers.

The third conductive layer CL3b may include or define a first connection pattern CNP1b, a second connection pattern CNP2b, and a third capacitor pattern CPE3b. The first connection pattern CNP1b, the second connection pattern CNP2b, and the third capacitor pattern CPE3b may be spaced apart from each other in a plan view. For example, the third capacitor pattern CPE3b may be spaced apart from the first connection pattern CNP1b in the second direction DR2, and the second connection pattern CNP2b may be spaced apart from the third capacitor pattern CPE3b in the second direction DR2. The first connection pattern CNP1b, the third capacitor pattern CPE3b, and the second connection pattern CNP2b may be sequentially disposed along the second direction DR2.

As illustrated in FIGS. 41, 45, and 47, the first connection pattern CNP1b may at least partially overlap the first source region S1b of the first semiconductor pattern SMP1b in a plan view. The first connection pattern CNP1b may be connected to the first source region S1b of the first semiconductor pattern SMP1b (i.e., the first electrode of the second transistor T2b) through a first contact hole CNT1b defined or formed by penetrating (or defined or formed through) an inorganic insulating layer (e.g., the first to third inorganic insulating layers IIL1b, IIL2b, and IIL3b) disposed therebelow. For example, the first contact hole CNT1b may expose a portion of the first source region S1b of the first semiconductor pattern SMP1b, and a portion of the first connection pattern CNP1b may contact the portion of the first source region S1b of the first semiconductor pattern SMP1b exposed by the first contact hole CNT1b.

As illustrated in FIGS. 41, 45, and 47, the third capacitor pattern CPE3b may at least partially overlap the first drain region D1b of the first semiconductor pattern SMP1b in a plan view. The third capacitor pattern CPE3b may be connected to the first drain region D1b of the first semiconductor pattern SMP1b (i.e., the second electrode of the second transistor T2b) through a second contact hole CNT2b defined or formed by penetrating (or defined or formed through) an inorganic insulating layer (e.g., the first to third inorganic insulating layers IIL1b, IIL2b, and IIL3b) disposed therebelow. For example, the second contact hole CNT2b may expose a portion of the first drain region D1b of the first semiconductor pattern SMP1b, and a portion of the third capacitor pattern CPE3b may contact the portion of the first drain region D1b of the first semiconductor pattern SMP1b exposed by the second contact hole CNT2b.

In addition, the third capacitor pattern CPE3b may at least partially overlap each of the first and second capacitor patterns CPE1b and CPE2b in a plan view. The first drain region D1b of the first semiconductor pattern SMP1b, the first capacitor pattern CPE1b, the second capacitor pattern CPE2b, and the third capacitor pattern CPE3b may be disposed along the third direction DR3.

As illustrated in FIGS. 43, 45, and 47, the second connection pattern CNP2b can at least partially overlap the first capacitor pattern CPE1b in a plan view. The second connection pattern CNP2b may be connected to the first capacitor pattern CPE1b through a third contact hole CNT3b defined or formed by penetrating (or defined or formed through) an inorganic insulating layer (e.g., the second and third inorganic insulating layers IIL2b and IIL3b) disposed therebelow. For example, the third contact hole CNT3b may expose a portion of the first capacitor pattern CPE1b, and a portion of the second connection pattern CNP2b may contact the portion of the first capacitor pattern CPE1b exposed by the third contact hole CNT3b.

The fourth inorganic insulating layer IIL4b may be disposed on the third conductive layer CL3b. The fourth inorganic insulating layer IIL4b may include an inorganic insulating material. The fourth inorganic insulating layer IIL4b may have a single-layer structure or a multi-layer structure including a plurality of insulating layers. The fourth inorganic insulating layer IIL4b may cover the first connection pattern CNP1b, the second connection pattern CNP2b, and the third capacitor pattern CPE3b.

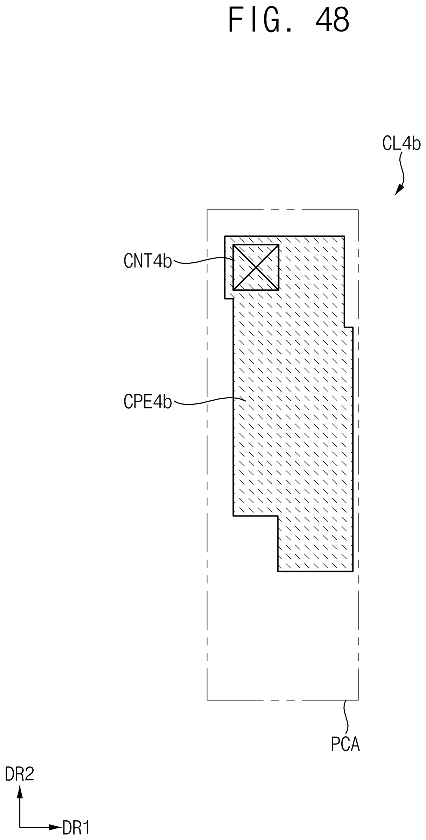

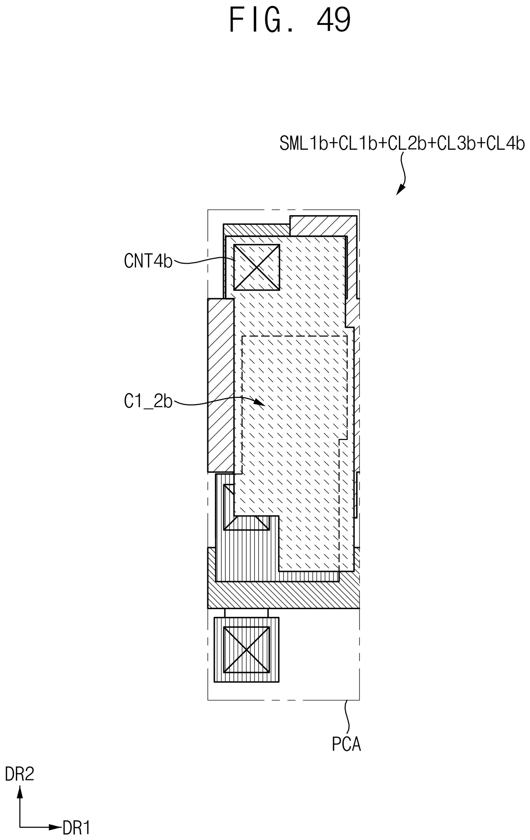

FIG. 48 illustrates the fourth conductive layer CL4b, and FIG. 49 illustrates the view of FIG. 47 with the fourth conductive layer CL4b further disposed.

In an embodiment, as illustrated in FIGS. 40, 48, and 49, the fourth conductive layer CL4b may be disposed on the fourth inorganic insulating layer IIL4b. The fourth conductive layer CL4b may include a conductive material. The fourth conductive layer CL4b may have a single-layer structure or a multi-layer structure including a plurality of conductive layers.

The fourth conductive layer CL4b may include or define a fourth capacitor pattern CPE4b.

As illustrated in FIGS. 47 and 49, the fourth capacitor pattern CPE4b may at least partially overlap the second connection pattern CNP2b in a plan view. The fourth capacitor pattern CPE4b may be connected to the second connection pattern CNP2b through a fourth contact hole CNT4b defined or formed by penetrating (or defined or formed through) an inorganic insulating layer (e.g., the fourth inorganic insulating layer IIL4b) disposed therebelow. For example, the fourth contact hole CNT4b may expose a portion of the second connection pattern CNP2b, and a portion of the fourth capacitor pattern CPE4b may contact the portion of the second connection pattern CNP2b exposed by the fourth contact hole CNT4b.

Accordingly, the fourth capacitor pattern CPE4b may be electrically connected to the first capacitor pattern CPE1b (i.e., the second electrode of the second capacitor C2b) through the second connection pattern CNP2b. For example, a portion of the fourth capacitor pattern CPE4b may be the back gate electrode of the first transistor T1b.

The fourth capacitor pattern CPE4b may at least partially overlap the third capacitor pattern CPE3b in a plan view. A portion of the fourth capacitor pattern CPE4b may overlap a portion of the third capacitor pattern CPE3b. In an embodiment, the portion of the third capacitor pattern CPE3b and the portion of the fourth capacitor pattern CPE4b, which are spaced apart from each other with the fourth inorganic insulating layer IIL4b therebetween, may form a second sub-capacitor C1_2b. For example, the third capacitor pattern CPE3b may be a first electrode of the second sub-capacitor C1_2b, and the fourth capacitor pattern CPE4b may be a second electrode of the second sub-capacitor C1_2b. In an embodiment, the second sub-capacitor C1_2b may be a portion of the first capacitor C1b.

In addition, the fourth capacitor pattern CPE4b may at least partially overlap each of the first drain region D1b of the first semiconductor pattern SMP1b, the first capacitor pattern CPE1b, the second capacitor pattern CPE2b, and the third capacitor pattern CPE3b in a plan view. The first drain region D1b of the first semiconductor pattern SMP1b, the first capacitor pattern CPE1b, the second capacitor pattern CPE2b, the third capacitor pattern CPE3b, and the fourth capacitor pattern CPE4b may be disposed along the third direction DR3.

In an embodiment, the second sub-capacitor C1_2b may at least partially overlap each of the first sub-capacitor C1_1b and the second capacitor C2b in a plan view. The first sub-capacitor C1_1b, the second capacitor C2b, and the second sub-capacitor C1_2b may be disposed along the third direction DR3.

The fifth inorganic insulating layer IIL5b may be disposed on the fourth conductive layer CL4b. The fifth inorganic insulating layer IIL5b may include an inorganic insulating material. The fifth inorganic insulating layer IIL5b may have a single-layer structure or a multi-layer structure including a plurality of insulating layers. The fifth inorganic insulating layer IIL5b may cover the fourth capacitor pattern CPE4b.

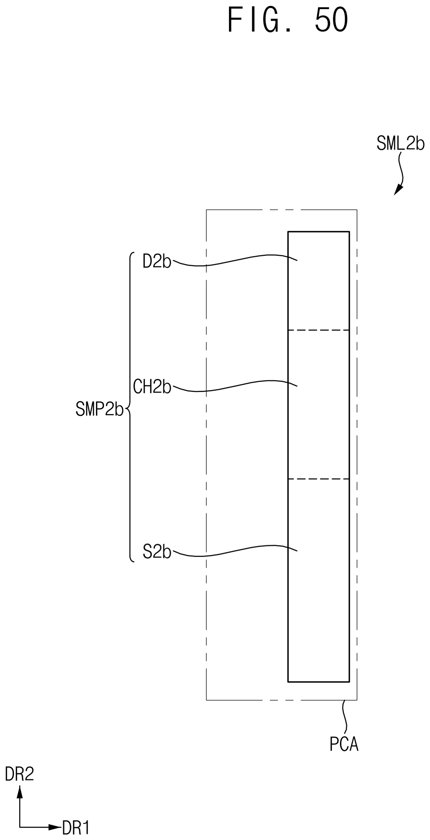

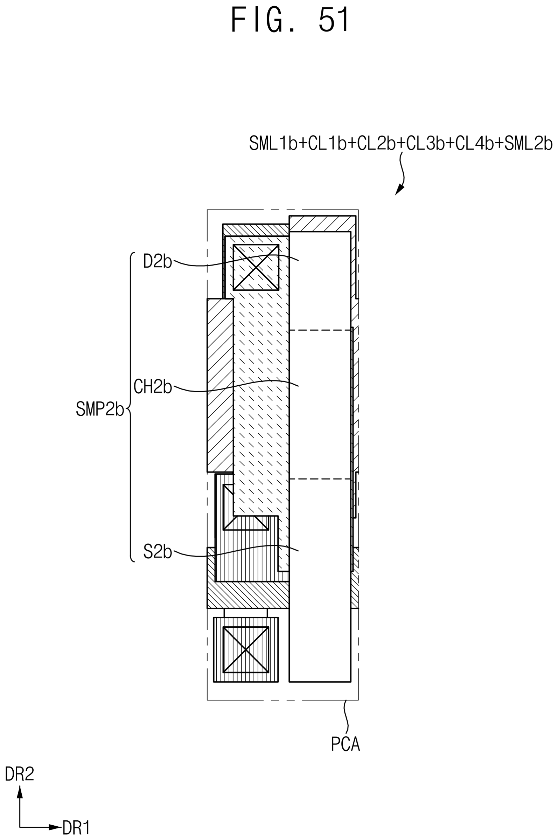

FIG. 50 illustrates the second semiconductor layer SML2b, and FIG. 51 illustrates the view of FIG. 49 with the second semiconductor layer SML2b further disposed.

In an embodiment, as illustrated in FIGS. 40, 50, and 51, the second semiconductor layer SML2b may be disposed on the fifth inorganic insulating layer IIL5b. The first semiconductor layer SML1b may be disposed under the second semiconductor layer SML2b.

In an embodiment, the second semiconductor layer SML2b may include an oxide semiconductor. For example, the second semiconductor layer SML2b may include a metal oxide semiconductor. For example, the second semiconductor layer SML2b may include an oxide of at least one selected from indium (In), gallium (Ga), tin (Sn), zirconium (Zr), vanadium (V), hafnium (Hf), cadmium (Cd), germanium (Ge), chromium (Cr), titanium (Ti), and zinc (Zn).

The second semiconductor layer SML2b may include or define a second semiconductor pattern SMP2b. The second semiconductor pattern SMP2b may include a second source region S2b, a second drain region D2b, and a second channel region CH2b defined between the second source region S2b and the second drain region D2b. In an embodiment, the second source region S2b, the second channel region CH2b, and the second drain region D2b may be sequentially disposed along the second direction DR2.

The second source region S2b may be the first electrode of the first transistor T1b, the second drain region D2b may be the second electrode of the first transistor T1b, and the second channel region CH2b may be a channel of the first transistor T1b.

In an embodiment, the second semiconductor pattern SMP2b may at least partially overlap the first semiconductor pattern SMP1b in a plan view. In an embodiment, the second transistor T2b and the first transistor T1b may be disposed along the third direction DR3.

As illustrated in FIGS. 49 and 51, the second semiconductor pattern SMP2b may at least partially overlap the fourth capacitor pattern CPE4b in a plan view. A portion of the fourth capacitor pattern CPE4b may overlap the second channel region CH2b of the second semiconductor pattern SMP2b in a plan view. The portion of the fourth capacitor pattern CPE4b overlapping the second channel region CH2b may be the back gate electrode of the first transistor T1b.

The sixth inorganic insulating layer IIL6b may be disposed on the second semiconductor layer SML2b. The sixth inorganic insulating layer IIL6b may include an inorganic insulating material. The sixth inorganic insulating layer IIL6b may have a single-layer structure or a multi-layer structure including a plurality of insulating layers. The sixth inorganic insulating layer IIL6b may cover the second semiconductor pattern SMP2b.

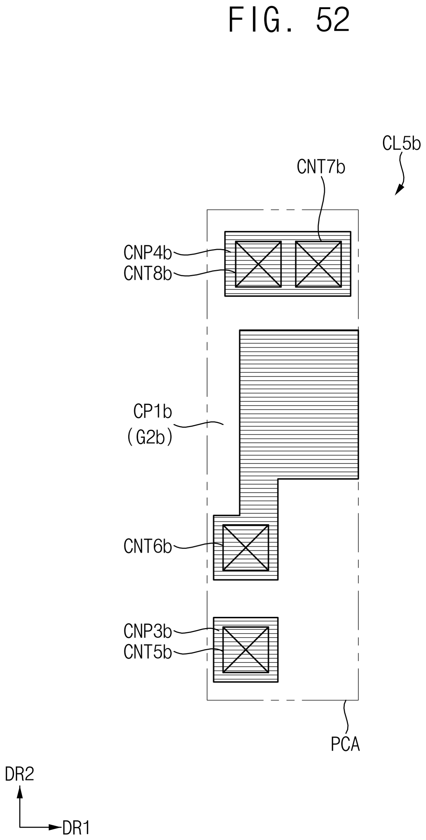

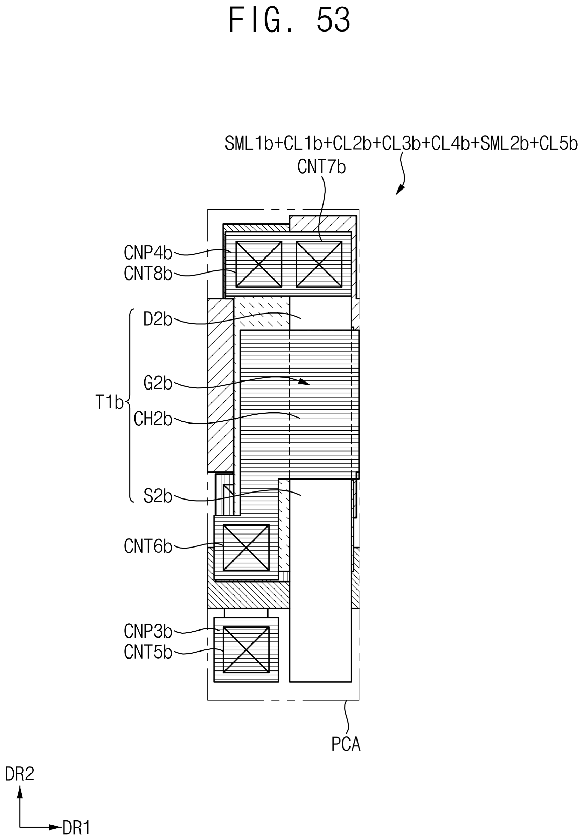

FIG. 52 illustrates the fifth conductive layer CL5b, and FIG. 53 illustrates the view of FIG. 51 with the fifth conductive layer CL5b further disposed.

In an embodiment, as illustrated in FIGS. 40, 52, and 53, the fifth conductive layer CL5b may be disposed on the sixth inorganic insulating layer IIL6b. The fifth conductive layer CL5b may include a conductive material. The fifth conductive layer CL5b may have a single-layer structure or a multi-layer structure including a plurality of conductive layers.

The fifth conductive layer CL5b may include or define a third connection pattern CNP3b, a fourth connection pattern CNP4b, and a first conductive pattern CP1b. The third connection pattern CNP3b, the fourth connection pattern CNP4b, and the first conductive pattern CP1b may be spaced apart from each other in a plan view. For example, the first conductive pattern CP1b may be spaced apart from the third connection pattern CNP3b in the second direction DR2, and the fourth connection pattern CNP4b may be spaced apart from the first conductive pattern CP1b in the second direction DR2. The fourth connection pattern CNP4b, the first conductive pattern CP1b, and the third connection pattern CNP3b may be sequentially disposed along the second direction DR2.

As illustrated in FIGS. 47, 51, and 53, the third connection pattern CNP3b may at least partially overlap the first connection pattern CNP1b in a plan view. The third connection pattern CNP3b may be connected to the first connection pattern CNP1b through a fifth contact hole CNT5b defined or formed by penetrating (or defined or formed through) an inorganic insulating layer (e.g., the fourth to sixth inorganic insulating layers IIL4b, IIL5b, and IIL6b) disposed therebelow. For example, the fifth contact hole CNT5b may expose a portion of the first connection pattern CNP1b, and a portion of the third connection pattern CNP3b may contact the portion of the first connection pattern CNP1b exposed by the fifth contact hole CNT5b.

As illustrated in FIGS. 47, 51, and 53, the first conductive pattern CP1b may at least partially overlap the third capacitor pattern CPE3b in a plan view. The first conductive pattern CP1b may be connected to the third capacitor pattern CPE3b through a sixth contact hole CNT6b defined or formed by penetrating (or defined or formed through) an inorganic insulating layer (e.g., the fourth to sixth inorganic insulating layers IIL4b, IIL5b, and IIL6b) disposed therebelow. For example, the sixth contact hole CNT6b may expose a portion of the third capacitor pattern CPE3b, and a portion of the first conductive pattern CP1b may contact the portion of the third capacitor pattern CPE3b exposed by the sixth contact hole CNT6b.

The first conductive pattern CP1b may at least partially overlap the second semiconductor pattern SMP2b in a plan view. A portion of the first conductive pattern CP1b may overlap the second channel region CH2b of the second semiconductor pattern SMP2b in a plan view. The portion of the first conductive pattern CP1b overlapping the second channel region CH2b may be the gate electrode G2b of the first transistor T1b.

Accordingly, the portion of the first conductive pattern CP1b (i.e., the gate electrode G2b of the first transistor T1b) may be electrically connected to the first drain region D1b of the first semiconductor pattern SMP1b (i.e., the second electrode of the second transistor T2b) through the third capacitor pattern CPE3b.

In addition, the first conductive pattern CP1b may at least partially overlap each of the first drain region D1b of the first semiconductor pattern SMP1b, the first capacitor pattern CPE1b, the second capacitor pattern CPE2b, the third capacitor pattern CPE3b, and the fourth capacitor pattern CPE4b in a plan view. The first drain region D1b of the first semiconductor pattern SMP1b, the first capacitor pattern CPE1b, the second capacitor pattern CPE2b, the third capacitor pattern CPE3b, the fourth capacitor pattern CPE4b, and the first conductive pattern CP1b may be disposed along the third direction DR3.

As illustrated in FIGS. 49, 51, and. 53, the fourth connection pattern CNP4b may at least partially overlap each of the second drain region D2b of the second semiconductor pattern SMP2b and the fourth capacitor pattern CPE4b in a plan view.

The fourth connection pattern CNP4b may be connected to the second drain region D2b of the second semiconductor pattern SMP2b (i.e., the second electrode of the first transistor T1b) through a seventh contact hole CNT7b defined or formed by penetrating (or defined or formed through) an inorganic insulating layer (e.g., the sixth inorganic insulating layer IIL6b) disposed therebelow. For example, the seventh contact hole CNT7b may expose a portion of the second drain region D2b of the second semiconductor pattern SMP2b, and a portion of the fourth connection pattern CNP4b may contact the portion of the second drain region D2b of the second semiconductor pattern SMP2b exposed by the seventh contact hole CNT7b.

In addition, the fourth connection pattern CNP4b may be connected to the fourth capacitor pattern CPE4b through an eighth contact hole CNT8b defined or formed by penetrating (or defined or formed through) an inorganic insulating layer (e.g., the fifth and sixth inorganic insulating layers IIL5b and IIL6b) disposed therebelow. For example, the eighth contact hole CNT8b may expose a portion of the fourth capacitor pattern CPE4b, and a portion of the fourth connection pattern CNP4b may contact the portion of the fourth capacitor pattern CPE4b exposed by the eighth contact hole CNT8b.

Accordingly, the fourth connection pattern CNP4b may electrically connect the second drain region D2b of the second semiconductor pattern SMP2b (i.e., the second electrode of the first transistor T1b) and the fourth capacitor pattern CPE4b. That is, the second drain region D2b of the second semiconductor pattern SMP2b may be electrically connected to the fourth capacitor pattern CPE4b through the fourth connection pattern CNP4b, and may be electrically connected to the first capacitor pattern CPE1b (i.e., the second electrode of the second capacitor C2b) through the fourth connection pattern CNP4b, the fourth capacitor pattern CPE4b, and the second connection pattern CNP2b.

The seventh inorganic insulating layer IIL7b may be disposed on the fifth conductive layer CL5b. The seventh inorganic insulating layer IIL7b may include an inorganic insulating material. The seventh inorganic insulating layer IIL7b may have a single-layer structure or a multi-layer structure including a plurality of insulating layers. The seventh inorganic insulating layer IIL7b may cover the third connection pattern CNP3b, the fourth connection pattern CNP4b, and the first conductive pattern CP1b.

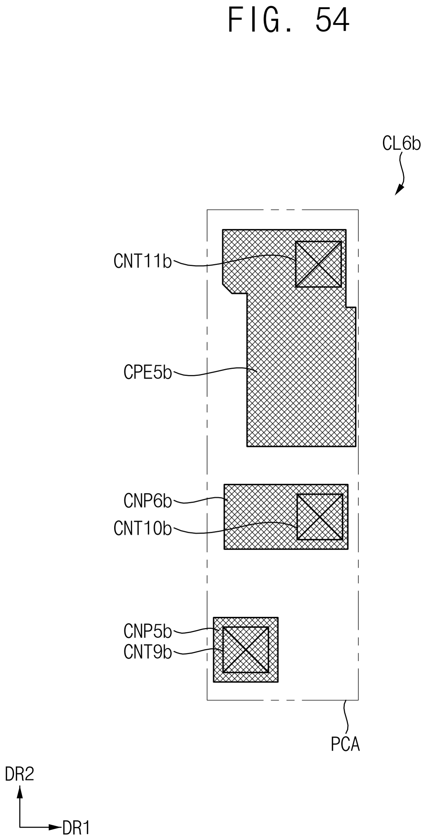

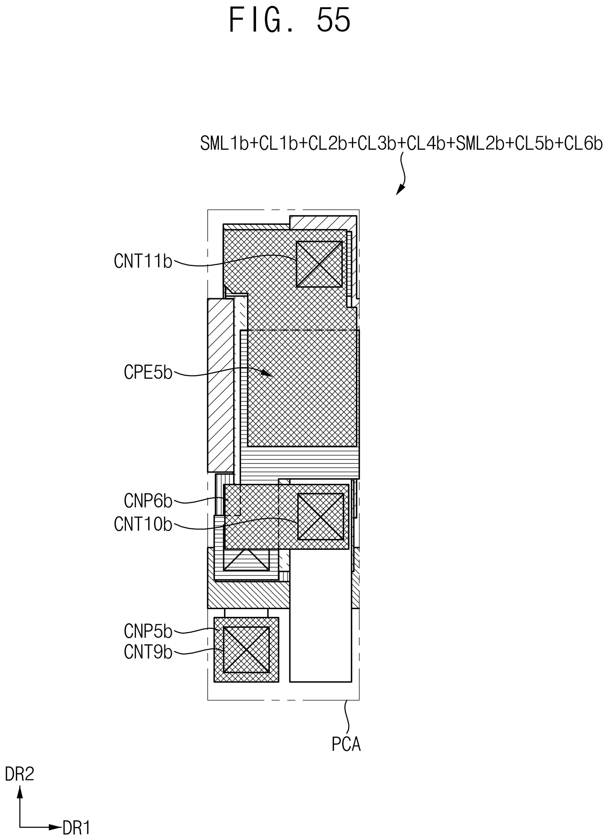

FIG. 54 illustrates the sixth conductive layer CL6b, and FIG. 55 illustrates the view of FIG. 53 with the sixth conductive layer CL6b further disposed.

In an embodiment, as illustrated in FIGS. 40, 54, and 55, the sixth conductive layer CL6b may be disposed on the seventh inorganic insulating layer IIL7b. The sixth conductive layer CL6b may include a conductive material. The sixth conductive layer CL6b may have a single-layer structure or a multi-layer structure including a plurality of conductive layers.

The sixth conductive layer CL6b may include or define a fifth connection pattern CNP5b, a sixth connection pattern CNP6b, and a fifth capacitor pattern CPE5b. The fifth connection pattern CNP5b, the sixth connection pattern CNP6b, and the fifth capacitor pattern CPE5b may be spaced apart from each other in a plan view. For example, the sixth connection pattern CNP6b may be spaced apart from the fifth connection pattern CNP5b in the second direction DR2, and the fifth capacitor pattern CPE5b may be spaced apart from the sixth connection pattern CNP6b in the second direction DR2. The fifth connection pattern CNP5b, the sixth connection pattern CNP6b, and the fifth capacitor pattern CPE5b may be sequentially disposed along the second direction DR2.

As illustrated in FIGS. 53 and 55, the fifth connection pattern CNP5b may at least partially overlap the third connection pattern CNP3b in a plan view. The fifth connection pattern CNP5b may be connected to the third connection pattern CNP3b through a ninth contact hole CNT9b defined or formed by penetrating (or defined or formed through) an inorganic insulating layer (e.g., the seventh inorganic insulating layer IIL7b) disposed therebelow. For example, the ninth contact hole CNT9b may expose a portion of the third connection pattern CNP3b, and a portion of the fifth connection pattern CNP5b may contact the portion of the third connection pattern CNP3b exposed by the ninth contact hole CNT9b.

As illustrated in FIGS. 51, 53, and 55, the sixth connection pattern CNP6b may at least partially overlap the second source region S2b of the second semiconductor pattern SMP2b in a plan view. The sixth connection pattern CNP6b may be connected to the second source region S2b of the second semiconductor pattern SMP2b (i.e., the first electrode of the first transistor T1b) through a tenth contact hole CNT10b defined or formed by penetrating (or defined or formed through) an inorganic insulating layer (e.g., the sixth and seventh inorganic insulating layers IIL6b and IIL7b) disposed therebelow. For example, the tenth contact hole CNT10b may expose a portion of the second source region S2b of the second semiconductor pattern SMP2b, and a portion of the sixth connection pattern CNP6b may contact the portion of the second source region S2b of the second semiconductor pattern SMP2b exposed by the tenth contact hole CNT10b.

As illustrated in FIGS. 53 and 55, the fifth capacitor pattern CPE5b may at least partially overlap the fourth connection pattern CNP4b in a plan view. The fifth capacitor pattern CPE5b may be connected to the fourth connection pattern CNP4b through an eleventh contact hole CNT11b defined or formed by penetrating (or defined or formed through) an inorganic insulating layer (e.g., the seventh inorganic insulating layer IIL7b) disposed therebelow. For example, the eleventh contact hole CNT11b may expose a portion of the fourth connection pattern CNP4b, and a portion of the fifth capacitor pattern CPE5b may contact the portion of the fourth connection pattern CNP4b exposed by the eleventh contact hole CNT11b.

Accordingly, the fifth capacitor pattern CPE5b may be electrically connected to the second drain region D2b of the second semiconductor pattern SMP2b (i.e., the second electrode of the first transistor T1b) through the fourth connection pattern CNP4b, and may be electrically connected to the first capacitor pattern CPE1b (i.e., the second electrode of the second capacitor C2b) through the fourth connection pattern CNP4b, the fourth capacitor pattern CPE4b, and the second connection pattern CNP2b. For example, a portion of the fifth capacitor pattern CPE5b may be the back gate electrode of the fourth transistor T4b.

The fifth capacitor pattern CPE5b may at least partially overlap the first conductive pattern CP1b in a plan view. A portion of the fifth capacitor pattern CPE5b may overlap a portion of the first conductive pattern CP1b. In an embodiment, the portion of the first conductive pattern CP1b and the portion of the fifth capacitor pattern CPE5b, which are spaced apart from each other with the seventh inorganic insulating layer IIL7b therebetween, may form a third sub-capacitor C1_3b. For example, the portion of the first conductive pattern CP1b may be a first electrode of the third sub-capacitor C1_3b, and the portion of the fifth capacitor pattern CPE5b may be a second electrode of the third sub-capacitor C1_3b. In an embodiment, the third sub-capacitor C1_3b may be a portion of the first capacitor C1b.

In addition, the fifth capacitor pattern CPE5b may at least partially overlap each of the first drain region D1b of the first semiconductor pattern SMP1b, the first capacitor pattern CPE1b, the second capacitor pattern CPE2b, the third capacitor pattern CPE3b, the fourth capacitor pattern CPE4b, and the first conductive pattern CP1b in a plan view. The first drain region D1b of the first semiconductor pattern SMP1b, the first capacitor pattern CPE1b, the second capacitor pattern CPE2b, the third capacitor pattern CPE3b, the fourth capacitor pattern CPE4b, the first conductive pattern CP1b, and the fifth capacitor pattern CPE5b may be disposed along the third direction DR3.

In an embodiment, the third sub-capacitor C1_3b may at least partially overlap each of the first sub-capacitor C1_1b, the second capacitor C2b, and the second sub-capacitor C1_2b in a plan view. The first sub-capacitor C1_1b, the second capacitor C2b, the second sub-capacitor C1_2b, and the third sub-capacitor C1_3b may be disposed along the third direction DR3.

In an embodiment, the first capacitor C1b may include the first sub-capacitor C1_1b, the second sub-capacitor C1_2b, and the third sub-capacitor C1_3b. The first to third sub-capacitors C1_1b, C1_2b, and C1_3b may be defined in different layers, and may overlap each other in a plan view. That is, the first capacitor C1b may have a multi-capacitor structure (e.g., triple-capacitor structure), and the first to third sub-capacitors C1_1b, C1_2b, and Cl_3b may function as one capacitor.

For example, the first semiconductor pattern SMP1b of the first semiconductor layer SML1b and the first capacitor pattern CPE1b of the first conductive layer CL1b may define the first sub-capacitor C1_1b, the third capacitor pattern CPE3b of the third conductive layer CL3b and the fourth capacitor pattern CPE4b of the fourth conductive layer CL4b may define the second sub-capacitor C1_2b, and the first conductive pattern CP1b of the fifth conductive layer CL5b and the fifth capacitor pattern CPE5b of the sixth conductive layer CL6b may define the third sub-capacitor C1_3b. Accordingly, the capacitance of the first capacitor C1b may be sufficiently secured even within a limited area. That is, the capacitance of the first capacitor C1b may be further increased while further reducing a region occupied by the first capacitor C1b.

In addition, in an embodiment, the second capacitor C2b and the first capacitor C1b (i.e., each of the first to third sub-capacitors C1_1b, C1_2b, and C1_3b) may be defined in different layers, and may overlap the first capacitor C1b (i.e., each of the first to third sub-capacitors C1_1b, C1_2b, and C1_3b) in a plan view. For example, the first capacitor pattern CPE1b of the first conductive layer CL1b and the second capacitor pattern CPE2b of the second conductive layer CL2b may define the second capacitor C2b. Accordingly, the degree of integration of the pixel circuit PCb may be improved, and the resolution of the display panel DPb and the resolution of the display device including the same may be improved.

In an embodiment, a thickness of each of the inorganic insulating layers, which are defines the first to third sub-capacitors C1_1b, C1_2b, and C1_3b and the second capacitor C2b, may be in a range of about 500 Å or more and about 4000 Å or less. When the thickness of each of the inorganic insulating layers is less than about 500 Å, static electricity may be generated between the conductive layers and/or the semiconductor layers with each inorganic insulating layer interposed therebetween. When the thickness of each of the inorganic insulating layers is more than about 4000 Å, it may be relatively difficult to secure the capacitance of the capacitor.

In an embodiment, a thickness of the first inorganic insulating layer IIL1b, which is between the first semiconductor pattern SMP1b and the first capacitor pattern CPE1b defining the first sub-capacitor C1_1b, in the third direction DR3 may be in a range of about 500 Å or more and about 4000 Å or less. In an embodiment, a thickness of the fourth inorganic insulating layer IIL4b, which is between the third capacitor pattern CPE3b and the fourth capacitor pattern CPE4b defining the second sub-capacitor C1_2b, in the third direction DR3 may be in a range of about 500 Å or more and about 4000 Å or less. In an embodiment, a thickness of the seventh inorganic insulating layer IIL7b, which is between the first conductive pattern CP1b and the fifth capacitor pattern CPE5b defining the third sub-capacitor C1_3b, in the third direction DR3 may be in a range of about 500 Å or more and about 4000 Å or less. In an embodiment, a thickness of the second inorganic insulating layer IIL2b, which is between the first capacitor pattern CPE1b and the second capacitor pattern CPE2b defining the second capacitor C2b, in the third direction DR3 may be in a range of about 500 Å or more and about 4000 Å or less.

The eighth inorganic insulating layer IIL8b may be disposed on the sixth conductive layer CL6b. The eighth inorganic insulating layer IIL8b may include an inorganic insulating material. The eighth inorganic insulating layer IIL8b may have a single-layer structure or a multi-layer structure including a plurality of insulating layers. The eighth inorganic insulating layer IIL8b may cover the fifth connection pattern CNP5b, the sixth connection pattern CNP6b, and the fifth capacitor pattern CPE5b.

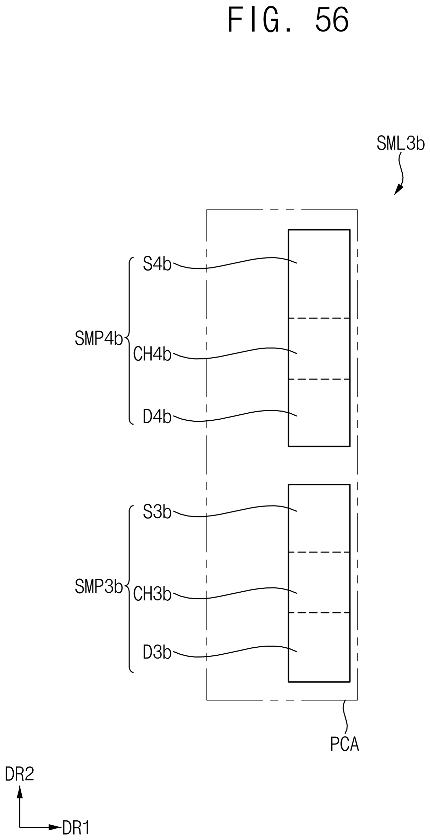

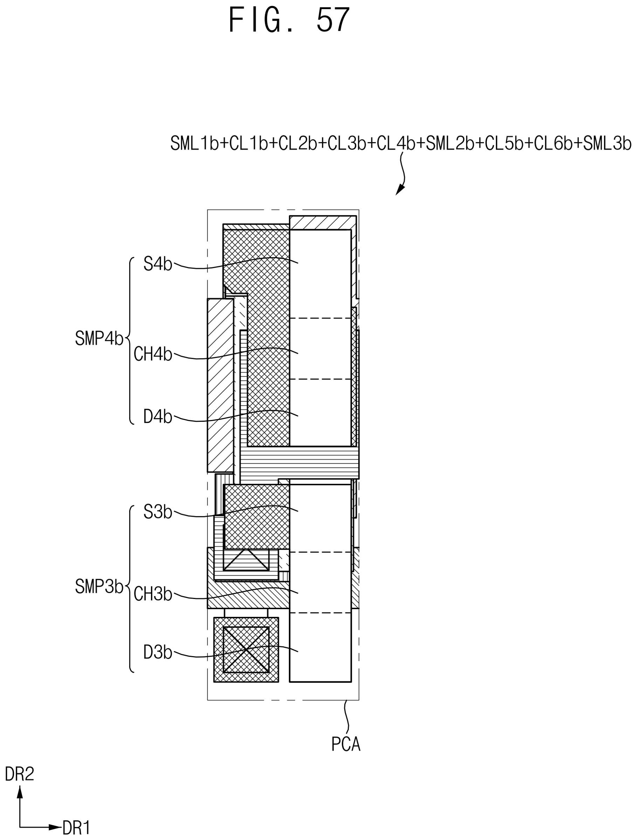

FIG. 56 illustrates the third semiconductor layer SML3b, and FIG. 57 illustrates the view of FIG. 55 with the third semiconductor layer SML3b further disposed.

In an embodiment, as illustrated in FIGS. 40, 56, and 57, the third semiconductor layer SML3b may be disposed on the eighth inorganic insulating layer IIL8b. The third semiconductor layer SML3b may be disposed on the second semiconductor layer SML2b. The second semiconductor layer SML2b may be disposed between the first semiconductor layer SML1b and the third semiconductor layer SML3b.

In an embodiment, the third semiconductor layer SML3b may include an oxide semiconductor. For example, the third semiconductor layer SML3b may include a metal oxide semiconductor. For example, the third semiconductor layer SML3b may include an oxide of at least one selected from indium (In), gallium (Ga), tin (Sn), zirconium (Zr), vanadium (V), hafnium (Hf), cadmium (Cd), germanium (Ge), chromium (Cr), titanium (Ti), and zinc (Zn).

The third semiconductor layer SML3b may include or define a third semiconductor pattern SMP3b and a fourth semiconductor pattern SMP4b. The third semiconductor pattern SMP3b and the fourth semiconductor pattern SMP4b may be spaced apart from each other in a plan view. For example, the fourth semiconductor pattern SMP4b may be spaced apart from the third semiconductor pattern SMP3b in the second direction DR2.

The third semiconductor pattern SMP3b may include a third source region S3b, a third drain region D3b, and a third channel region CH3b defined between the third source region S3b and the third drain region D3b. In an embodiment, the third drain region D3b, the third channel region CH3b, and the third source region S3b may be sequentially disposed along the second direction DR2.

The third source region S3b may be the first electrode of the third transistor T3b, the third drain region D3b may be the second electrode of the third transistor T3b, and the third channel region CH3b may be a channel of the third transistor T3b.

In an embodiment, the third semiconductor pattern SMP3b may at least partially overlap each of the first and second semiconductor patterns SMP1b and SMP2b in a plan view. In an embodiment, the second transistor T2b, the first transistor T1b, and the third transistor T3b may be sequentially disposed along the third direction DR3. That is, the pixel circuit PCb included in the display panel DPb may be implemented as a multi-layer structure in which the first transistor T1b, the second transistor T2b, and the third transistor T3b are stacked in the third direction DR3, thereby the degree of integration of the pixel circuits PCb may be improved.

The fourth semiconductor pattern SMP4b may include a fourth source region S4b, a fourth drain region D4b, and a fourth channel region CH4b defined between the fourth source region S4b and the fourth drain region D4b. In an embodiment, the fourth drain region D4b, the fourth channel region CH4b, and the fourth source region S4b may be sequentially disposed along the second direction DR2.

The fourth source region S4b may be the first electrode of the fourth transistor T4b, the fourth drain region D4b may be the second electrode of the fourth transistor T4b, and the fourth channel region CH4b may be a channel of the fourth transistor T4b.

In an embodiment, the fourth semiconductor pattern SMP4b may at least partially overlap each of the first and second semiconductor patterns SMP1b and SMP2b in a plan view. In an embodiment, the second transistor T2b, the first transistor T1b, and the fourth transistor T4b may be sequentially disposed along the third direction DR3. That is, the pixel circuit PCb included in the display panel DPb may be implemented as a multi-layer structure in which the first transistor T1b, the second transistor T2b, and the fourth transistor T4b are stacked in the third direction DR3, thereby the degree of integration of the pixel circuits PCb may be improved.

As illustrated in FIGS. 55 and 57, the fourth semiconductor pattern SMP4b may at least partially overlap the fifth capacitor pattern CPE5b in a plan view. A portion of the fifth capacitor pattern CPE5b may overlap the fourth channel region CH4b of the fourth semiconductor pattern SMP4b in a plan view. The portion of the fifth capacitor pattern CPE5b overlapping the fourth channel region CH4b may be the back gate electrode of the fourth transistor T4b.

The ninth inorganic insulating layer IIL9b may be disposed on the third semiconductor layer SML3b. The ninth inorganic insulating layer IIL9b may include an inorganic insulating material. The ninth inorganic insulating layer IIL9b may have a single-layer structure or a multi-layer structure including a plurality of insulating layers. The ninth inorganic insulating layer IIL9b may cover the third semiconductor pattern SMP3b and the fourth semiconductor pattern SMP4b.

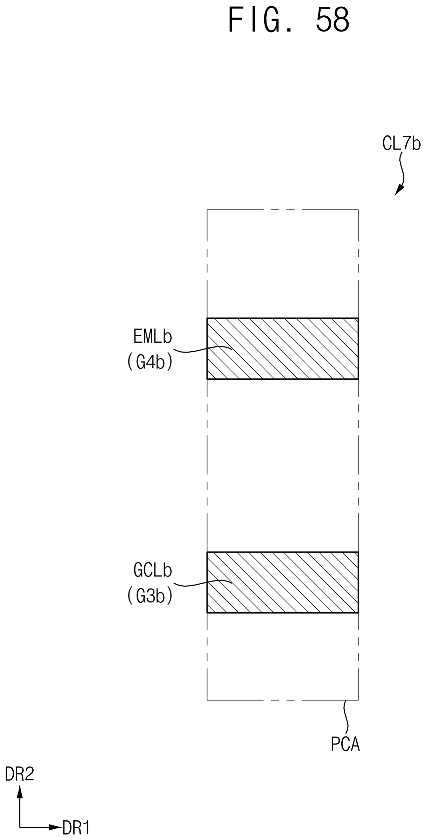

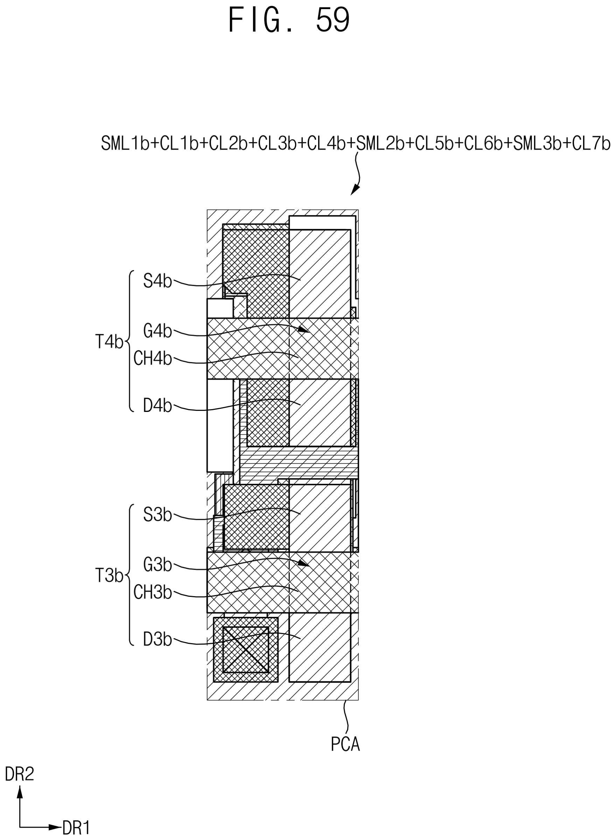

FIG. 58 illustrates the seventh conductive layer CL7b, and FIG. 59 illustrates the view of FIG. 57 with the seventh conductive layer CL7b further disposed.

In an embodiment, as illustrated in FIGS. 40, 58, and 59, the seventh conductive layer CL7b may be disposed on the ninth inorganic insulating layer IIL9b. The seventh conductive layer CL7b may include a conductive material. The seventh conductive layer CL7b may have a single-layer structure or a multi-layer structure including a plurality of conductive layers.

The seventh conductive layer CL7b may include the compensation gate line GCLb and the emission line EMLb. The compensation gate line GCLb and the emission line EMLb may be spaced apart from each other in a plan view.

In an embodiment, the compensation gate line GCLb may extend in the first direction DR1. The compensation gate signal GC of FIG. 7 may be applied to the compensation gate line GCLb.

A portion of the compensation gate line GCLb may overlap the third channel region CH3b of the third semiconductor pattern SMP3b in a plan view. The portion of the compensation gate line GCLb overlapping the third channel region CH3b may be the gate electrode G3b of the third transistor T3b.

In an embodiment, the emission line EMLb may extend in the first direction DR1. For example, the emission line EMLb may be spaced apart from the compensation gate line GCLb in the second direction DR2 in a plan view. The emission signal EM of FIG. 7 may be applied to the emission line EMLb.

A portion of the emission line EMLb may overlap the fourth channel region CH4b of the fourth semiconductor pattern SMP4b in a plan view. The portion of the emission line EMLb overlapping the fourth channel region CH4b may be the gate electrode G4b of the fourth transistor T4b.

The tenth inorganic insulating layer IIL10b may be disposed on the seventh conductive layer CL7b. The tenth inorganic insulating layer IIL10b may include an inorganic insulating material. The tenth inorganic insulating layer IIL10b may have a single-layer structure or a multi-layer structure including a plurality of insulating layers. The tenth inorganic insulating layer IIL10b may cover the compensation gate line GCLb and the emission line EMLb.

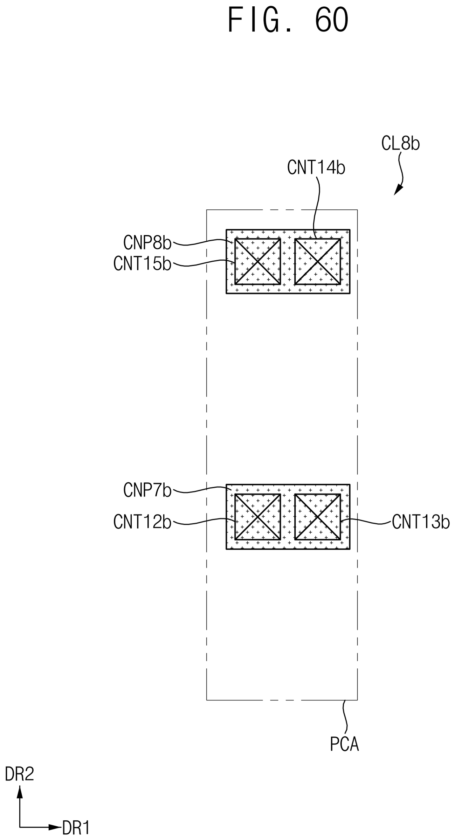

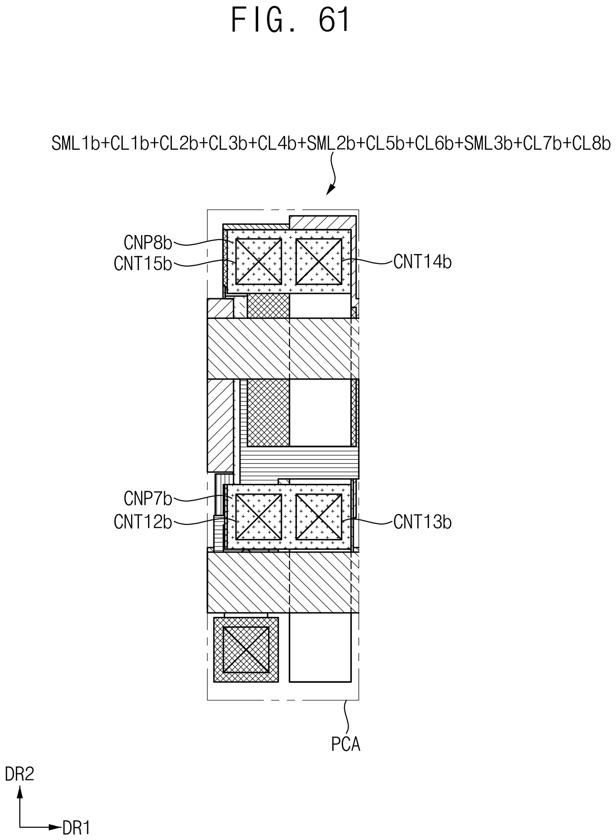

FIG. 60 illustrates the eighth conductive layer CL8b, and FIG. 61 illustrates the view of FIG. 59 with the eighth conductive layer CL8b further disposed.

In an embodiment, as illustrated in FIGS. 40, 60, and 61, the eighth conductive layer CL8b may be disposed on the tenth inorganic insulating layer IIL10b. The eighth conductive layer CL8b may include a conductive material. The eighth conductive layer CL8b may have a single-layer structure or a multi-layer structure including a plurality of conductive layers.

The eighth conductive layer CL8b may include or define a seventh connection pattern CNP7b and an eighth connection pattern CNP8b. The seventh connection pattern CNP7b and the eighth connection pattern CNP8b may be spaced apart from each other in a plan view. For example, the eighth connection pattern CNP8b may be spaced apart from the seventh connection pattern CNP7b in the second direction DR2.

As illustrated in FIGS. 55, 57, 59, and 61, the seventh connection pattern CNP7b may at least partially overlap each of the sixth connection pattern CNP6b and the third drain region D3b of the third semiconductor pattern SMP3b in a plan view.

The seventh connection pattern CNP7b may be connected to the sixth connection pattern CNP6b through a twelfth contact hole CNT12b defined or formed by penetrating (or defined or formed through) an inorganic insulating layer (e.g., the eighth to tenth inorganic insulating layers IIL8b, IIL9b, and IIL10b) disposed therebelow. For example, the twelfth contact hole CNT12b may expose a portion of the sixth connection pattern CNP6b, and a portion of the seventh connection pattern CNP7b may contact the portion of the sixth connection pattern CNP6b exposed by the twelfth contact hole CNT12b.

In addition, the seventh connection pattern CNP7b may be connected to the third drain region D3b of the third semiconductor pattern SMP3b (i.e., the second electrode of the third transistor T3b) through a thirteenth contact hole CNT13b defined or formed by penetrating (or defined or formed through) an inorganic insulating layer (e.g., the ninth and tenth inorganic insulating layers IIL9b and IIL10b) disposed therebelow. For example, the thirteenth contact hole CNT13b may expose a portion of the third drain region D3b of the third semiconductor pattern SMP3b, and a portion of the seventh connection pattern CNP7b may contact the portion of the third drain region D3b of the third semiconductor pattern SMP3b exposed by the thirteenth contact hole CNT13b.

Accordingly, the seventh connection pattern CNP7b may electrically connect the sixth connection pattern CNP6b and the third drain region D3b of the third semiconductor pattern SMP3b. That is, the third drain region D3b of the third semiconductor pattern SMP3b (i.e., the second electrode of the third transistor T3b) may be electrically connected to the second source region S2b of the second semiconductor pattern SMP2b (i.e., the first electrode of the first transistor T1b) through the seventh connection pattern CNP7b and the sixth connection pattern CNP6b.

As illustrated in FIGS. 55, 57, 59, and 61, the eighth connection pattern CNP8b may at least partially overlap each of the fourth source region S4b of the fourth semiconductor pattern SMP4b and the fifth capacitor pattern CPE5b in a plan view.

The eighth connection pattern CNP8b may be connected to the fourth source region S4b of the fourth semiconductor pattern SMP4b (i.e., the first electrode of the fourth transistor T4b) through a fourteenth contact hole CNT14b defined or formed by penetrating (or defined or formed through) an inorganic insulating layer (e.g., the ninth and tenth inorganic insulating layers IIL9b and IIL10b) disposed therebelow. For example, the fourteenth contact hole CNT14b may expose a portion of the fourth source region S4b of the fourth semiconductor pattern SMP4b, and a portion of the eighth connection pattern CNP8b may contact the portion of the fourth source region S4b of the fourth semiconductor pattern SMP4b exposed by the fourteenth contact hole CNT14b.

In addition, the eighth connection pattern CNP8b may be connected to the fifth capacitor pattern CPE5b through a fifteenth contact hole CNT15b defined or formed by penetrating (or defined or formed through) an inorganic insulating layer (e.g., the eighth to tenth inorganic insulating layers IIL8b, IIL9b, and IIL10b) disposed therebelow. For example, the fifteenth contact hole CNT15b may expose a portion of the fifth capacitor pattern CPE5b, and a portion of the eighth connection pattern CNP8b may contact the portion of the fifth capacitor pattern CPE5b exposed by the fifteenth contact hole CNT15b.

Accordingly, the eighth connection pattern CNP8b may electrically connect the fourth source region S4b of the fourth semiconductor pattern SMP4b and the fifth capacitor pattern CPE5b. That is, the fourth source region S4b of the fourth semiconductor pattern SMP4b (i.e., the first electrode of the fourth transistor T4b) may be electrically connected to the fifth capacitor pattern CPE5b through the eighth connection pattern CNP8b.

In addition, the fourth source region S4b of the fourth semiconductor pattern SMP4b (i.e., the first electrode of the fourth transistor T4b) may be electrically connected to the second drain region D2b of the second semiconductor pattern SMP2b (i.e., the second electrode of the first transistor T1b) through the eighth connection pattern CNP8b, the fifth capacitor pattern CPE5b, and the fourth connection pattern CNP4b, and may be electrically connected to the first capacitor pattern CPE1b (i.e., the second electrode of the second capacitor C2b) through the eighth connection pattern CNP8b, the fifth capacitor pattern CPE5b, the fourth connection pattern CNP4b, the fourth capacitor pattern CPE4b, and the second connection pattern CNP2b.

The eleventh inorganic insulating layer IIL11b may be disposed on the eighth conductive layer CL8b. The eleventh inorganic insulating layer IIL11b may include an inorganic insulating material. The eleventh inorganic insulating layer IIL11b may have a single-layer structure or a multi-layer structure including a plurality of insulating layers. The eleventh inorganic insulating layer IIL11b may cover the seventh connection pattern CNP7b and the eighth connection pattern CNP8b.

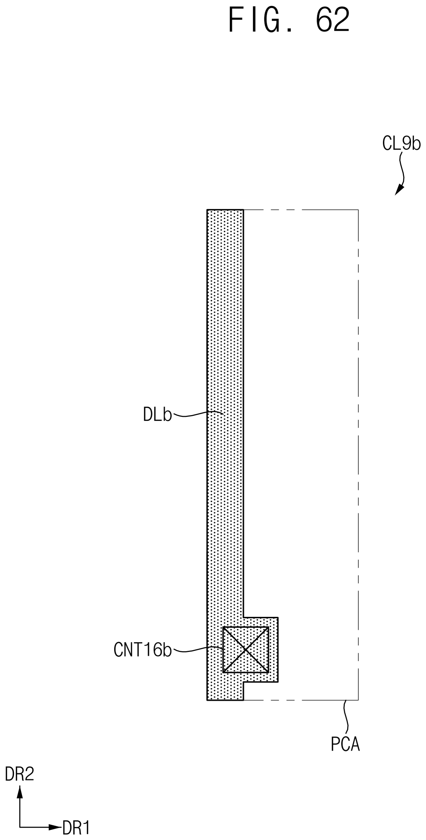

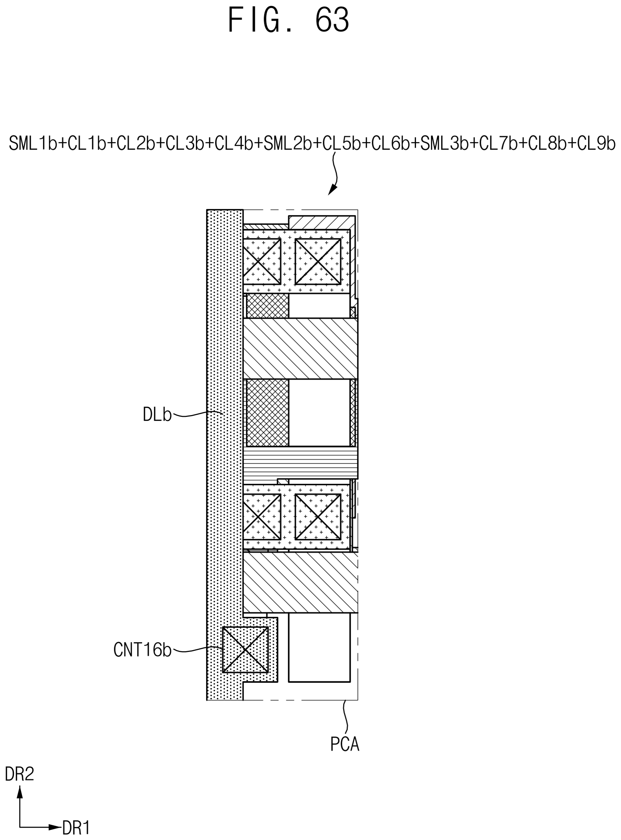

FIG. 62 illustrates the ninth conductive layer CL9b, and FIG. 63 illustrates the view of FIG. 61 with the ninth conductive layer CL9b further disposed.

In an embodiment, as illustrated in FIGS. 40, 62, and 63, the ninth conductive layer CL9b may be disposed on the eleventh inorganic insulating layer IIL11b. The ninth conductive layer CL9b may include a conductive material. The ninth conductive layer CL9b may have a single-layer structure or a multi-layer structure including a plurality of conductive layers.

The ninth conductive layer CL9b may include or define the data line DLb. The data voltage VDAT of FIG. 7 may be applied to the data line DLb.

In an embodiment, the data line DLb may extend in the second direction DR2. As illustrated in FIGS. 55, 61, and 63, the data line DLb may at least partially overlap the fifth connection pattern CNP5b in a plan view. The data line DLb may be connected to the fifth connection pattern CNP5b through a sixteenth contact hole CNT16b defined or formed by penetrating (or defined or formed through) an inorganic insulating layer (e.g., the eighth to eleventh inorganic insulating layers IIL8b, IIL9b, IIL10b, and IIL11b) disposed therebelow. For example, the sixteenth contact hole CNT16b may expose a portion of the fifth connection pattern CNP5b, and a portion of the data line DLb may contact the portion of the fifth connection pattern CNP5b exposed by the sixteenth contact hole CNT16b.

Accordingly, the data line DLb may be connected to the first source region S1b of the first semiconductor pattern SMP1b (i.e., the first electrode of the second transistor T2b) through the fifth connection pattern CNP5b, the third connection pattern CNP3b, and the first connection pattern CNP1b. Therefore, the data voltage VDAT of FIG. 7 may be applied to the first source region S1b of the first semiconductor pattern SMP1b (i.e., the first electrode of the second transistor T2b) through the data line DLb, the fifth connection pattern CNP5b, the third connection pattern CNP3b, and the first connection pattern CNP1b.

The twelfth inorganic insulating layer IIL12b may be disposed on the ninth conductive layer CL9b. The twelfth inorganic insulating layer IIL12b may include an inorganic insulating material. The twelfth inorganic insulating layer IIL12b may have a single-layer structure or a multi-layer structure including a plurality of insulating layers. The twelfth inorganic insulating layer IIL12b may cover the data line DLb.

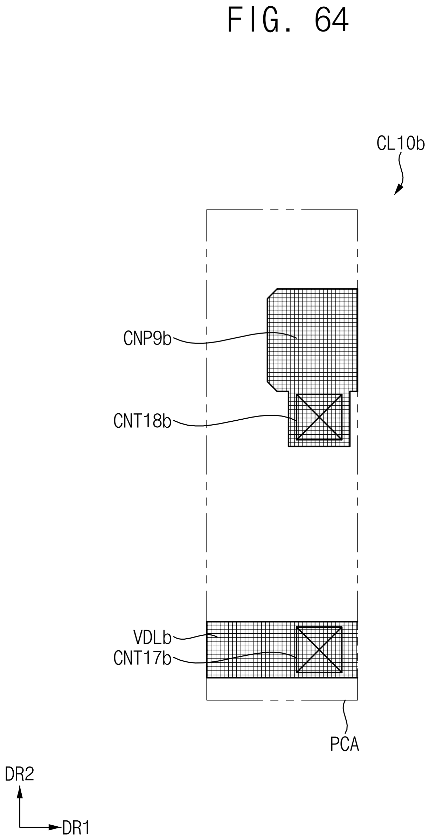

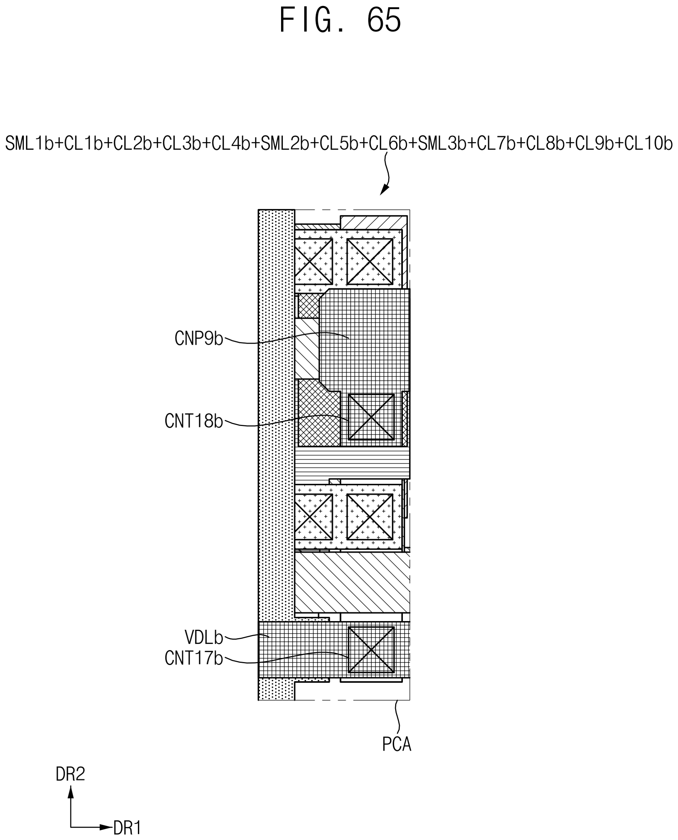

FIG. 64 illustrates the tenth conductive layer CL10b, and FIG. 65 illustrates the view of FIG. 63 with the tenth conductive layer CL10b further disposed.

In an embodiment, as illustrated in FIGS. 40, 64, and 65, the tenth conductive layer CL10b may be disposed on the twelfth inorganic insulating layer IIL12b. The tenth conductive layer CL10b may include a conductive material. The tenth conductive layer CL10b may have a single-layer structure or a multi-layer structure including a plurality of conductive layers.

The tenth conductive layer CL10b may include or define the driving power line VDLb and a ninth connection pattern CNP9b. The driving power line VDLb and the ninth connection pattern CNP9b may be spaced apart from each other in a plan view. For example, the ninth connection pattern CNP9b may be spaced apart from the driving power line VDLb in the second direction DR2 in a plan view.

In an embodiment, the driving power line VDLb may be extend in the first direction DR1. The driving power voltage ELVDD of FIG. 7 may be applied to the driving power line VDLb.

As illustrated in FIGS. 57, 63, and 65, the driving power line VDLb may at least partially overlap the third source region S3b of the third semiconductor pattern SMP3b in a plan view. The driving power line VDLb may be connected to the third source region S3b of the third semiconductor pattern SMP3b (i.e., the first electrode of the third transistor T3b) through a seventeenth contact hole CNT17b defined or formed by penetrating (or defined or formed through) an inorganic insulating layer (e.g., the ninth to twelfth inorganic insulating layers IIL9b, IIL10b, IIL11b, and IIL12b) disposed therebelow. For example, the seventeenth contact hole CNT17b may expose a portion of the third source region S3b of the third semiconductor pattern SMP3b, and a portion of the driving power line VDLb may contact the portion of the third source region S3b of the third semiconductor pattern SMP3b exposed by the seventeenth contact hole CNT17b.

Accordingly, the driving power voltage ELVDD of FIG. 7 may be applied to the third source region S3b of the third semiconductor pattern SMP3b (i.e., the first electrode of the third transistor T3b) through the driving power line VDLb.

As illustrated in FIGS. 57, 63, and 65, the ninth connection pattern CNP9b may at least partially overlap the fourth drain region D4b of the fourth semiconductor pattern SMP4b in a plan view. The ninth connection pattern CNP9b may be connected to the fourth drain region D4b of the fourth semiconductor pattern SMP4b (i.e., the second electrode of the fourth transistor T4b) through an eighteenth contact hole CNT18b defined or formed by penetrating (or defined or formed through) an inorganic insulating layer (e.g., the ninth to twelfth inorganic insulating layers IIL9b, IIL10b, IIL11b, and IIL12b) disposed therebelow. For example, the eighteenth contact hole CNT18b may expose a portion of the fourth drain region D4b of the fourth semiconductor pattern SMP4b, and a portion of the ninth connection pattern CNP9b may contact the portion of the fourth drain region D4b of the fourth semiconductor pattern SMP4b exposed by the eighteenth contact hole CNT18b.

The first organic insulating layer OIL1b may be disposed on the tenth conductive layer CL10b. The first organic insulating layer OIL1b may include an organic insulating material. The first organic insulating layer OIL1b may have a single-layer structure or a multi-layer structure including a plurality of insulating layers. The first organic insulating layer OIL1b may cover the driving power line VDLb and the ninth connection pattern CNP9b.

The eleventh conductive layer may be disposed on the first organic insulating layer OIL1b. The eleventh conductive layer may have a single-layer structure or a multi-layer structure including a plurality of conductive layers.

The eleventh conductive layer may include or define a tenth connection pattern CNP10b. The tenth connection pattern CNP10b may overlap the ninth connection pattern CNP9b in a plan view. The tenth connection pattern CNP10b may be connected to the ninth connection pattern CNP9b through a first via hole VH1b defined or formed by penetrating an organic insulating layer (e.g., the first organic insulating layer OIL1b) disposed therebelow. For example, the first via hole VH1b may expose a portion of the ninth connection pattern CNP9b. A portion of the tenth connection pattern CNP10b may contact the portion of the ninth connection pattern CNP9b exposed by the first via hole VH1b.

The second organic insulating layer OIL2b may be disposed on the eleventh conductive layer. The second organic insulating layer OIL2b may include an organic insulating material. The second organic insulating layer OIL2b may have a single-layer structure or a multi-layer structure including a plurality of insulating layers. The second organic insulating layer OIL2b may cover the tenth connection pattern CNP10b.

The light emitting element layer LEL may be disposed on the second organic insulating layer OIL2b.

The first electrode ED1 of the light emitting element LE may be disposed on the second organic insulating layer OIL2b. The first electrode ED1 may include a conductive material. For example, the first electrode ED1 may be the anode electrode of the light emitting element LE.

The first electrode ED1 may be connected to the tenth connection pattern CNP10b through a second via hole VH2b defined or formed by penetrating an organic insulating layer (e.g., the second organic insulating layer OIL2b) disposed therebelow. Accordingly, the first electrode ED1 may be electrically connected to the fourth drain region D4b of the fourth semiconductor pattern SMP4b (i.e., the second electrode of the fourth transistor T4b) through the tenth connection pattern CNP10b and the ninth connection pattern CNP9b.

The pixel defining layer PDL may be disposed on the second organic insulating layer OIL2b and the first electrode ED1. The pixel defining layer PDL may cover a peripheral portion of the first electrode ED1 and may define a pixel opening that exposes a central portion of the first electrode ED1. The pixel defining layer PDL may include an inorganic insulating material and/or an organic insulating material.

The middle layer ML may be disposed on the first electrode ED1. The middle layer ML may include the emission layer. In an embodiment, the middle layer ML may further include various functional layers (e.g., a hole injection layer, a hole transport layer, an electron transport layer, an electron injection layer, or the like) disposed on and/or under the emission layer.

The second electrode ED2 of the light emitting element LE may be disposed on the middle layer ML. The second electrode ED2 may also be disposed on the pixel defining layer PDL. The second electrode ED2 may include a conductive material. For example, the second electrode ED2 may be the cathode electrode of the light emitting element LE. The first electrode ED1, the middle layer ML, and the second electrode ED2 may form or collectively define the light emitting element LE.

Embodiments 4 to 6 (E4 to E6), Embodiments 13 to 15 (E13 to E15), Embodiments 22 to 24 (E22 to E24), and Embodiments 31 to 33 (E31 to E33) of FIG. 11 may be embodiments of the display panel DPb having the structure described with reference to FIGS. 40 to 65. Here, in each of Embodiments 4 to 6 (E4 to E6), Embodiments 13 to 15 (E13 to E15), Embodiments 22 to 24 (E22 to E24), and Embodiments 31 to 33 (E31 to E33), the CNT area of FIG. 11 is a value calculated by summing areas of the first to eighteenth contact holes CNT1b to CNT18b of FIGS. 40 to 65 in a plan view. Specifically, in Embodiment 14 (E14), an area of a bottom surface of each of the first to eighteenth contact holes CNT1b to CNT18b is 2.56 µm².

FIG. 66 is a block diagram illustrating an electronic device according to an embodiment.

Referring to FIG. 66, an electronic device 10 according to embodiments may include a display module 11, a processor 12, a memory 13, and a power module 14.

The display device according to embodiments (e.g., the display device DD of FIG. 1) may be applied to various electronic devices 10. The electronic device 10 may include the display device, and may further include modules or devices with additional functions other than the display device.

The processor 12 (e.g., the host processor) may include one or more processors including at least one of a central processing unit ("CPU"), an application processor ("AP"), a graphic processing unit ("GPU"), a communication processor ("CP"), an image signal processor ("ISP"), and a controller.

The memory 13 may store data information necessary for the operation of the processor 12 or the display module 11. When the processor 12 executes the application stored in the memory 13, the input image data IMG and/or the input control signal CONT (see FIG. 1) may be transmitted to the display module 11, and the display module 11 may process the received signal and output image information through a display screen.

The power module 14 may include a power supply module, such as a power adapter or a battery device, and a power conversion module which converts the power supplied by the power supply module to generate power required for the operation of the electronic device 10.

At least one of each component of the electronic device 10 described above may be included in the display device according to embodiments. In addition, some of the individual modules functionally included in one module may be included in the display device, and other portions may be provided separately from the display device. For example, the display device may include the display module 11, and the processor 12, the memory 13, and the power module 14 may be provided in the form of other devices within the electronic device 10 other than the display device.

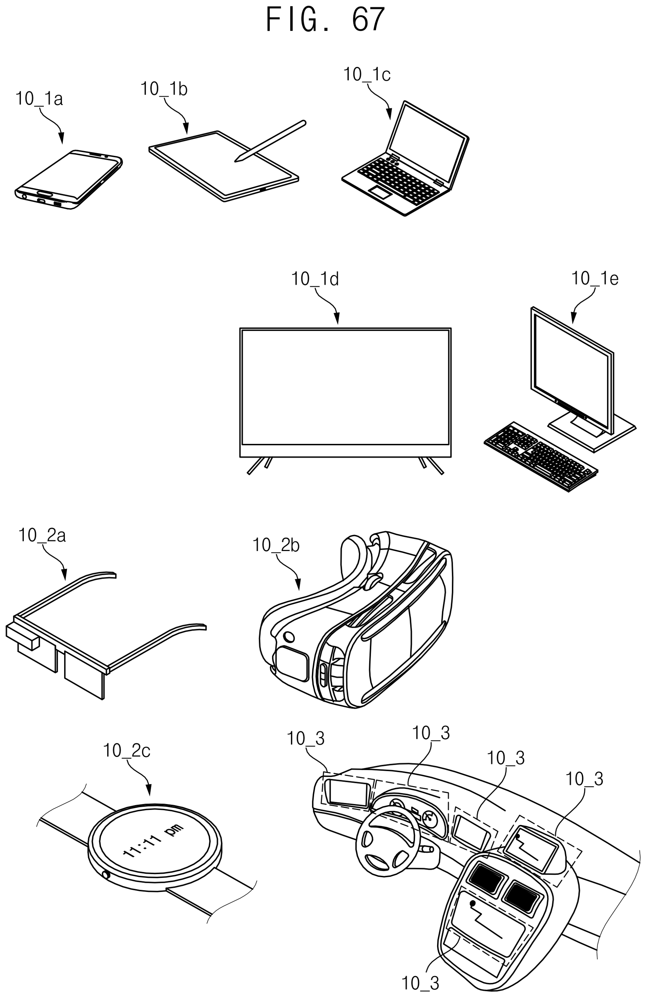

FIG. 67 is a schematic diagram illustrating electronic devices according to various embodiments.

Referring to FIGS. 66 and 67, various electronic devices 10 to which the display device according to embodiments are applied may include not only image display electronic devices such as a smartphone 10_1a, a tablet PC 10_1b, a laptop 10_1c, a TV 10_1d, and a desktop monitor 10_1e, but also wearable electronic devices including display modules, such as smart glasses 10_2a, a head-mounted display 10_2b, and a smart watch 10_2c, automotive electronic devices 10_3 including display modules, such as a dashboard of a car, a center fascia, a Center Information Display ("CID") disposed on a dashboard, and a room mirror display, or the like.

Although embodiments and implementations have been described herein, other embodiments and modifications will be apparent from this description. Accordingly, the inventive concept is not limited to such embodiments, but rather to the broader scope of the appended claims.

## Claims

1. A display device comprising:
a substrate including a plurality of pixel circuit regions;
a circuit element layer disposed on the substrate, the circuit element layer including a plurality of semiconductor layers, a plurality of conductive layers, and a plurality of insulating layers which are stacked in a thickness direction, the circuit element layer including a plurality of pixel circuits disposed in the plurality of pixel circuit regions, respectively; and
a light emitting element layer disposed on the circuit element layer, the light emitting element layer including a plurality of light emitting elements connected to the plurality of pixel circuits, respectively,
wherein each of the pixel circuits includes a plurality of transistors and at least one capacitor,
wherein the insulating layers included in the circuit element layer include a plurality of inorganic insulating layers and at least one organic insulating layer disposed on the inorganic insulating layers,
wherein a plurality of contact holes penetrate at least one of the inorganic insulating layers, and
wherein the ratio, expressed as a percentage, of the sum of areas of the contact holes in one pixel circuit region of the pixel circuit regions to the area of the one pixel circuit region is in the range of 8 or more and 98 or less.

2. The display device of claim 1, wherein the area of each of the contact holes is measured based on a bottom surface of each of the contact holes in a plan view.

3. The display device of claim 1 or 2, wherein the ratio, expressed as a percentage, of the sum of areas of channel regions of the transistors in the one pixel circuit region to the area of the one pixel circuit region is in the range of 10 or more and 30 or less.

4. The display device of claim 1, 2 or 3, wherein each of the pixel circuits includes:
a first transistor including a gate electrode connected to a first node, a first electrode to which a driving power voltage is applied, and a second electrode connected to a second node, the first transistor being configured to apply a driving current to a corresponding one of the light emitting elements;
a second transistor including a gate electrode to which a write gate signal is applied, a first electrode to which a data voltage is applied, and a second electrode connected to a third node;
a third transistor including a gate electrode to which a compensation gate signal is applied, a first electrode connected to the second node, and a second electrode connected to the first node;
a fourth transistor including a gate electrode to which an initialization gate signal is applied, a first electrode to which an initialization voltage is applied, and a second electrode connected to the second node;
a first capacitor including a first electrode connected to the first node and a second electrode connected to the third node; and
a second capacitor including a first electrode connected to the third node and a second electrode to which the initialization voltage is applied.

5. The display device of claim 4, wherein each of the first transistor and the third transistor is a P-type transistor, and
wherein each of the second transistor and the fourth transistor is an N-type transistor.

6. The display device of claim 4 or 5, wherein the semiconductor layers include a first semiconductor layer including a silicon semiconductor, and a second semiconductor layer disposed on the first semiconductor layer and including an oxide semiconductor,
wherein a channel region of the first transistor and a channel region of the third transistor are defined in the first semiconductor layer, and
wherein a channel region of the second transistor and a channel region of the fourth transistor are defined in the second semiconductor layer.

7. The display device of claim 6, wherein the first capacitor at least partially overlaps each of the channel region of the second transistor and the channel region of the third transistor in a plan view, and/or wherein the second capacitor at least partially overlaps the first capacitor in a plan view, and/or wherein the second capacitor at least partially overlaps each of the channel region of the second transistor and the channel region of the third transistor in a plan view.

8. The display device of claim 1, wherein each of the pixel circuits includes:
a first transistor including a gate electrode connected to a first node, a first electrode connected to a second node, and a second electrode connected to a third node, the first transistor being configured to apply a driving current to a corresponding one of the light emitting elements;
a second transistor including a gate electrode to which a write gate signal is applied, a first electrode to which a data voltage is applied, and a second electrode connected to the first node;
a third transistor including a gate electrode to which a compensation gate signal is applied, a first electrode to which a driving power voltage is applied, and a second electrode connected to the second node;
a fourth transistor including a gate electrode to which an emission signal is applied, a first electrode connected to the third node, and a second electrode connected to an anode electrode of the corresponding one of the light emitting elements;
a first capacitor including a first electrode connected to the first node and a second electrode connected to the third node; and
a second capacitor including a first electrode connected to the third node and a second electrode to which a reference voltage is applied.

9. The display device of claim 8, wherein each of the first transistor, the third transistor, and the fourth transistor is an N-type transistor, and
wherein the second transistor is a P-type transistor.

10. The display device of claim 8 or 9, wherein the semiconductor layers include a first semiconductor layer including a silicon semiconductor, a second semiconductor layer disposed on the first semiconductor layer and including an oxide semiconductor, and a third semiconductor layer disposed on the second semiconductor layer and including an oxide semiconductor,
wherein a channel region of the first transistor is defined in the second semiconductor layer,
wherein a channel region of the second transistor is defined in the first semiconductor layer, and
wherein a channel region of the third transistor and a channel region of the fourth transistor are defined in the third semiconductor layer.

11. The display device of claim 10, wherein the first capacitor includes a first sub-capacitor, a second sub-capacitor, and a third sub-capacitor which are stacked in the thickness direction.

12. The display device of claim 11, wherein the first sub-capacitor, the second sub-capacitor, and the third sub-capacitor at least partially overlap each other in a plan view, and/ or wherein the second capacitor at least partially overlaps each of the first sub-capacitor, the second sub-capacitor, and the third sub-capacitor in a plan view.

13. The display device of claim 1, wherein each of the pixel circuits includes:
a first transistor including a gate electrode connected to a first node, a first electrode to which a driving power voltage is applied, and a second electrode connected to a second node, the first transistor being configured to apply a driving current to a corresponding one of the light emitting elements;
a second transistor including a gate electrode to which a compensation gate signal is applied, a first electrode connected to a third node, and a second electrode connected to the second node;
a third transistor including a gate electrode to which a write gate signal is applied, a first electrode connected to the first node, and a second electrode connected to the third node;
a first capacitor including a first electrode to which an initialization voltage is applied and a second electrode connected to the first node; and
a second capacitor including a first electrode to which a data voltage is applied and a second electrode connected to the third node.

14. The display device of claim 13, wherein the first transistor is a P-type transistor, and wherein each of the second transistor and the third transistor is an N-type transistor.

15. An electronic device comprising:
a display device for displaying an image and including:
a substrate including a plurality of pixel circuit regions;
a circuit element layer disposed on the substrate, the circuit element layer including a plurality of semiconductor layers, a plurality of conductive layers, and a plurality of insulating layers which are stacked in a thickness direction, the circuit element layer including a plurality of pixel circuits disposed in the plurality of pixel circuit regions, respectively; and
a light emitting element layer disposed on the circuit element layer, the light emitting element layer including a plurality of light emitting elements connected to the plurality of pixel circuits, respectively; and
one or more processors configured to provide input image data and an input control signal to the display device,
wherein each of the pixel circuits includes a plurality of transistors and at least one capacitor,
wherein the insulating layers included in the circuit element layer include a plurality of inorganic insulating layers and at least one organic insulating layer disposed on the inorganic insulating layers,
wherein a plurality of contact holes, which penetrate at least one of the inorganic insulating layers, are defined, and
wherein the ratio, expressed as a percentage, of the sum of areas of the contact holes in one pixel circuit region of the pixel circuit regions to the area of the one pixel circuit region is in the range of 8 or more and 98 or less.
